# EUROPEAN PATENT SPECIFICATION

(11) **EP 3 660 024 B1**
(45) Date of publication and mention of the grant of the patent: **05.05.2021**
(21) Application number: 19212313.1
(22) Date of filing: 28.11.2019
(51) Int. Cl.: C07F 5/02

(54) **POLYCYCLIC AROMATIC COMPOUNDS AND ORGANIC ELECTROLUMINESCENT DEVICES USING THE SAME**
POLYCYCLISCHE AROMATISCHE VERBINDUNGEN UND ORGANISCHE ELEKTROLUMINESZENZ-VORRICHTUNGEN, DIE DIESE VERWENDEN
COMPOSÉS AROMATIQUES POLYCYCLIQUES ET DISPOSITIFS ÉLECTROLUMINESCENTS ORGANIQUES UTILISANT CEUX-CI

(30) Priority: 30.11.2018 KR 20180151781; 12.06.2019 KR 20190069314
(43) Date of publication of application: 03.06.2020
(73) Proprietor: SFC Co., Ltd., Cheongju-si, Chungcheongbuk-do 28122 (KR)
(72) Inventor: JOO, SungHoon, 28122 Chungcheongbuk-do (KR); KIM, Ji-Hwan, 28122 Chungcheongbuk-do (KR); YANG, Byung-sun, 28122 Chungcheongbuk-do (KR); JO, Hyeon Jun, 28122 Chungcheongbuk-do (KR); CHOI, Sungeun, 28122 Chungcheongbuk-do (KR); KIM, Su-jin, 28122 Chungcheongbuk-do (KR); SHIN, Bong-Ki, 28122 Chungcheongbuk-do (KR)
(74) Representative: Grosse, Felix Christopher

(56) References cited:
- EP-A2- 3 246 963
- US-A1- 2018 301 629
- US-A1- 2019 207 112

## Description

The present invention relates to polycyclic aromatic compounds and highly efficient and long-lasting organic electroluminescent devices with greatly improved luminous efficiency using the same.

Organic electroluminescent devices are self-luminous devices in which electrons injected from an electron injecting electrode (cathode) recombine with holes injected from a hole injecting electrode (anode) in a light emitting layer to form excitons, which emit light while releasing energy. Such organic electroluminescent devices have the advantages of low driving voltage, high luminance, large viewing angle, and short response time and can be applied to full-color light emitting flat panel displays. Due to these advantages, organic electroluminescent devices have received attention as next-generation light sources.

The above characteristics of organic electroluminescent devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized structures of organic layers for organic electroluminescent devices and stable and efficient materials for organic layers of organic electroluminescent devices.

Thus, there is a continued need to develop structures of organic electroluminescent devices optimized to improve their luminescent properties and new materials capable of supporting the optimized structures of organic electroluminescent devices.

Therefore, the present invention intends to provide organic electroluminescent compounds that are employed in organic layers of organic electroluminescent devices, achieving high efficiency and long lifetime of the devices. The present invention also intends to provide organic electroluminescent devices including the organic electroluminescent compounds.

One aspect of the present invention provides an organic electroluminescent compound as defined in the appended claims 1 and 2.

A further aspect of the present invention provides an organic electroluminescent device as defined in the appended claims 3 to 16.

The polycyclic aromatic compound of the present invention is employed in at least one of the organic layers of the organic electroluminescent device, achieving high efficiency and long lifetime of the device.

The present disclosure will now be described in more detail.

The present disclosure describes a polycyclic aromatic compound represented by Formula A-1 or A-2: 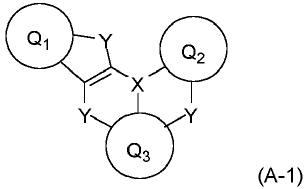 wherein Q₁ to Q₃ are identical to or different from each other and are each independently a substituted or unsubstituted C₆-C₅₀ aromatic hydrocarbon ring or a substituted or unsubstituted C₂-C₅₀ heteroaromatic ring, the linkers Y are identical to or different from each other and are each independently selected from N-R₁, CR₂R₃, O, S, Se, and SiR₄R₅, X is B, and R₁ to R₅ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that each of R₁ to R₅ is optionally bonded to Q₁, Q₂ or Q₃ to form an alicyclic or aromatic monocyclic or polycyclic ring, R₂ and R₃ are optionally linked to each other to form an alicyclic or aromatic monocyclic or polycyclic ring, and R₃ and R₄ are optionally linked to each other to form an alicyclic or aromatic monocyclic or polycyclic ring, 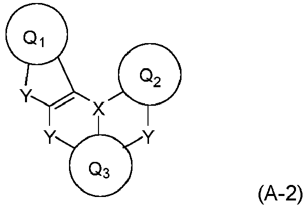 wherein Q₁, Q₂, Q₃, X, and Y are as defined in Formula A-1.

The presence of boron (B) in the structure of the polycyclic aromatic compound ensures high efficiency and long lifetime of an organic electroluminescent device.

The polycyclic aromatic compound of Formula A-1 or A-2 can be employed in an organic electroluminescent device, achieving high efficiency and long lifetime of the device.

According to the present invention, the polycyclic aromatic compound of Formula A-1 or A-2 has a polycyclic aromatic skeletal structure represented by Formula A-3, A-4, A-5 or A-6: 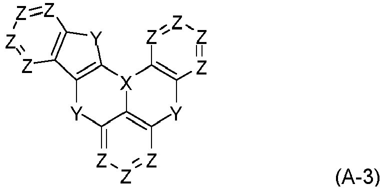 wherein each Z is independently CR or N, the substituents R are identical to or different from each other and are independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the substituents R are optionally bonded to each other or are optionally linked to other adjacent substituents to form alicyclic or aromatic monocyclic or polycyclic rings whose carbon atoms are optionally substituted with one or more heteroatoms selected from N, S, and O atoms, and X and Y are as defined in Formulae A-1 and A-2, 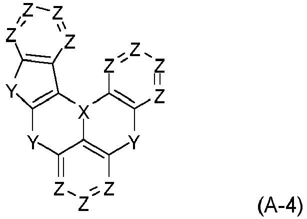 wherein X, Y, and Z are as defined in Formula A-3, 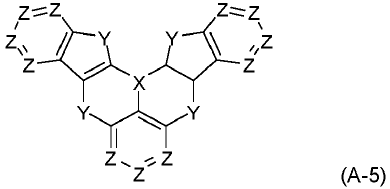 wherein X, Y, and Z are as defined in Formula A-3, 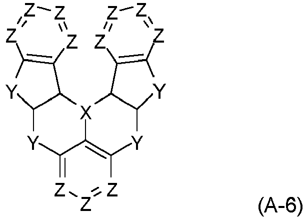 wherein X, Y, and Z are as defined in Formula A-3.

The use of the skeletal structure meets desired requirements of various organic layers of an organic electroluminescent device, achieving high efficiency and long lifetime of the device.

As used herein, the term "substituted" in the definition of Q₁ to Q₃, R, and R₁ to R₅ indicates substitution with one or more substituents selected from the group consisting of deuterium, cyano, halogen, hydroxyl, nitro, C₁-C₂₄ alkyl, C₃-C₂₄ cycloalkyl, C₁-C₂₄ haloalkyl, C₁-C₂₄ alkenyl, C₁-C₂₄ alkynyl, C₁-C₂₄ heteroalkyl, C₁-C₂₄ heterocycloalkyl, C₆-C₂₄ aryl, C₆-C₂₄ arylalkyl, C₂-C₂₄ heteroaryl, C₂-C₂₄ heteroarylalkyl, C₁-C₂₄ alkoxy, C₁-C₂₄ alkylamino, C₁-C₂₄ arylamino, C₁-C₂₄ heteroarylamino, C₁-C₂₄ alkylsilyl, C₁-C₂₄ arylsilyl, and C₁-C₂₄ aryloxy, or a combination thereof. The term "unsubstituted" in the same definition indicates having no substituent.

In the "substituted or unsubstituted C₁-C₁₀ alkyl", "substituted or unsubstituted C₆-C₃₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

In the present invention, the alkyl groups may be straight or branched. The number of carbon atoms in the alkyl groups is not particularly limited but is preferably from 1 to 20. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkyl group is intended to include monocyclic and polycyclic ones and may be optionally substituted with one or more other substituents. As used herein, the term "polycyclic" means that the cycloalkyl group may be directly attached or fused to one or more other cyclic groups. The other cyclic groups may be cycloalkyl groups and other examples thereof include heterocycloalkyl, aryl, and heteroaryl groups. The cycloalkyl group may be specifically a cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl or cyclooctyl group but is not limited thereto.

The heterocycloalkyl group is intended to include monocyclic and polycyclic ones interrupted by a heteroatom such as O, S, Se, N or Si and may be optionally substituted with one or more other substituents. As used herein, the term "polycyclic" means that the heterocycloalkyl group may be directly attached or fused to one or more other cyclic groups. The other cyclic groups may be heterocycloalkyl groups and other examples thereof include cycloalkyl, aryl, and heteroaryl groups.

The aryl groups may be monocyclic or polycyclic ones. Examples of the monocyclic aryl groups include, but are not limited to, phenyl, biphenyl, terphenyl, and terphenyl groups. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The heteroaryl groups refer to heterocyclic groups interrupted by one or more heteroatoms. Examples of the heteroaryl groups include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The alkoxy group may be specifically a methoxy, ethoxy, propoxy, isobutyloxy, sec-butyloxy, pentyloxy, iso-amyloxy or hexyloxy group, but is not limited thereto.

The silyl group is intended to include alkyl-substituted silyl groups and aryl-substituted silyl groups. Specific examples of such silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine groups may be, for example, -NH₂, alkylamine groups, and arylamine groups. The arylamine groups are aryl-substituted amine groups and the alkylamine groups are alkyl-substituted amine groups. Examples of the arylamine groups include substituted or unsubstituted monoarylamine groups, substituted or unsubstituted diarylamine groups, and substituted or unsubstituted triarylamine groups. The aryl groups in the arylamine groups may be monocyclic or polycyclic ones. The arylamine groups may include two or more aryl groups. In this case, the aryl groups may be monocyclic aryl groups or polycyclic aryl groups. Alternatively, the aryl groups may consist of a monocyclic aryl group and a polycyclic aryl group. The aryl groups in the arylamine groups may be selected from those exemplified above.

The aryl groups in the aryloxy group and the arylthioxy group are the same as those described above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. The arylthioxy group may be, for example, a phenylthioxy, 2-methylphenylthioxy or 4-tert-butylphenylthioxy group but is not limited thereto.

The halogen group may be, for example, fluorine, chlorine, bromine or iodine.

More specifically, the polycyclic aromatic compound represented by Formula A-1 or A-2 may be selected from the following compounds:

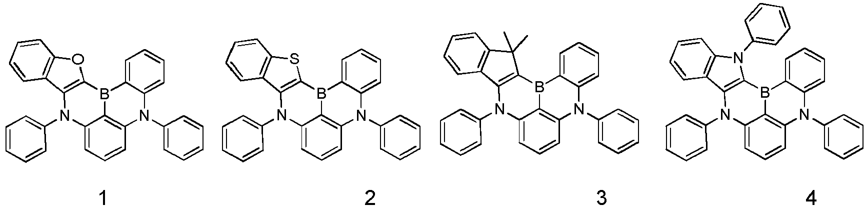

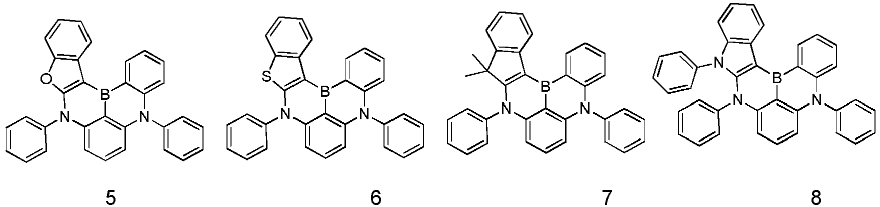

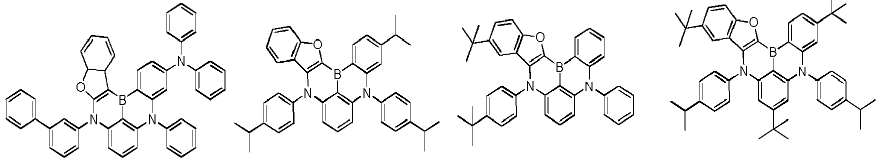

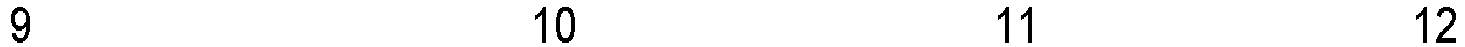

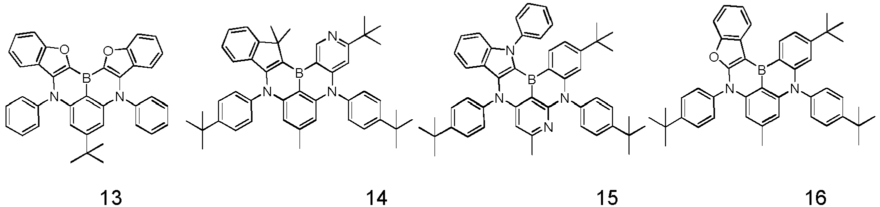

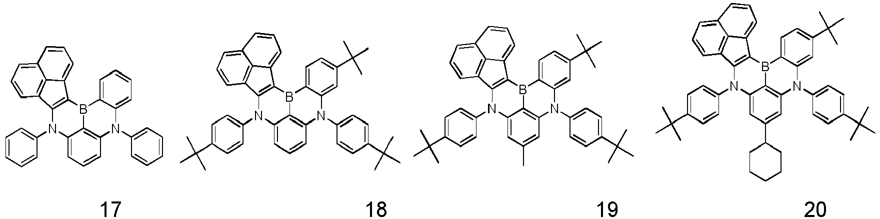

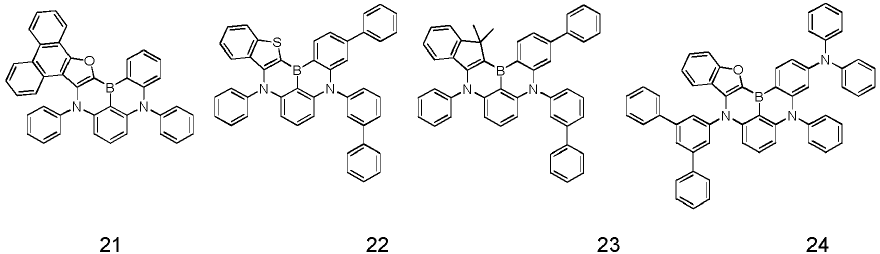

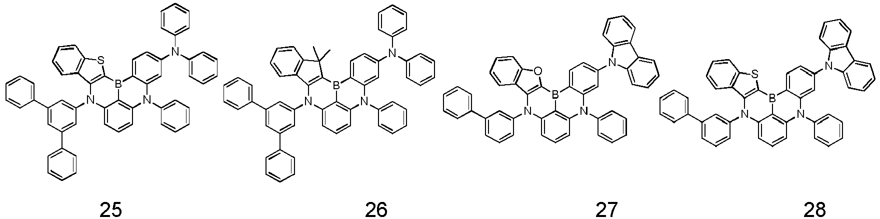

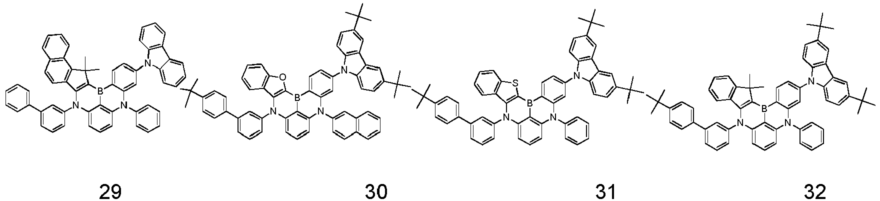

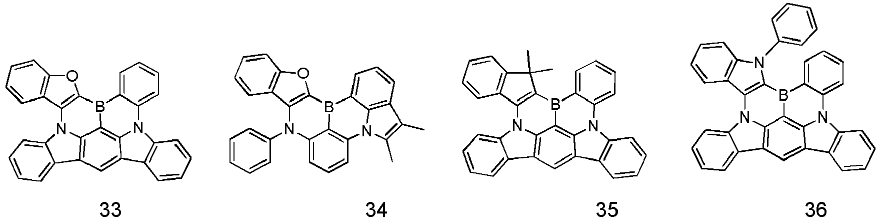

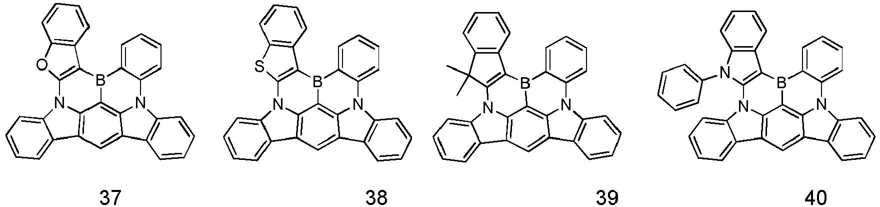

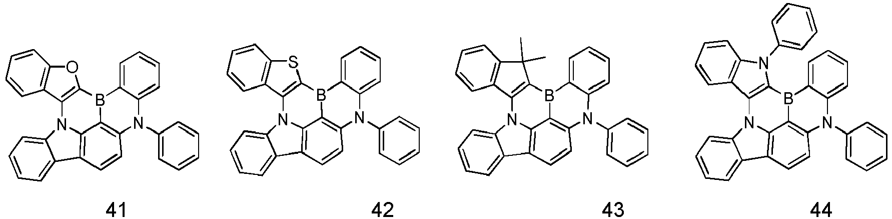

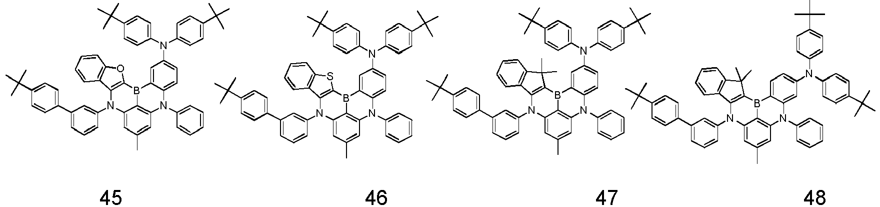

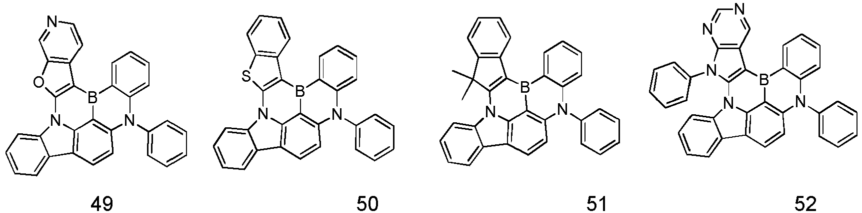

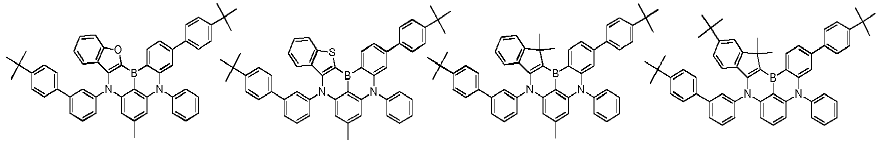

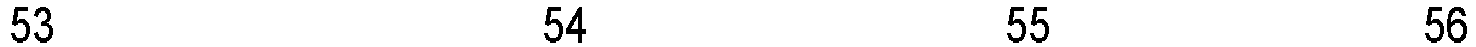

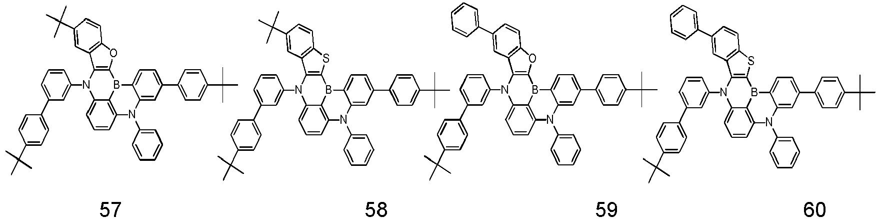

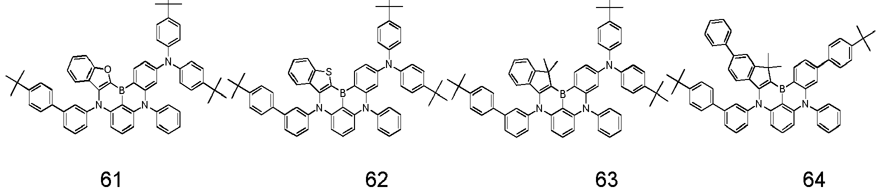

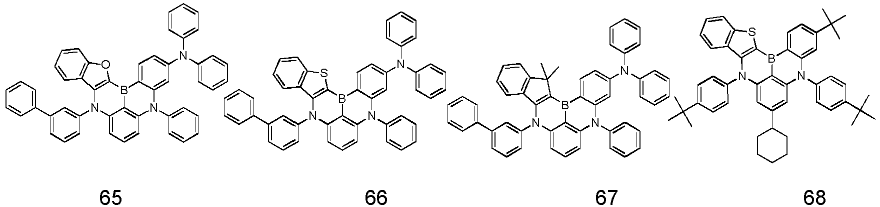

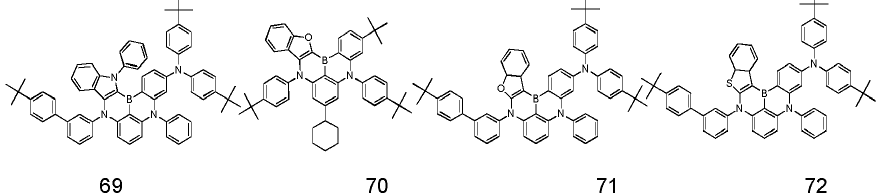

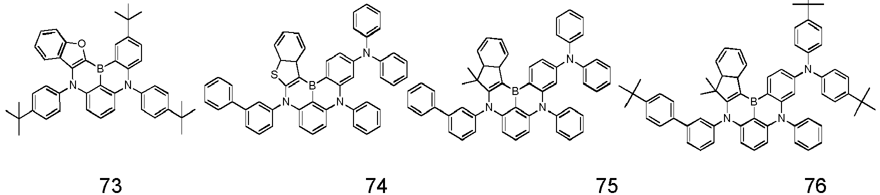

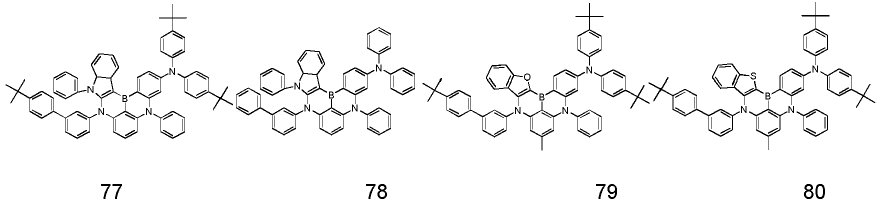

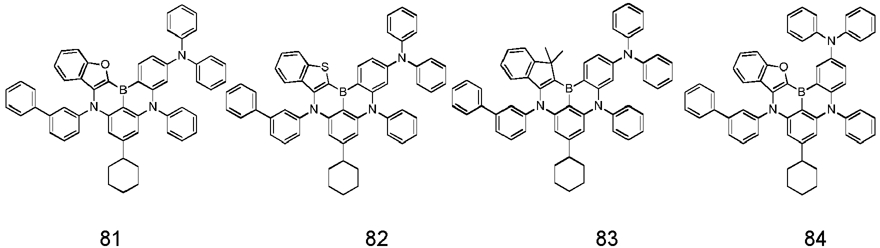

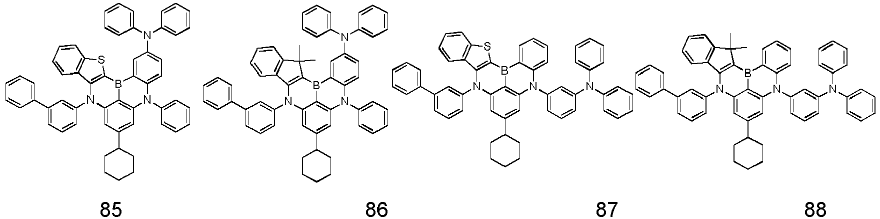

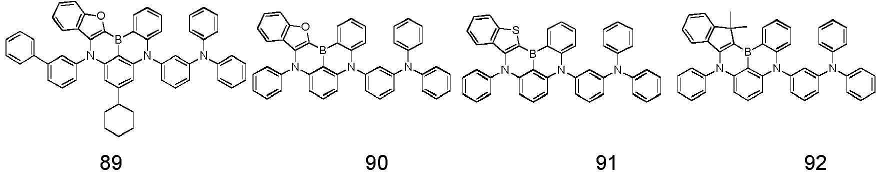

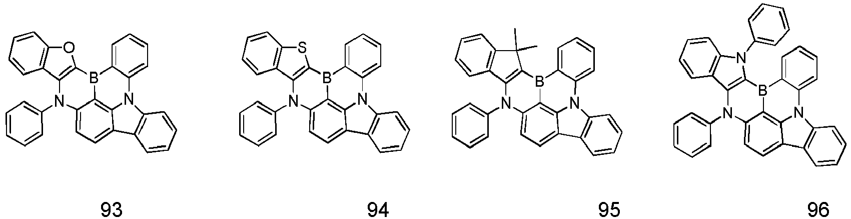

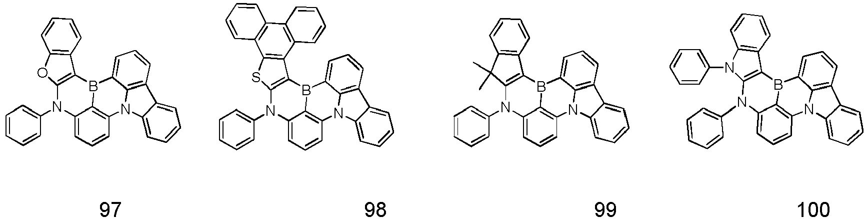

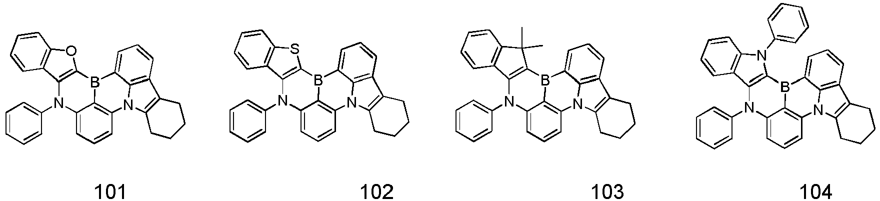

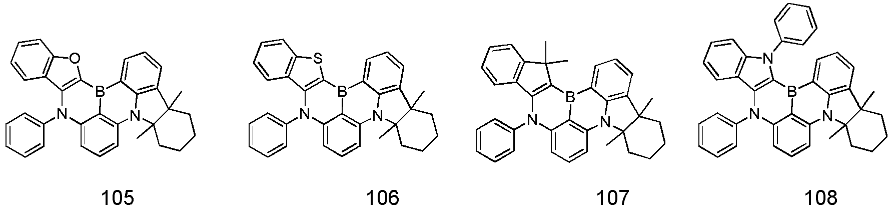

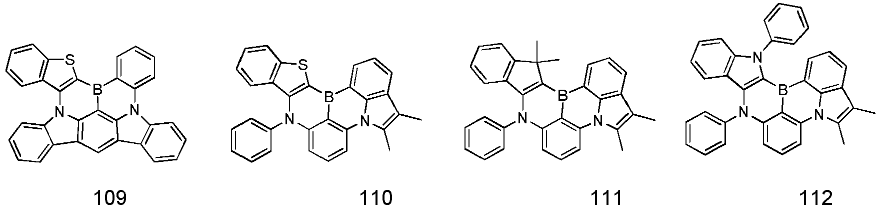

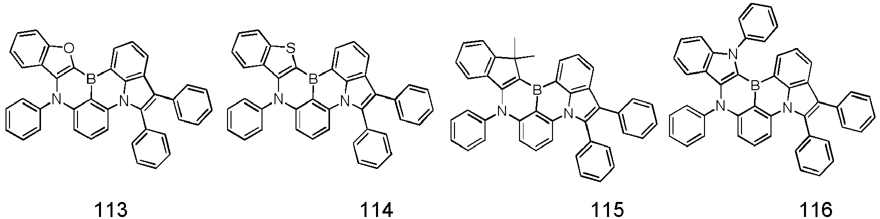

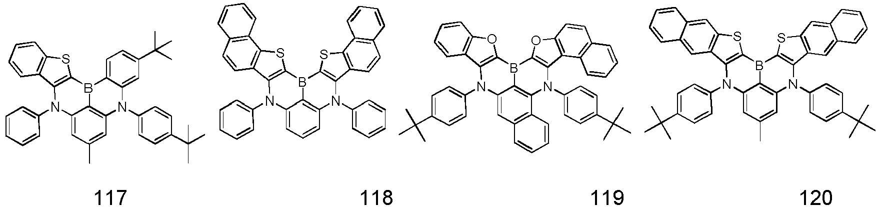

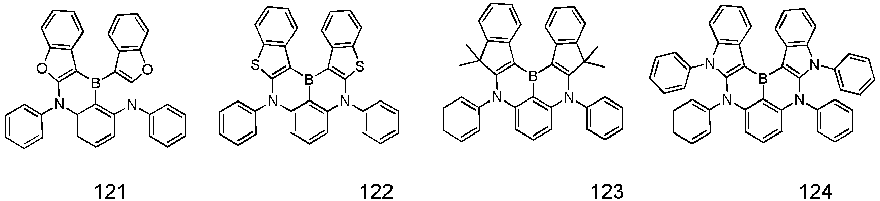

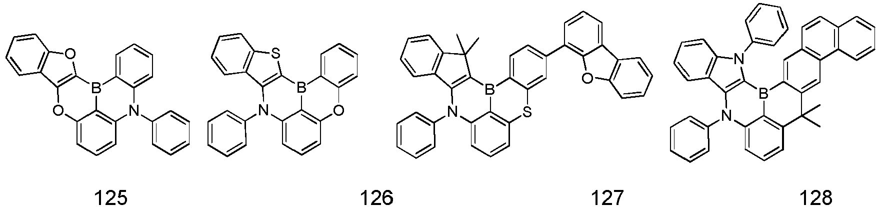

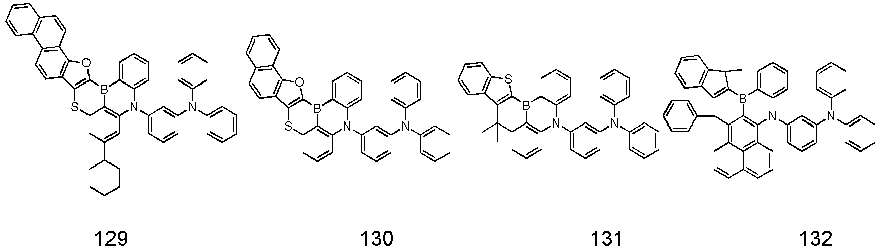

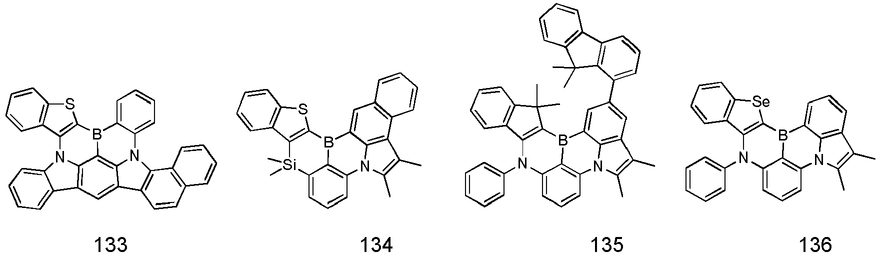

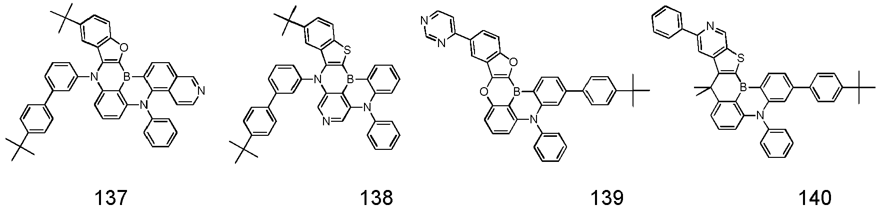

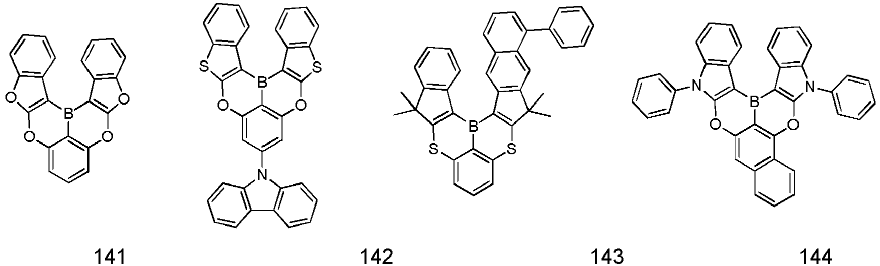

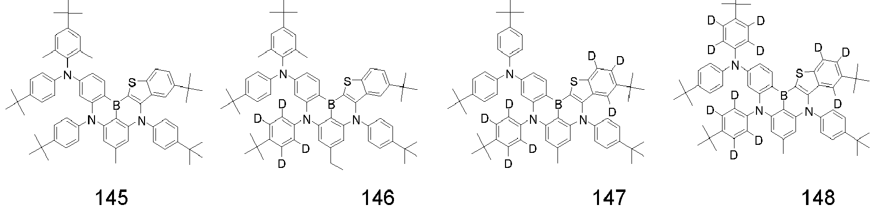

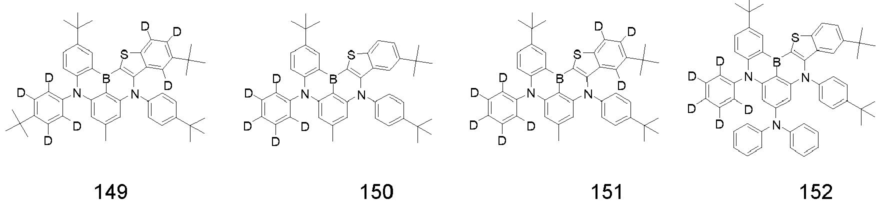

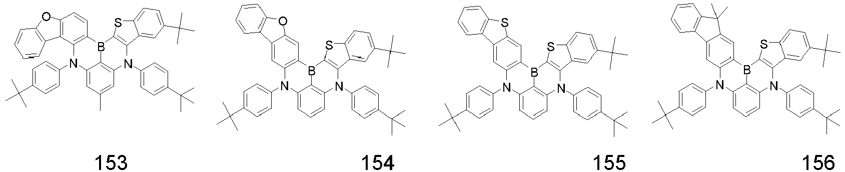

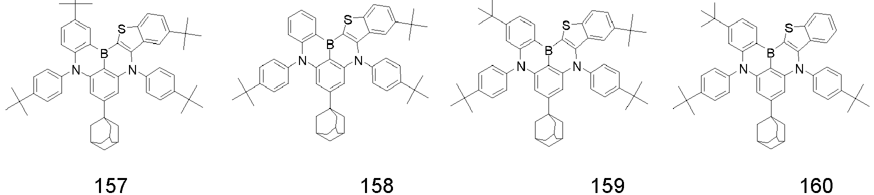

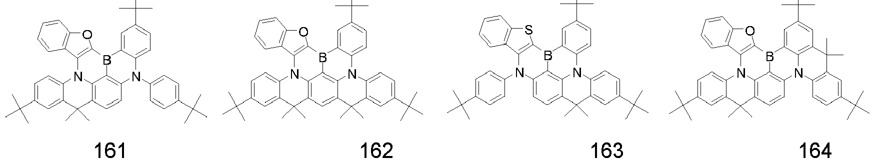

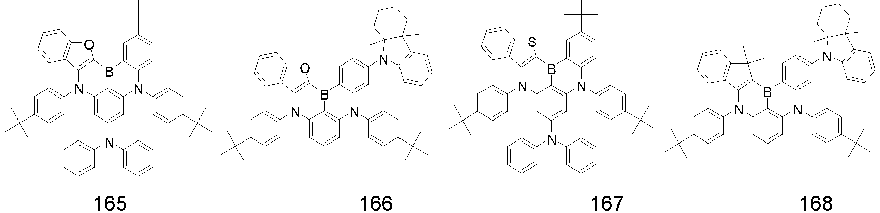

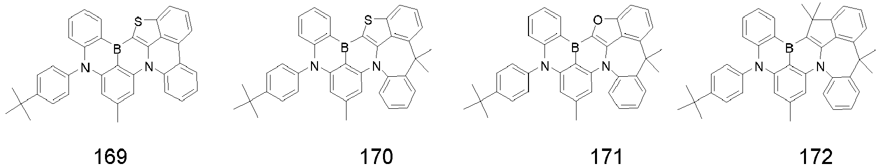

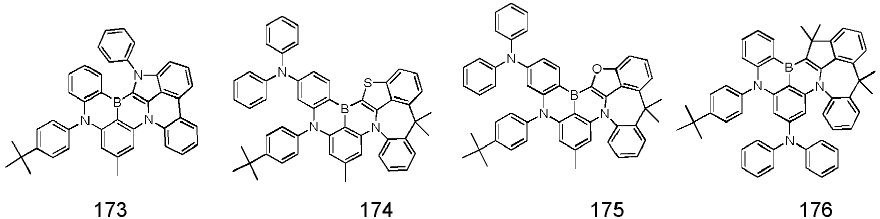

The specific examples of the substituents defined above can be found in the compounds of Formulae 1 to 176 but are not intended to limit the scope of the compound represented by Formula A-1 or A-2.

The introduction of substituents, including B, P or P=O, to form polycyclic aromatic structures allows the organic light emitting materials to have inherent characteristics of the substituents. For example, the introduced substituents may be those that are typically used in materials for hole injecting layers, hole transport layers, light emitting layers, electron transport layers, electron injecting layers, electron blocking layers, and hole blocking layers of organic electroluminescent devices. This introduction meets the requirements of the organic layers and enables the fabrication of highly efficient organic electroluminescent devices.

A further aspect of the present invention is directed to an organic electroluminescent device including a first electrode, a second electrode opposite to the first electrode, and one or more organic layers interposed between the first and second electrodes wherein at least one of the organic layers includes the organic electroluminescent compound represented by Formula A-3, A-4, A-5 or A-6 and optionally another organic electroluminescent compound represented by Formula A-3, A-4, A-5 or A-6.

That is, according to one embodiment of the present invention, the organic electroluminescent device has a structure in which one or more organic layers are arranged between a first electrode and a second electrode. The organic electroluminescent device of the present invention may be fabricated by a suitable method known in the art using suitable materials known in the art, except that the organic electroluminescent compound of Formula A-3, A-4, A-5 or A-6 is used to form the corresponding organic layer.

The organic layers of the organic electroluminescent device according to the present invention may form a monolayer structure. Alternatively, the organic layers may have a multilayer laminate structure. For example, the structure of the organic layers may include a hole injecting layer, a hole transport layer, a hole blocking layer, a light emitting layer, an electron blocking layer, an electron transport layer, and an electron injecting layer, but is not limited thereto. The number of the organic layers is not limited and may be increased or decreased. Preferred structures of the organic layers of the organic electroluminescent device according to the present invention will be explained in more detail in the Examples section that follows.

A more detailed description will be given concerning exemplary embodiments of the organic electroluminescent device according to the present invention.

The organic electroluminescent device of the present invention includes an anode, a hole transport layer, a light emitting layer, an electron transport layer, and a cathode. The organic electroluminescent device of the present invention may optionally further include a hole injecting layer between the anode and the hole transport layer and an electron injecting layer between the electron transport layer and the cathode. If necessary, the organic electroluminescent device of the present invention may further include one or two intermediate layers such as a hole blocking layer or an electron blocking layer. The organic electroluminescent device of the present invention may further include one or more organic layers such as a capping layer that have various functions depending on the desired characteristics of the device.

The light emitting layer of the organic electroluminescent device according to the present invention preferably includes, as a host compound, an anthracene derivative represented by Formula C: 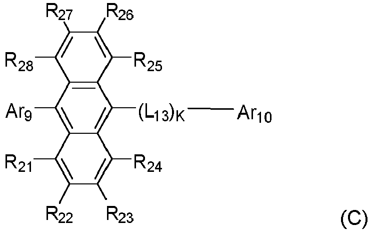 wherein R₂₁ to R₂₈ are identical to or different from each other and are as defined for R₁ to R₅ in Formula A-1 or A-2, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, preferably a single bond or substituted or unsubstituted C₆-C₂₀ arylene, and k is an integer from 1 to 3, provided that when k is 2 or more, the linkers L₁₃ are identical to or different from each other.

Ar₉ in Formula C is represented by Formula C-1: 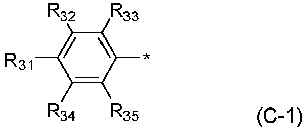 wherein R₃₁ to R₃₅ are identical to or different from each other and are as defined for R₁ to R₅ in Formula A-1 or A-2, and each of R₃₁ to R₃₅ is optionally bonded to an adjacent substituent to form a saturated or unsaturated ring.

The compound of Formula C employed in the organic electroluminescent device of the present invention may be specifically selected from the compounds of Formulae C1 to C48:

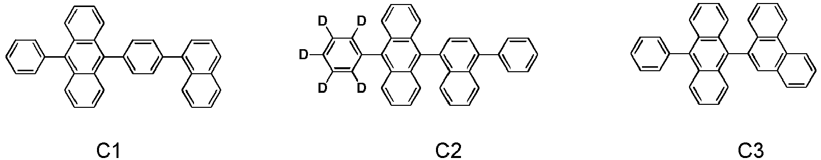

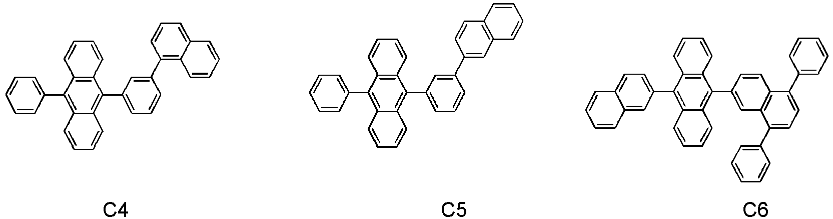

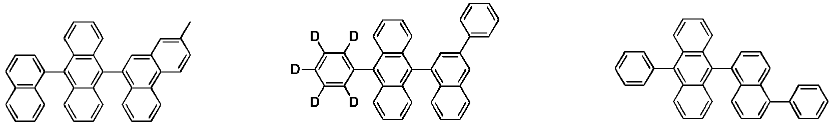

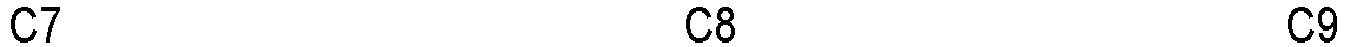

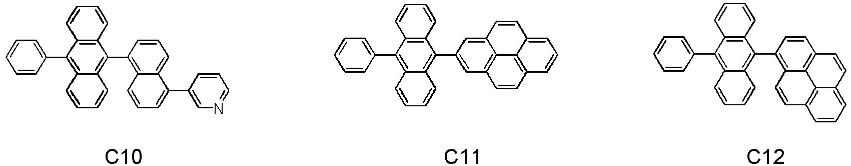

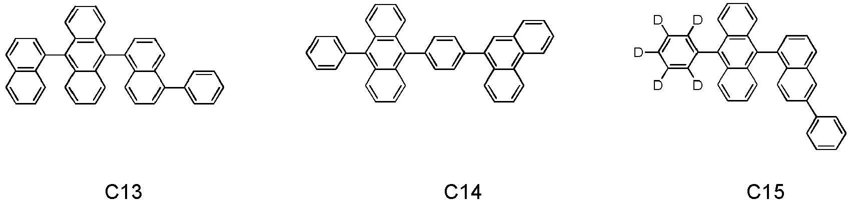

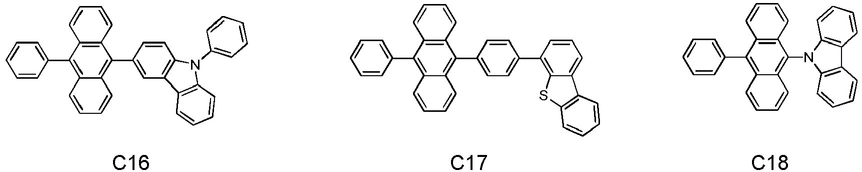

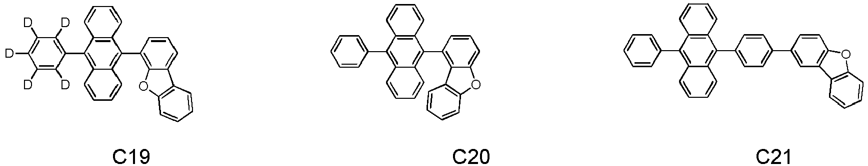

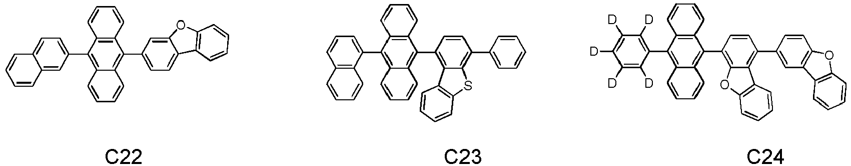

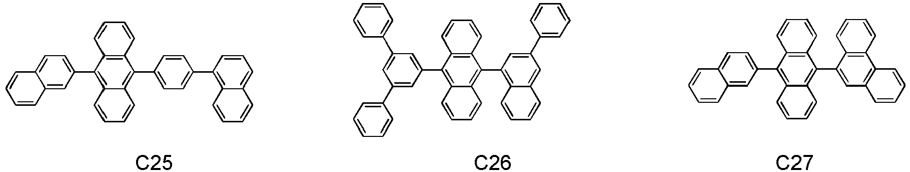

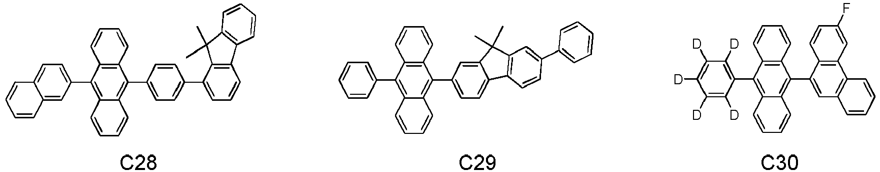

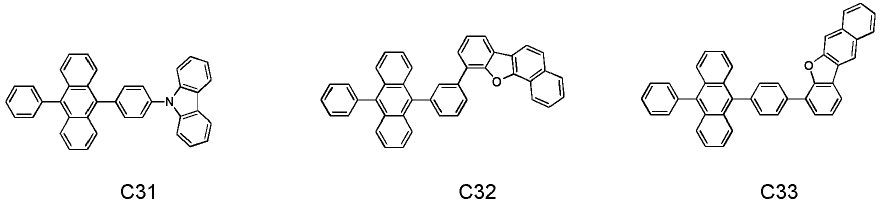

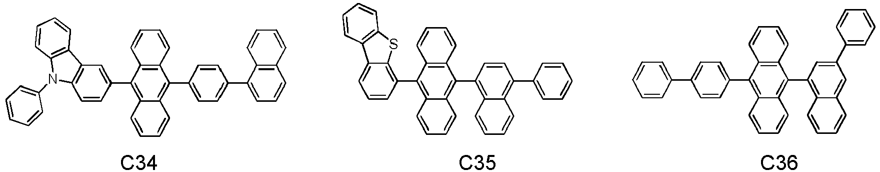

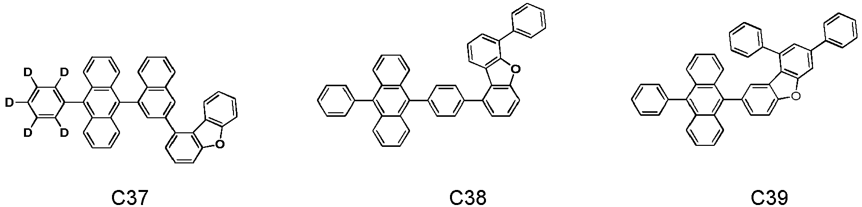

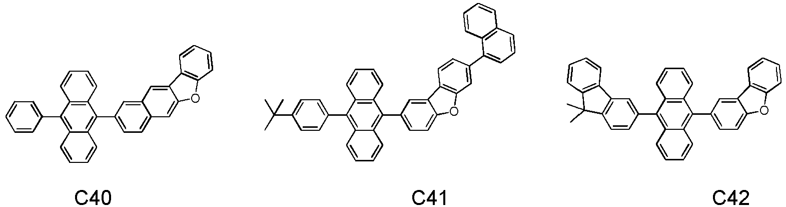

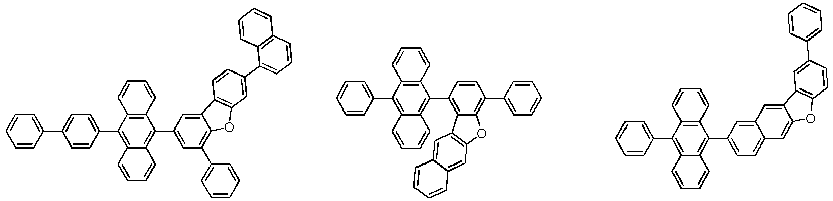

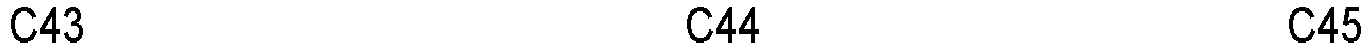

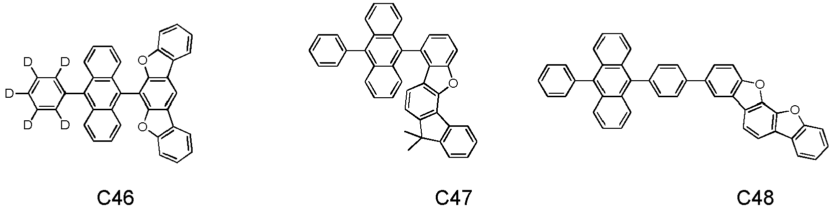

The organic electroluminescent device of the present invention may further include one or more organic layers, for example, a hole transport layer and an electron blocking layer, each of which may include a compound represented by Formula D: 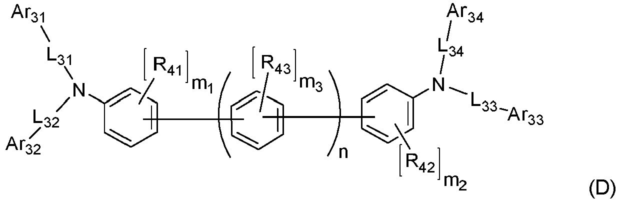 wherein R₄₁ to R₄₃ are identical to or different from each other and are each independently selected from hydrogen, deuterium, substituted or unsubstituted C₁-C₂₀ alkyl, substituted or unsubstituted C₆-C₅₀ aryl, substituted or unsubstituted C₇-C₅₀ arylalkyl, substituted or unsubstituted C₃-C₃₀ cycloalkyl, substituted or unsubstituted C₁-C₃₀ alkylsilyl, substituted or unsubstituted C₆-C₃₀ arylsilyl, and halogen, L₃₁ to L₃₄ are identical to or different from each other and are each independently single bonds or selected from substituted or unsubstituted C₆-C₅₀ arylene and substituted or unsubstituted C₂-C₅₀ heteroarylene, Ar₃₁ to Ar₃₄ are identical to or different from each other and are each independently selected from substituted or unsubstituted C₆-C₅₀ aryl and substituted or unsubstituted C₂-C₅₀ heteroaryl, n is an integer from 0 to 4, provided that when n is 2 or greater, the aromatic rings containing R₄₃ are identical to or different from each other, m₁ to m₃ are integers from 0 to 4, provided that when both m₁ and m₃ are 2 or more, the R₄₁, R₄₂, and R₄₃ groups are identical to or different from each other, and hydrogen or deuterium atoms are bonded to the carbon atoms of the aromatic rings to which R₄₁ to R₄₃ are not attached.

In Formula D, at least one of Ar₃₁ to Ar₃₄ is represented by Formula E: 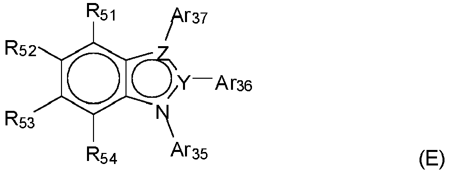 wherein R₅₁ to R₅₄ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, which are optionally linked to each other to form a ring, Y is a carbon or nitrogen atom, Z is a carbon, oxygen, sulfur or nitrogen atom, Ar₃₅ to Ar₃₇ are identical to or different from each other and are each independently selected from substituted or unsubstituted C₅-C₃₀ aryl and substituted or unsubstituted C₅-C₃₀ heteroaryl, provided that when Z is an oxygen or sulfur atom, Ar₃₇ is nothing, provided that when Y and Z are nitrogen atoms, only one of Ar₃₅, Ar₃₆, and Ar₃₇ is present, provided that when Y is a nitrogen atom and Z is a carbon atom, Ar₃₆ is nothing, with the proviso that one of R₅₁ to R₅₄ and Ar₃₅ to Ar₃₇ is a single bond linked to one of the linkers L₃₁ to L₃₄ in Formula D.

The compound of Formula D employed in the organic electroluminescent device of the present invention may be specifically selected from the compounds of Formulae D1 to D79:

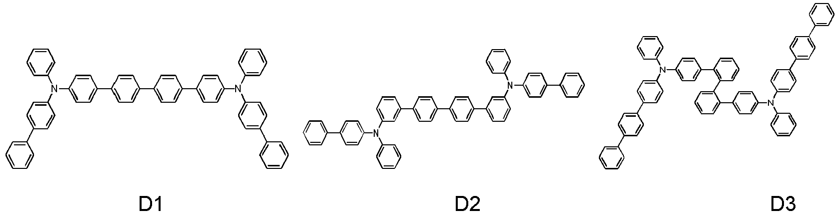

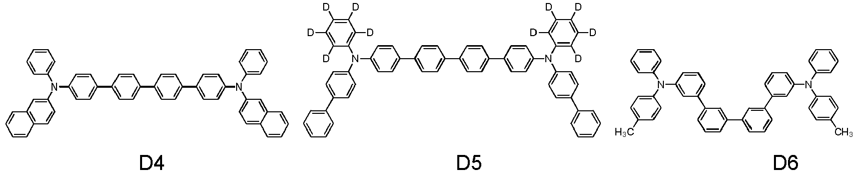

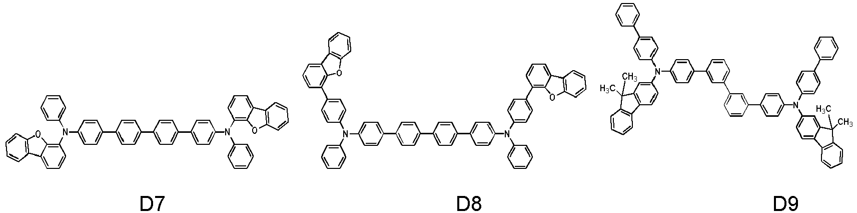

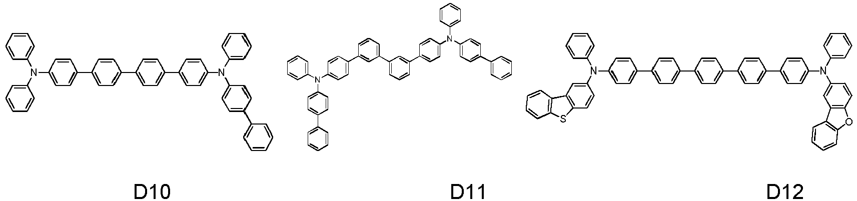

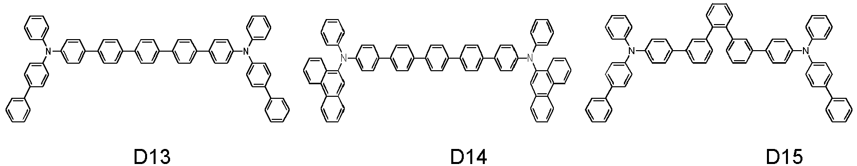

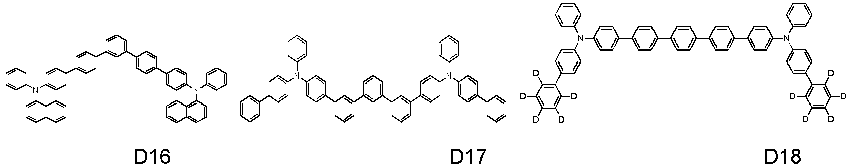

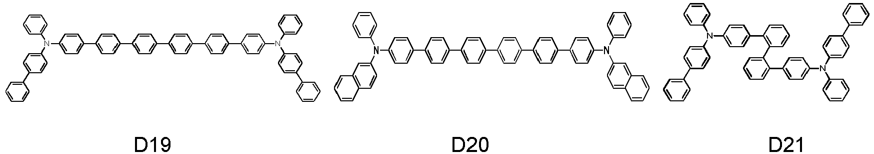

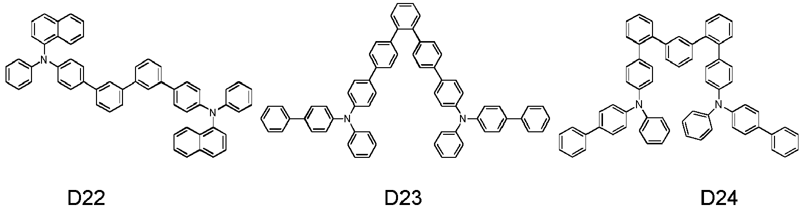

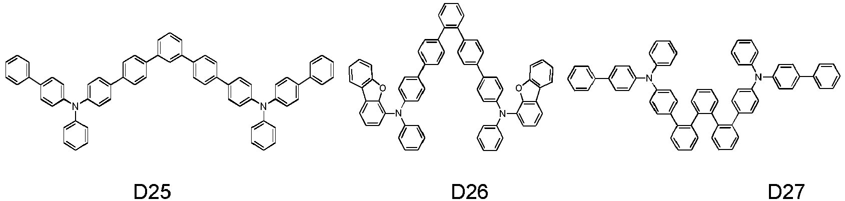

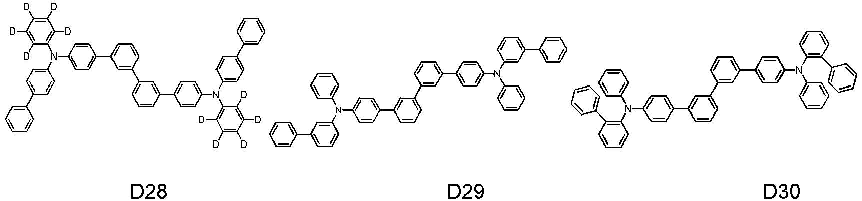

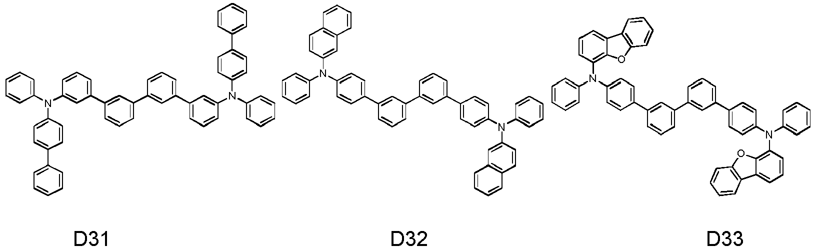

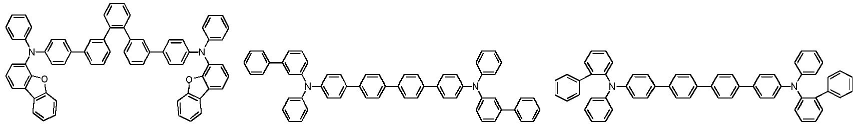

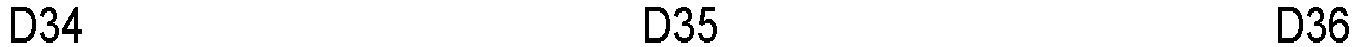

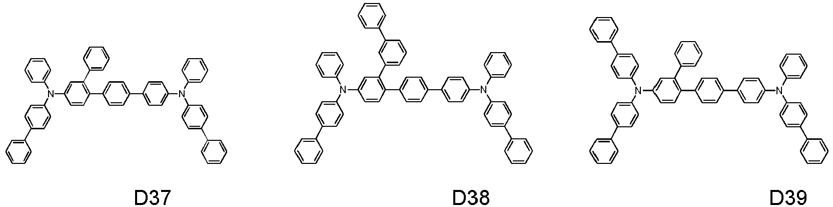

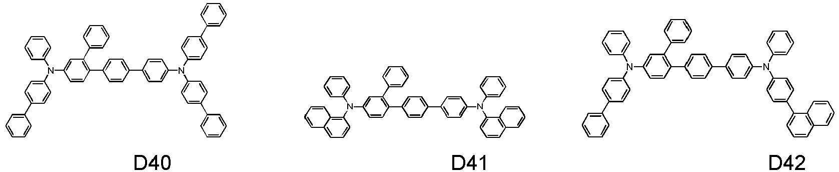

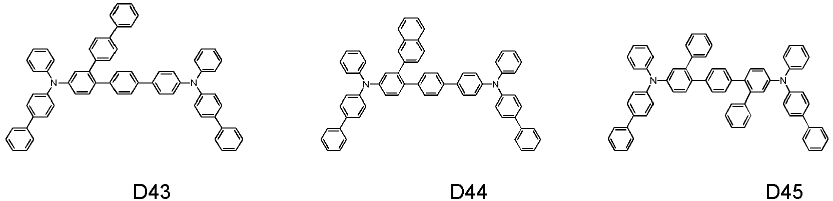

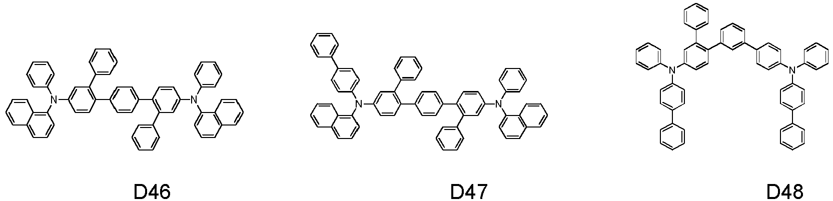

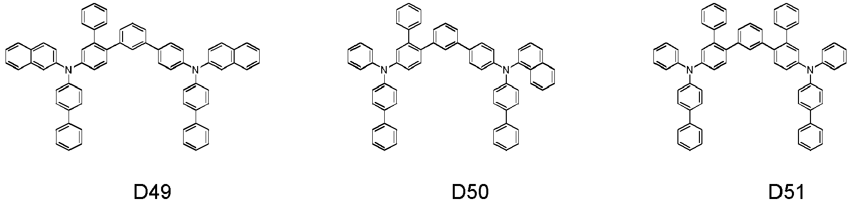

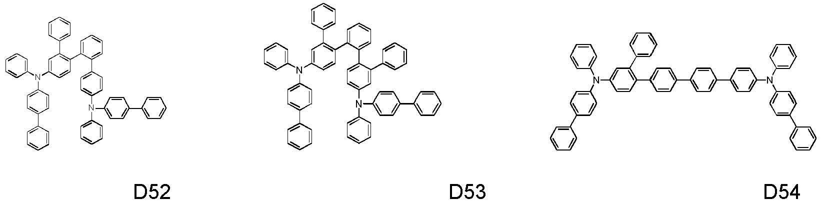

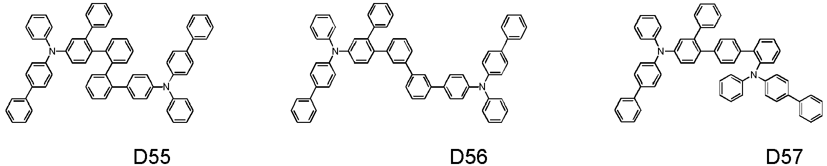

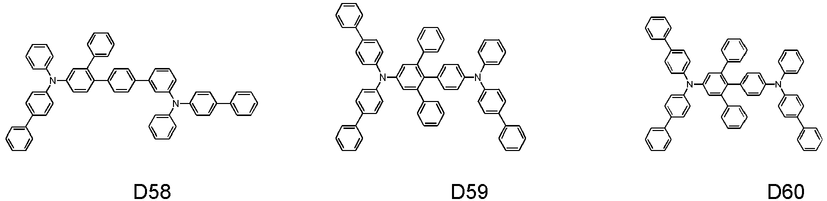

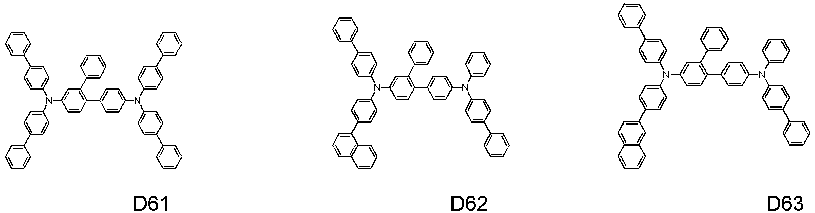

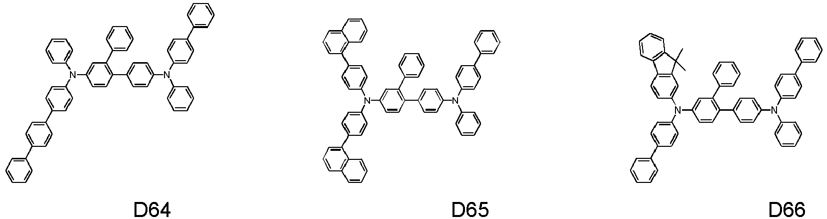

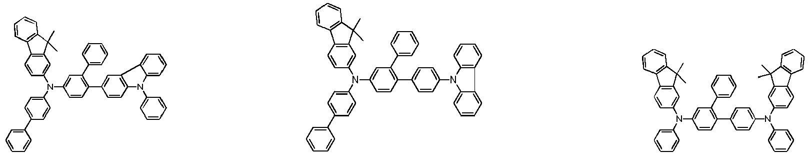

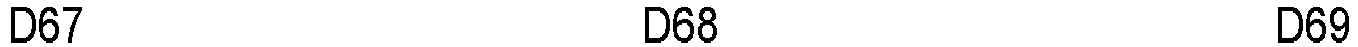

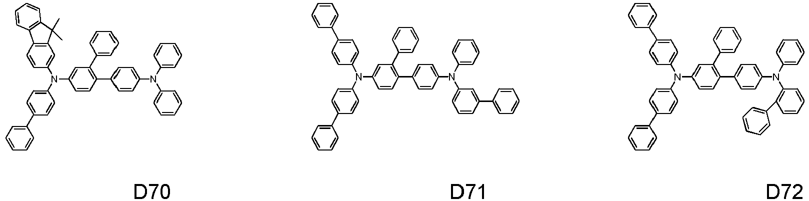

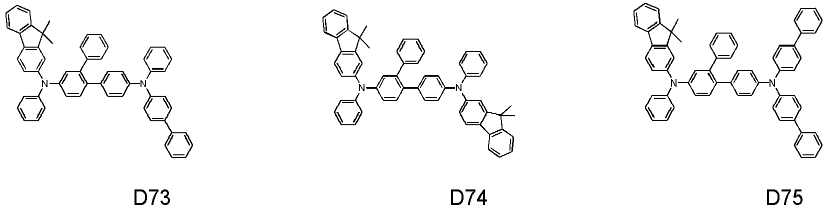

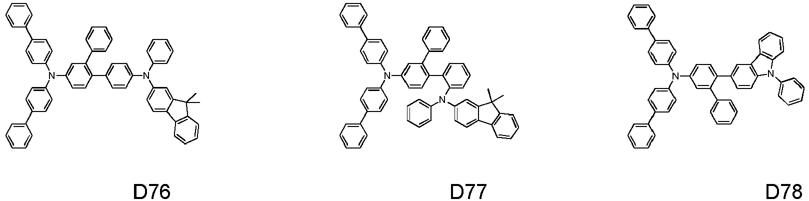

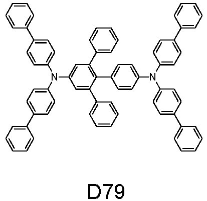

The compound of Formula D employed in the organic electroluminescent device of the present invention may be specifically selected from the compounds of Formulae D101 to D145:

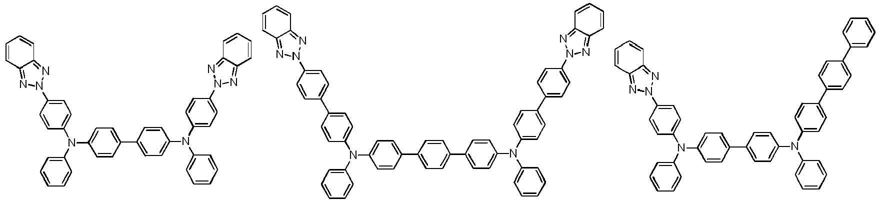

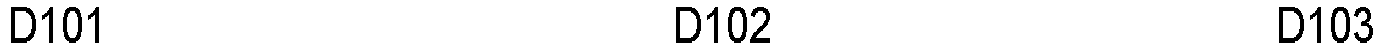

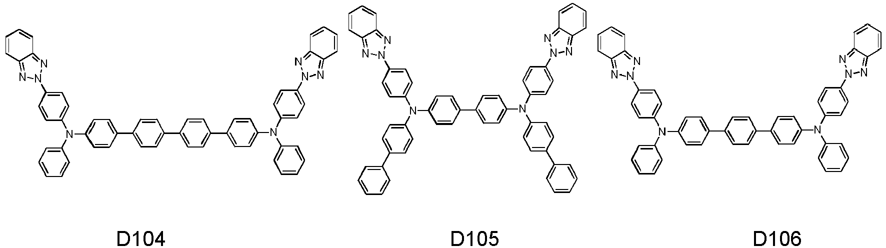

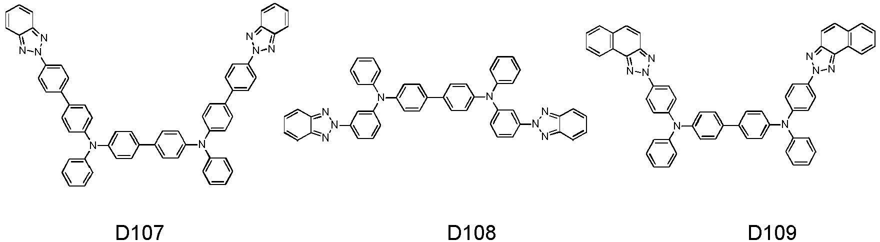

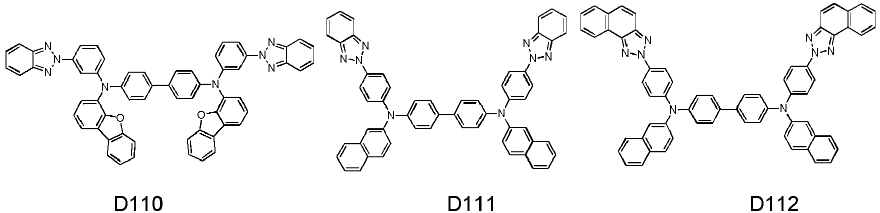

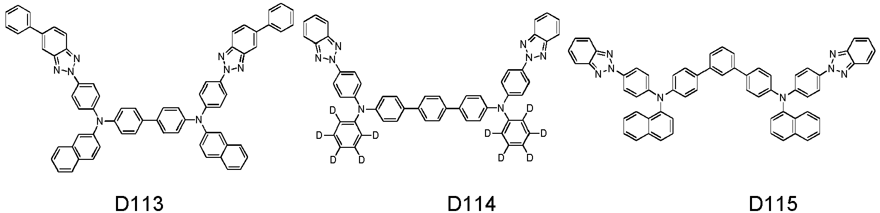

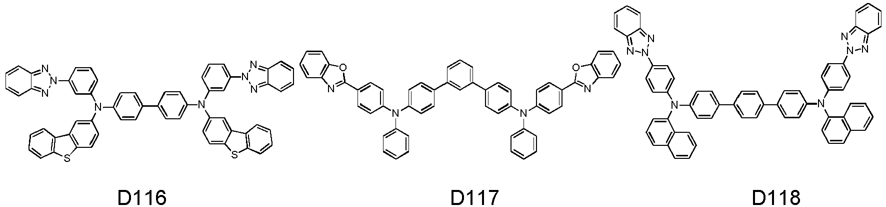

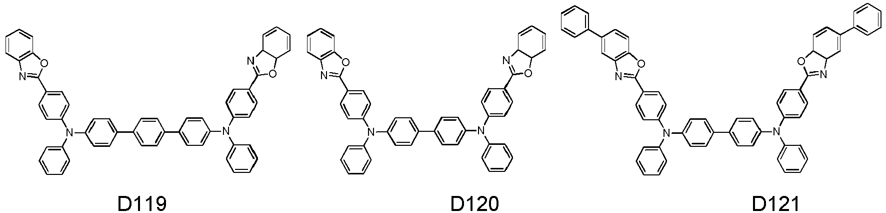

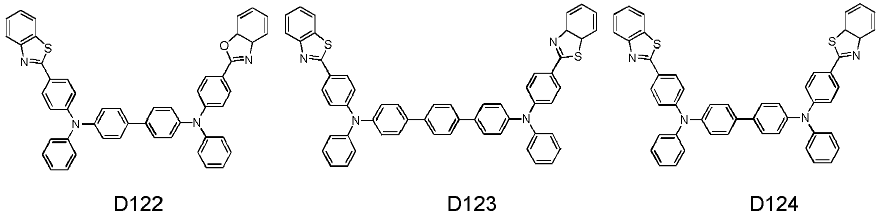

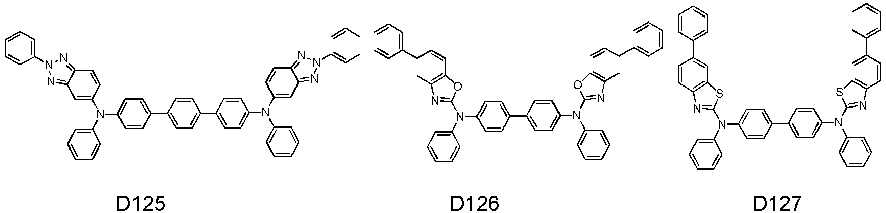

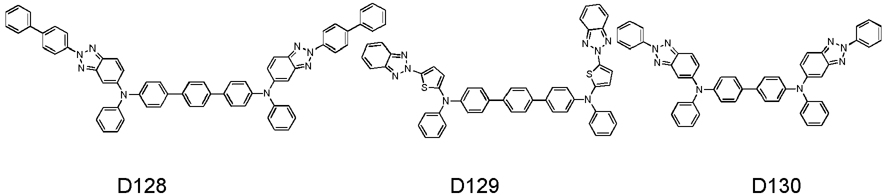

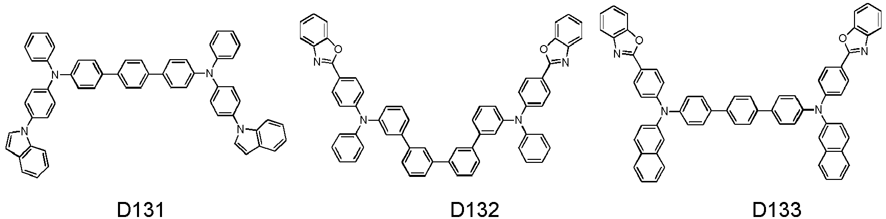

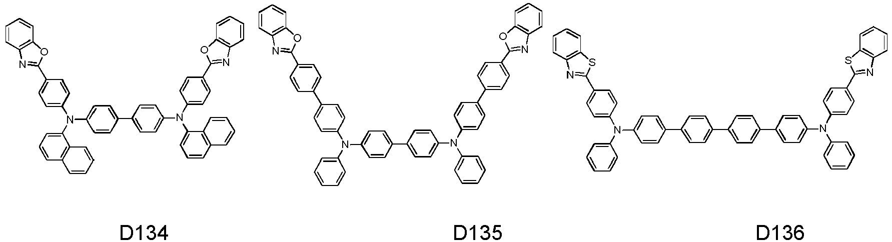

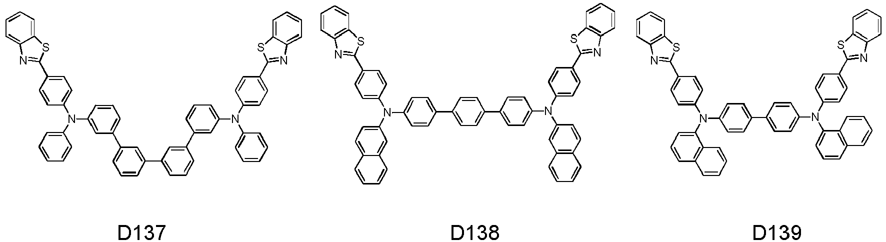

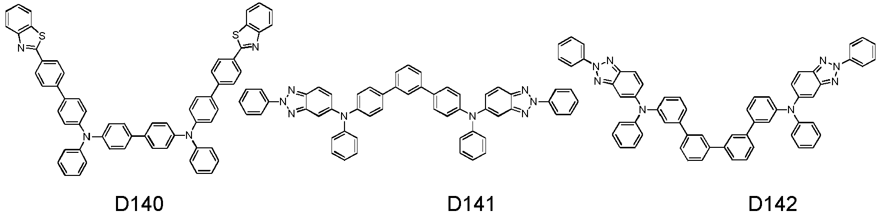

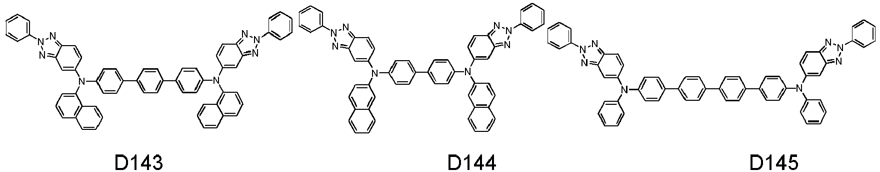

The organic electroluminescent device of the present invention may further include one or more organic layers, for example, a hole transport layer and an electron blocking layer, each of which may include a compound represented by Formula F: 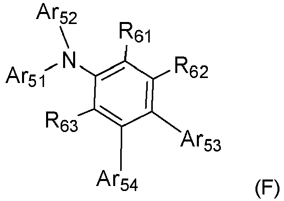 wherein R₆₁ to R₆₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, substituted or unsubstituted C₆-C₃₀ arylsilyl, substituted or unsubstituted C₁-C₃₀ alkylgermanium, substituted or unsubstituted C₁-C₃₀ arylgermanium, cyano, nitro, and halogen, and Ar₅₁ to Ar₅₄ are identical to or different from each other and are each independently substituted or unsubstituted C₆-C₄₀ aryl or substituted or unsubstituted C₂-C₃₀ heteroaryl.

The compound of Formula F employed in the organic electroluminescent device of the present invention may be specifically selected from the compounds of Formulae F1 to F33:

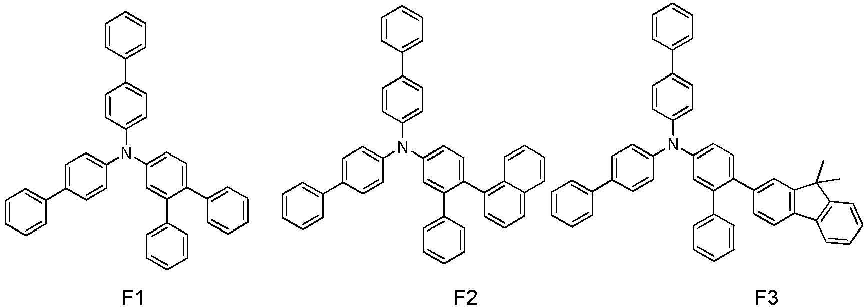

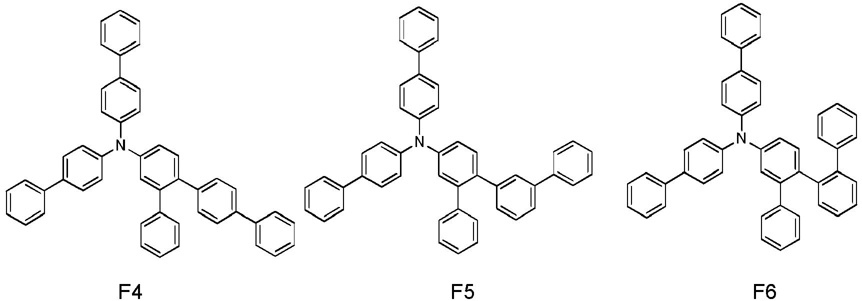

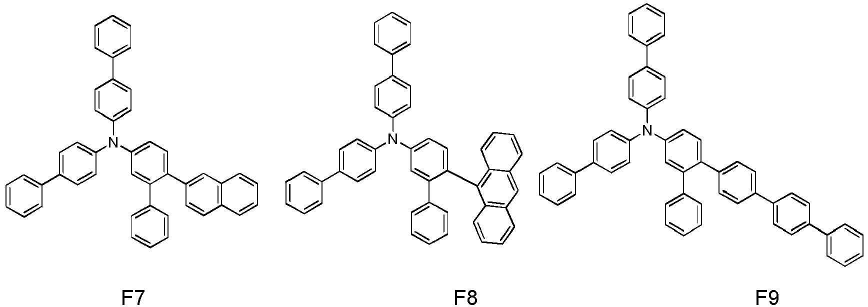

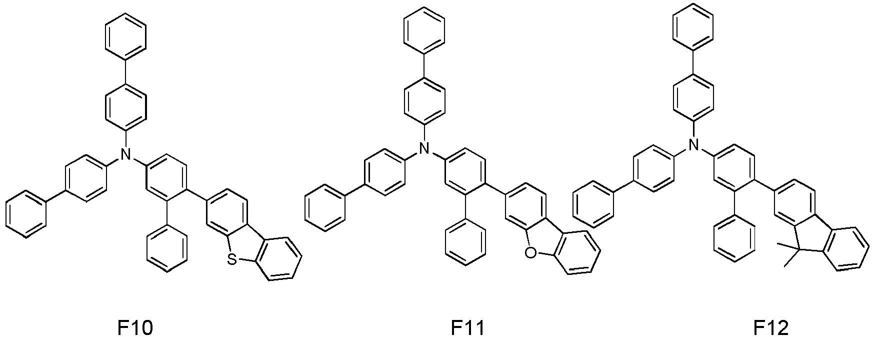

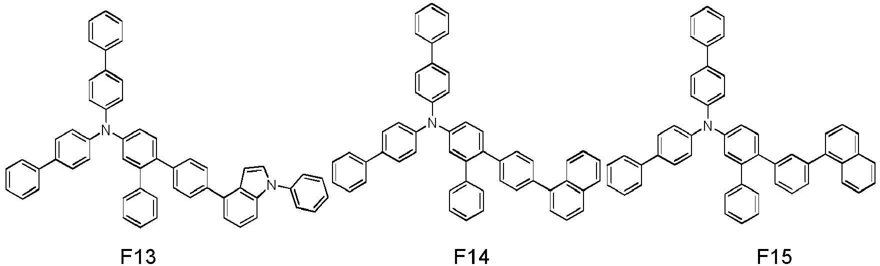

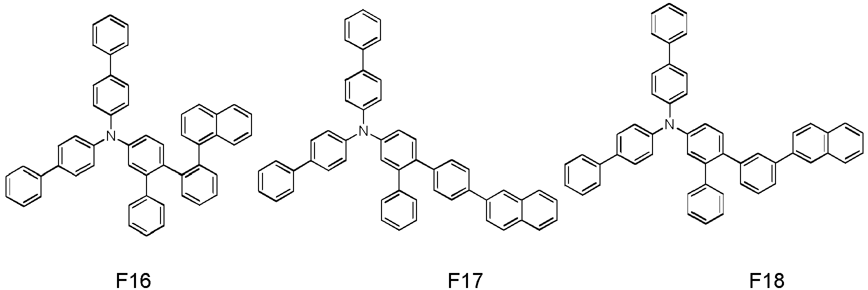

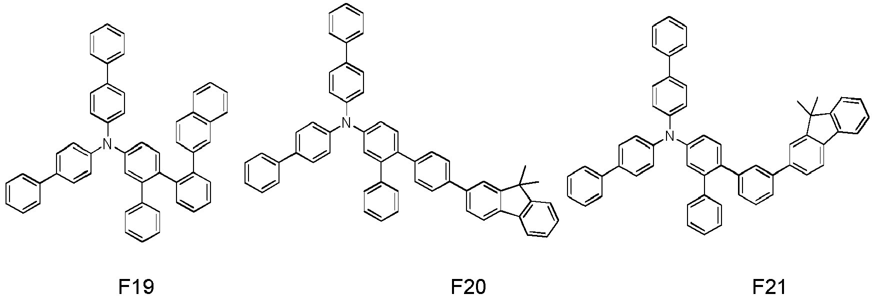

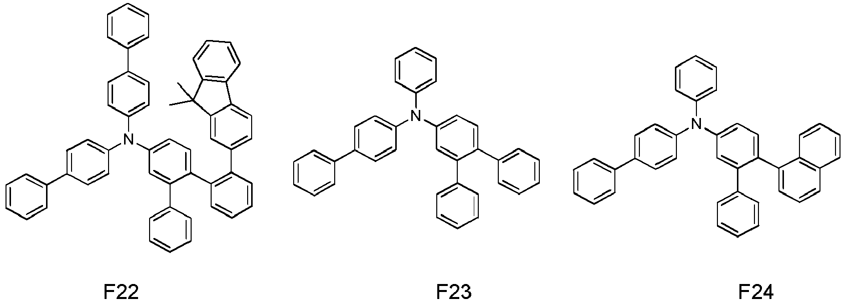

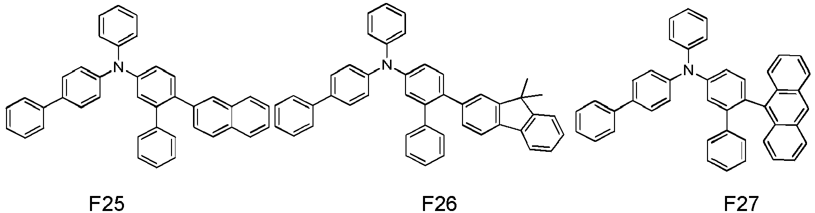

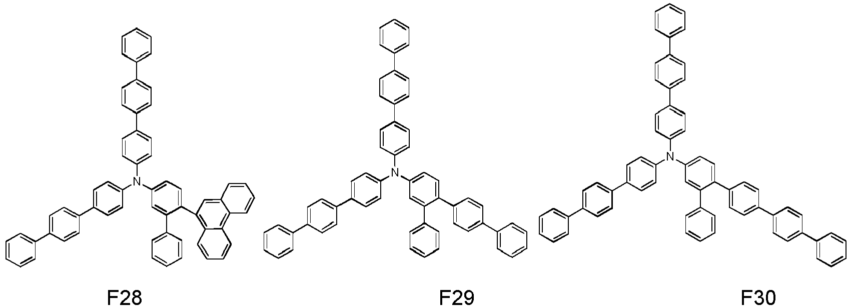

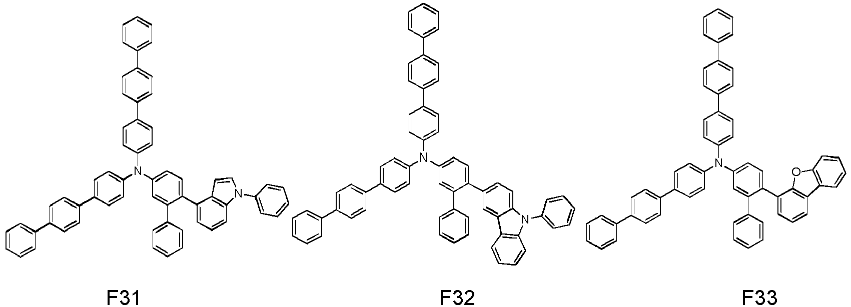

A specific structure of the organic electroluminescent device according to the present invention, a method for fabricating the device, and materials for the organic layers will be described below.

First, a material for the anode is coated on the substrate to form the anode. The substrate may be any of those used in general electroluminescent devices. The substrate is preferably an organic substrate or a transparent plastic substrate that is excellent in transparency, surface smoothness, ease of handling, and waterproofness. A highly transparent and conductive metal oxide, such as indium tin oxide (ITO), indium zinc oxide (IZO), tin oxide (SnO₂) or zinc oxide (ZnO), is used as the anode material.

A material for the hole injecting layer is coated on the anode by vacuum thermal evaporation or spin coating to form the hole injecting layer. Then, a material for the hole transport layer is coated on the hole injecting layer by vacuum thermal evaporation or spin coating to form the hole transport layer.

The material for the hole injecting layer is not specially limited so long as it is usually used in the art.

Specific examples of such materials include 4,4',4"-tris(2-naphthyl(phenyl)amino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis[4-(phenyl-m-tolylamino)phenyl]biphenyl-4,4'-diamine (DNTPD).

The material for the hole transport layer is not specially limited so long as it is commonly used in the art. Examples of such materials include N,N'-bis(3-methylphenyl)-N,N'-diphenyl-[1,1-biphenyl]-4,4'-diamine (TPD) and N,N'-di(naphthalen-1-yl)-N,N'-diphenylbenzidine (a-NPD).

Subsequently, a hole auxiliary layer and the light emitting layer are sequentially laminated on the hole transport layer. A hole blocking layer may be optionally formed on the organic light emitting layer by vacuum thermal evaporation or spin coating. The hole blocking layer blocks holes from entering the cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it has the ability to transport electrons and a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, NTAZ, BeBq₂, OXD-7, and Liq.

The electron transport layer is deposited on the hole blocking layer by vacuum thermal evaporation or spin coating, and the electron injecting layer is formed thereon. A metal for the cathode is deposited on the electron injecting layer by vacuum thermal evaporation to form the cathode, completing the fabrication of the organic electroluminescent device.

As the metal for the formation of the cathode, there may be used, for example, lithium (Li), magnesium (Mg), aluminum (Al), aluminum-lithium (Al-Li), calcium (Ca), magnesium-indium (Mg-In) or magnesium-silver (Mg-Ag). The organic electroluminescent device may be of top emission type. In this case, a transmissive material, such as ITO or IZO, may be used to form the cathode.

The material for the electron transport layer functions to stably transport electrons injected from the cathode. The electron transport material may be any of those known in the art and examples thereof include, but are not limited to, quinoline derivatives, particularly, tris(8-quinolinolate)aluminum (Alq3), TAZ, Balq, beryllium bis(benzoquinolin-10-olate (Bebq2), ADN, and oxadiazole derivatives, such as PBD, BMD, and BND.

Each of the organic layers can be formed by a monomolecular deposition or solution process. According to the monomolecular deposition process, the material for each layer is evaporated under heat and vacuum or reduced pressure to form the layer in the form of a thin film. According to the solution process, the material for each layer is mixed with a suitable solvent, and then the mixture is formed into a thin film by a suitable method, such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, and flexible white lighting systems.

The present invention will be explained in more detail with reference to the following examples. However, it will be obvious to those skilled in the art that these examples are in no way intended to limit the scope of the invention.

### Synthesis Example 1. Synthesis of Compound 1

### Synthesis Example 1-1. Synthesis of Intermediate 1-a

Intermediate 1-a was synthesized by Reaction 1:

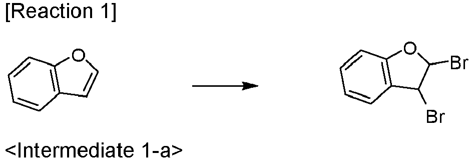

Benzofuran (50 g, 423 mmol) and dichloromethane (500 mL) were stirred in a 1 L reactor. The mixture was cooled to -10 °C and a dilute solution of bromine (67.7 g, 423 mmol) in dichloromethane (100 mL) was added dropwise thereto. The resulting mixture was stirred at 0 °C for 2 h. After completion of the reaction, the reaction mixture was added with an aqueous sodium thiosulfate solution, stirred, and extracted with ethyl acetate and H₂O. The organic layer was concentrated under reduced pressure and recrystallized from ethanol to afford Intermediate 1-a (100 g, yield 93%).

### Synthesis Example 1-2. Synthesis of Intermediate 1-b

Intermediate 1-b was synthesized by Reaction 2:

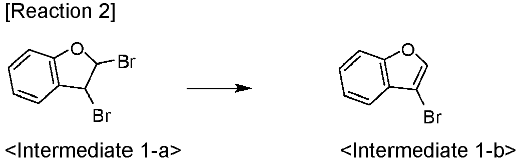

Potassium hydroxide (48.6 g, 866 mmol) and ethanol (400 mL) were dissolved in a 1 L reactor and a solution of Intermediate 1-a (120 g, 433 mmol) in ethanol was added dropwise thereto at 0 °C. After the dropwise addition was finished, the mixture was refluxed with stirring for 2 h. After completion of the reaction, the reaction mixture was concentrated under reduced pressure to remove the ethanol and extracted with ethyl acetate and water. The organic layer was concentrated and purified by column chromatography to afford Intermediate 1-b (42 g, yield 50%)

### Synthesis Example 1-3. Synthesis of Intermediate 1-c

Intermediate 1-c was synthesized by Reaction 3:

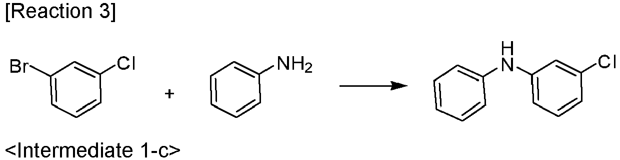

1-Bromo-3-iodobenzene (4.5 g, 16 mmol), aniline (5.8 g, 16 mmol), palladium acetate (0.1 g, 1 mmol), sodium tert-butoxide (3 g, 32 mmol), bis(diphenylphosphino)-1,1'-binaphthyl (0.2 g, 1 mmol), and toluene (45 mL) were placed in a 100 mL reactor. The mixture was refluxed with stirring for 24 h. After completion of the reaction, the reaction mixture was filtered. The filtrate was concentrated and purified by column chromatography to afford Intermediate 1-c (5.2 g, yield 82%).

### Synthesis Example 1-4. Synthesis of Intermediate 1-d

Intermediate 1-d was synthesized by Reaction 4:

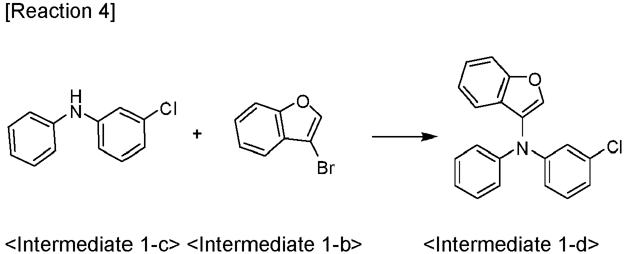

Intermediate 1-c (20 g, 98 mmol), Intermediate 1-b (18.4 g, 98 mmol), palladium acetate (0.5 g, 2 mmol), sodium tert-butoxide (18.9 g, 196 mmol), tri-tert-butylphosphine (0.8 g, 4 mmol), and toluene (200 mL) were placed in a 250 mL reactor. The mixture was refluxed with stirring for 5 h. After completion of the reaction, the reaction mixture was filtered. The filtrate was concentrated and purified by column chromatography to afford Intermediate 1-d (22 g, yield 75%)

### Synthesis Example 1-5. Synthesis of Intermediate 1-e

Intermediate 1-e was synthesized by Reaction 5:

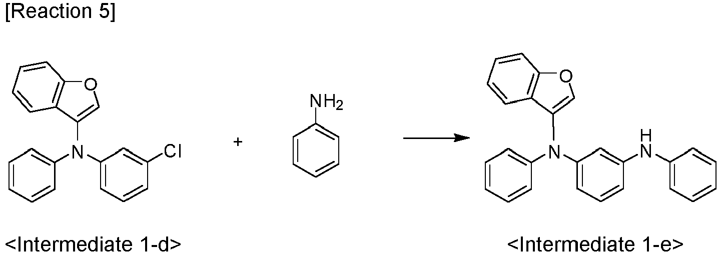

Intermediate 1-e (18.5 g, yield 74.1%) was synthesized in the same manner as in Synthesis Example 1-3, except that Intermediate 1-d was used instead of 1-bromo-4-iodobenzene.

### Synthesis Example 1-6. Synthesis of Intermediate 1-f

Intermediate 1-f was synthesized by Reaction 6:

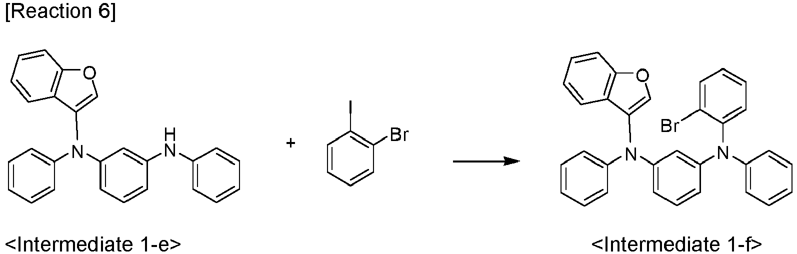

Intermediate 1-f (12 g, yield 84.1%) was synthesized in the same manner as in Synthesis Example 1-4, except that Intermediate 1-e and 1-bromo-2-iodobenzene were used instead of Intermediate 1-c and Intermediate 1-b.

### Synthesis Example 1-7. Synthesis of Compound 1

Compound 1 was synthesized by Reaction 7:

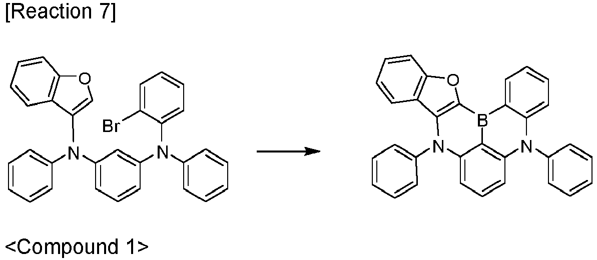

Intermediate 1-f (12 g, 23 mmol) and tert-butylbenzene (120 mL) were placed in a 300 mL reactor, and n-butyllithium (42.5 mL, 68 mmol) was added dropwise thereto at -78 °C. After the dropwise addition was finished, the mixture was stirred at 60 °C for 3 h. Thereafter, the reactor was flushed with nitrogen at 60 °C to remove heptane. After dropwise addition of boron tribromide (11.3 g, 45 mmol) at -78 °C, the resulting mixture was stirred at room temperature for 1 h and N,N-diisopropylethylamine (5.9 g, 45 mmol) was added dropwise thereto at 0 °C. After the dropwise addition was finished, the mixture was stirred at 120 °C for 2 h. After completion of the reaction, the reaction mixture was added with an aqueous sodium acetate solution at room temperature, stirred, and extracted with ethyl acetate. The organic layer was concentrated and purified by column chromatography to give Compound 1 (0.8 g, yield 13%). MS (MALDI-TOF) : m/z 460.17 [M⁺]

### Synthesis Example 2. Synthesis of Compound 2

### Synthesis Example 2-1. Synthesis of Intermediate 2-a

Intermediate 2-a was synthesized by Reaction 8:

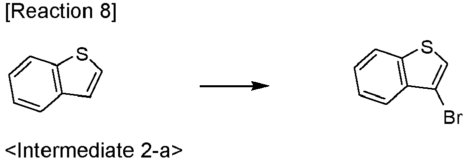

Benzothiophene (50 g, 373 mmol) and chloroform (500 mL) were stirred in a 1 L reactor. The mixture was cooled to -0 °C and a dilute solution of bromine (59.5 g, 373 mmol) in chloroform (100 mL) was added dropwise thereto. After the dropwise addition was finished, the resulting mixture was stirred at room temperature for 4 h. After completion of the reaction, the reaction mixture was added with an aqueous sodium thiosulfate solution, stirred, and extracted with ethyl acetate and H₂O. The organic layer was concentrated under reduced pressure and purified by column chromatography to afford Intermediate 2-a (70 g, yield 91%)

### Synthesis Example 2-2. Synthesis of Intermediate 2-b

Intermediate 2-b was synthesized by Reaction 9:

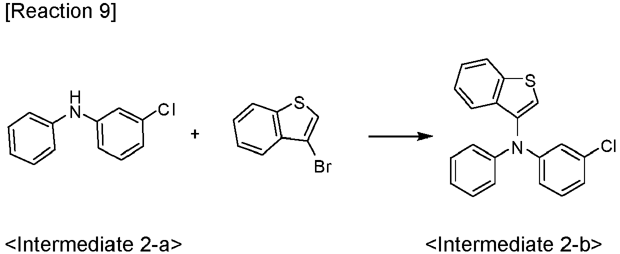

Intermediate 2-b (32 g, yield 75.4%) was synthesized in the same manner as in Synthesis Example 1-4, except that Intermediate 2-a was used instead of Intermediate 1-b.

### Synthesis Example 2-3. Synthesis of Intermediate 2-c

Intermediate 2-c was synthesized by Reaction 10:

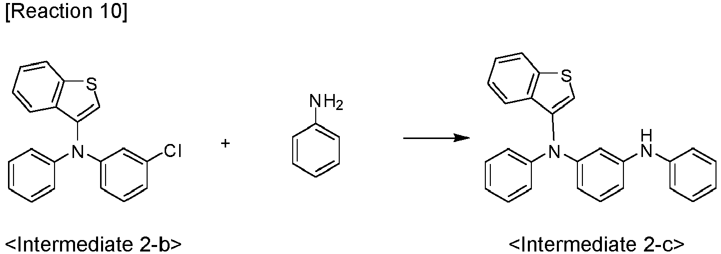

Intermediate 2-c (24.5 g, yield 73.1%) was synthesized in the same manner as in Synthesis Example 1-3, except that Intermediate 2-b was used instead of 1-bromo-4-iodobenzene.

### Synthesis Example 2-4. Synthesis of Intermediate 2-d

Intermediate 2-d was synthesized by Reaction 11:

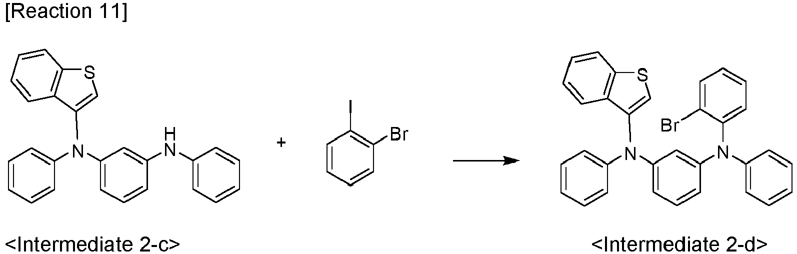

Intermediate 2-d (21 g, yield 77.5%) was synthesized in the same manner as in Synthesis Example 1-4, except that Intermediate 2-c and 1-bromo-2-iodobenzene were used instead of Intermediate 1-c and Intermediate 1-b.

### Synthesis Example 2-5. Synthesis of Compound 2

Compound 2 was synthesized by Reaction 12:

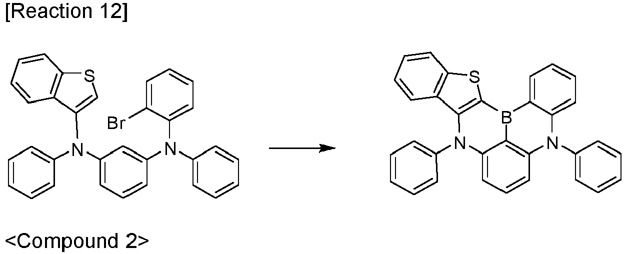

Compound 2 (1.5 g, yield 10.1%) was synthesized in the same manner as in Synthesis Example 1-7, except that Intermediate 2-d was used instead of Intermediate 1-f.
MS (MALDI-TOF) : m/z 467.15 [M⁺]

### Synthesis Example 3. Synthesis of Compound 13

### Synthesis Example 3-1. Synthesis of Intermediate 3-a

Intermediate 3-a was synthesized by Reaction 13:

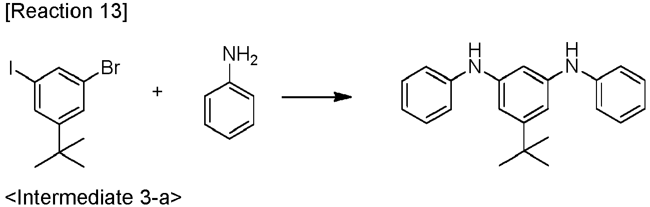

1-Bromo-3(tert-butyl)-5-iodobenzene (50 g, 177 mmol), aniline (36.2 g, 389 mmol), palladium acetate (1.6 g, 7 mmol), sodium tert-butoxide (51 g, 530 mmol), bis(diphenylphosphino)-1,1'-binaphthyl (4.4 g, 7 mmol), and toluene (500 mL) were placed in a 1 L reactor. The mixture was refluxed with stirring for 24 h. After completion of the reaction, the reaction mixture was filtered. The filtrate was concentrated and purified by column chromatography to afford Intermediate 3-a (42.5 g, yield 50%).

### Synthesis Example 3-2. Synthesis of Intermediate 3-b

Intermediate 3-b was synthesized by Reaction 14:

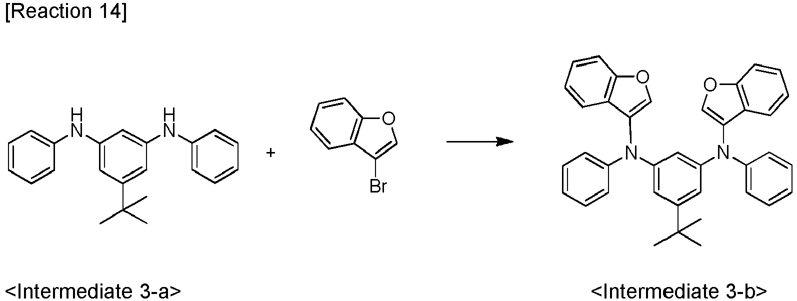

Intermediate 3-a (11 g, 42 mmol), Intermediate 1-b (20 g, 101 mmol), palladium acetate (1 g, 2 mmol), sodium tert-butoxide (12.2 g, 127 mmol), tri-tert-butylphosphine (0.7 g, 3 mmol), and toluene (150 mL) were placed in a 250 mL reactor. The mixture was refluxed with stirring for 5 h. After completion of the reaction, the reaction mixture was filtered. The filtrate was concentrated and purified by column chromatography to afford Intermediate 3-b (11 g, yield 65%)

### Synthesis Example 3-3. Synthesis of Compound 13

Compound 13 was synthesized by Reaction 15:

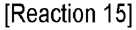

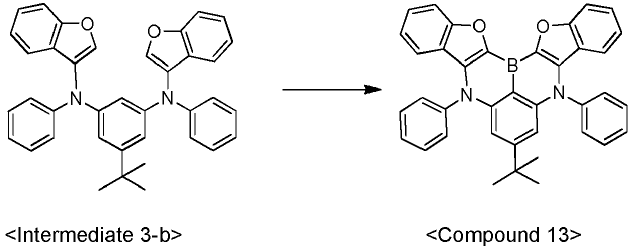

Compound 13 (0.5 g, yield 8%) was synthesized in the same manner as in Synthesis Example 1-7, except that Intermediate 3-b was used instead of Intermediate 1-f.
MS (MALDI-TOF) : m/z 556.23 [M⁺]

### Synthesis Example 4. Synthesis of Compound 65

### Synthesis Example 4-1. Synthesis of Intermediate 4-a

Intermediate 4-a was synthesized by Reaction 16:

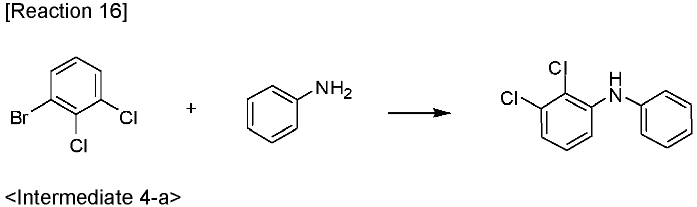

Intermediate 4-a (35.6 g, yield 71.2%) was synthesized in the same manner as in Synthesis Example 1-3, except that 1-bromo-2,3-dichlorobenzene was used instead of 1-bromo-4-iodobenzene.

### Synthesis Example 4-2. Synthesis of Intermediate 4-b

Intermediate 4-b was synthesized by Reaction 17:

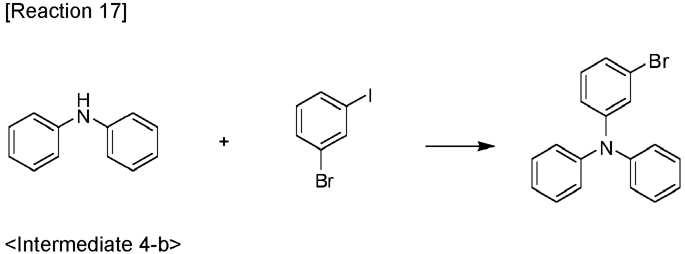

Diphenylamine (60.0 g, 355 mmol), 1-bromo-3-iodobenzene (100.3 g, 355 mmol), palladium acetate (0.8 g, 4 mmol), xantphos (2 g, 4 mmol), sodium tert-butoxide (68.2 g, 709 mmol), and toluene (700 mL) were placed in a 2 L reactor. The mixture was refluxed with stirring for 2 h. After completion of the reaction, the reaction mixture was filtered at room temperature, concentrated under reduced pressure, and purified by column chromatography to afford Intermediate 4-b (97 g, yield 91.2%).

### Synthesis Example 4-3. Synthesis of Intermediate 4-c

Intermediate 4-c was synthesized by Reaction 18:

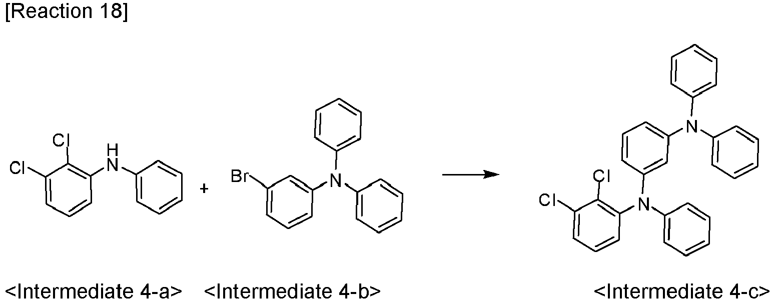

Intermediate 4-c (31 g, yield 77.7%) was synthesized in the same manner as in Synthesis Example 1-4, except that Intermediate 4-a and Intermediate 4-b were used instead of Intermediate 1-c and Intermediate 1-b.

### Synthesis Example 4-4. Synthesis of Intermediate 4-d

Intermediate 4-d was synthesized by Reaction 19:

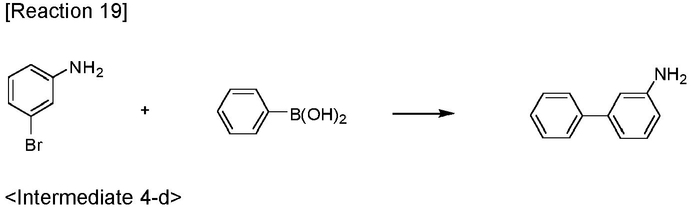

3-Bromoaniline (30 g, 174 mmol), phenylboronic acid (25.5 g, 209 mmol), tetrakis(triphenylphosphine)palladium (4 g, 3 mmol), potassium carbonate (48.2 g, 349 mmol), 1,4-dioxane (150 mL), toluene (150 mL), and distilled water (90 mL) were placed in a 1 L reactor. The mixture was refluxed with stirring for 4 h. After completion of the reaction, the reaction mixture was allowed to stand at room temperature for layer separation. The organic layer was concentrated under reduced pressure and purified by column chromatography to afford Intermediate 4-d (24 g, yield 80%).

### Synthesis Example 4-5. Synthesis of Intermediate 4-e

Intermediate 4-e was synthesized by Reaction 20:

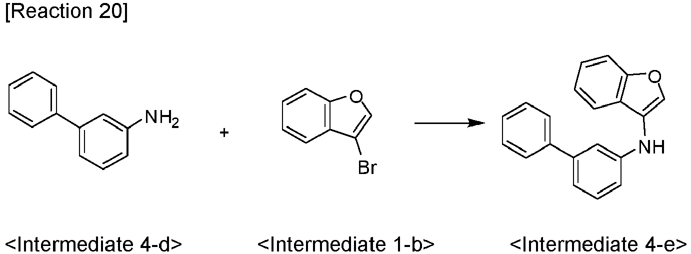

Intermediate 4-e (31.6 g, yield 68.2%) was synthesized in the same manner as in Synthesis Example 1-3, except that Intermediate 4-d and Intermediate 1-b were used instead of 1-bromo-4-iodobenzene and aniline.

### Synthesis Example 4-6. Synthesis of Intermediate 4-f

Intermediate 4-f was synthesized by Reaction 21:

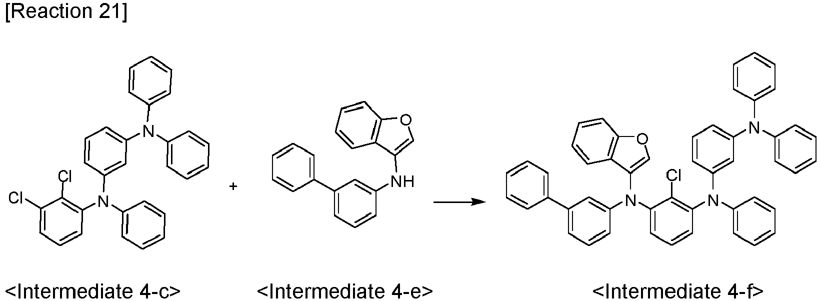

Intermediate 4-f (21 g, yield 67.7%) was synthesized in the same manner as in Synthesis Example 1-4, except that Intermediate 4-c and Intermediate 4-e were used instead of Intermediate 1-c and Intermediate 1-b.

### Synthesis Example 4-7. Synthesis of Compound 65

Compound 65 was synthesized by Reaction 22:

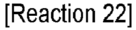

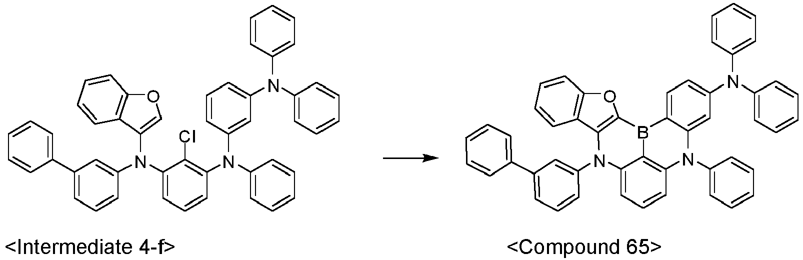

Intermediate 4-f (21 g, 37 mmol) and tert-butylbenzene were placed in a 250 mL reactor, and tert-butyllithium (42.4 mL, 74 mmol) was added dropwise thereto at -78 °C. After the dropwise addition was finished, the mixture was stirred at 60 °C for 3 h. Thereafter, the reactor was flushed with nitrogen at 60 °C to remove pentane. After dropwise addition of boron tribromide (7.1 mL, 74 mmol) at -78 °C, the resulting mixture was stirred at room temperature for 1 h and N,N-diisopropylethylamine (6 g, 74 mmol) was added dropwise thereto at 0 °C. After the dropwise addition was finished, the mixture was stirred at 120 °C for 2 h. After completion of the reaction, the reaction mixture was added with an aqueous sodium acetate solution at room temperature, stirred, and extracted with ethyl acetate. The organic layer was concentrated and purified by column chromatography to give Compound 65 (2.0 g, yield 17.4%).
MS (MALDI-TOF) : m/z 703.28 [M⁺]

### Synthesis Example 5. Synthesis of Compound 73

### Synthesis Example 5-1. Synthesis of Intermediate 5-a

Intermediate 5-a was synthesized by Reaction 23:

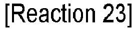

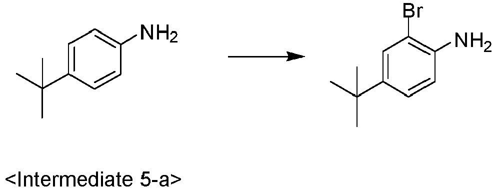

4-tert-butylaniline (40 g, 236 mmol) was dissolved in methylene chloride (400 mL) in a 1 L reactor. The mixture was stirred at 0 °C. Thereafter, N-bromosuccinimide (42 g, 236 mmol) was slowly added to the reactor. The resulting mixture was stirred at room temperature for 4 h. After completion of the reaction, H₂O was added dropwise to the reaction mixture at room temperature, followed by extraction with methylene chloride. The organic layer was concentrated and purified by column chromatography to afford Intermediate 5-a (48 g, yield 80%).

### Synthesis Example 5-2. Synthesis of Intermediate 5-b

Intermediate 5-b was synthesized by Reaction 24:

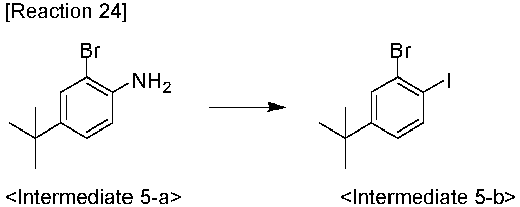

Intermediate 5-a (80 g, 351 mmol) and water (450 mL) were stirred in a 2 L reactor. The mixture was added with sulfuric acid (104 mL) and a solution of sodium nitrite (31.5 g, 456 mmol) in water (240 mL) was added dropwise thereto at 0 °C. After the dropwise addition was finished, the resulting mixture was stirred at 0 °C for 2 h. After dropwise addition of a solution of potassium iodide (116.4 g, 701 mmol) in water (450 mL) at 0 °C, the mixture was stirred at room temperature for 6 h. After completion of the reaction, the reaction mixture was added with an aqueous sodium thiosulfate solution at room temperature, stirred, and extracted with ethyl acetate. The organic layer was concentrated and purified by column chromatography to afford Intermediate 5-b (58 g, yield 51%).

### Synthesis Example 5-3. Synthesis of Intermediate 5-c

Intermediate 5-c was synthesized by Reaction 25:

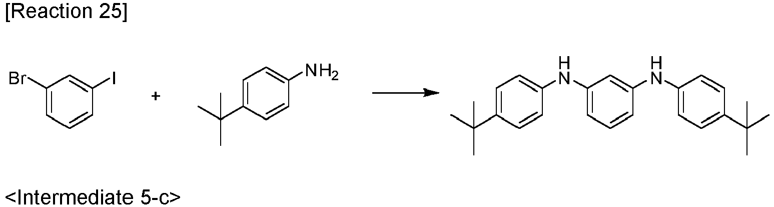

Intermediate 5-c (95 g, yield 80.4%) was synthesized in the same manner as in Synthesis Example 3-1, except that 4-tert-butylaniline was used instead of aniline.

### Synthesis Example 5-4. Synthesis of Intermediate 5-d

Intermediate 5-d was synthesized by Reaction 26:

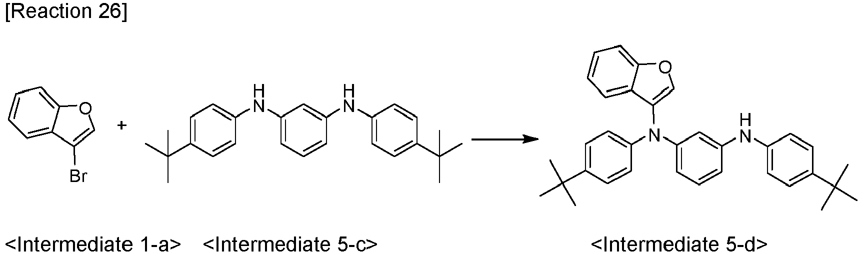

Intermediate 5-d (31 g, yield 71.5%) was synthesized in the same manner as in Synthesis Example 1-4, except that Intermediate 5-c was used instead of Intermediate 1-c.

### Synthesis Example 5-5. Synthesis of Intermediate 5-e

Intermediate 5-e was synthesized by Reaction 27:

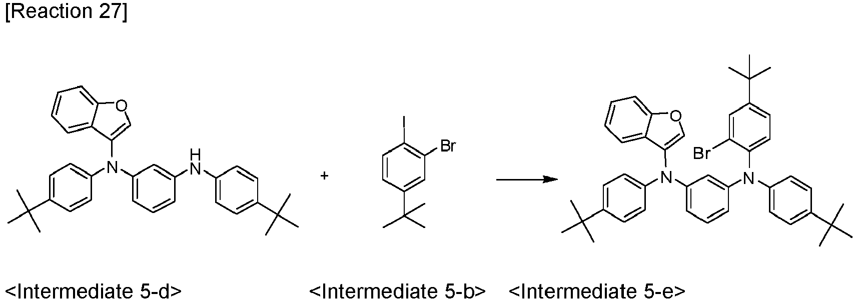

Intermediate 5-e (24 g, yield 67.1%) was synthesized in the same manner as in Synthesis Example 1-4, except that Intermediate 5-d and Intermediate 5-b were used instead of Intermediate 1-c and Intermediate 1-b.

### Synthesis Example 5-6. Synthesis of Compound 73

Compound 73 was synthesized by Reaction 28:

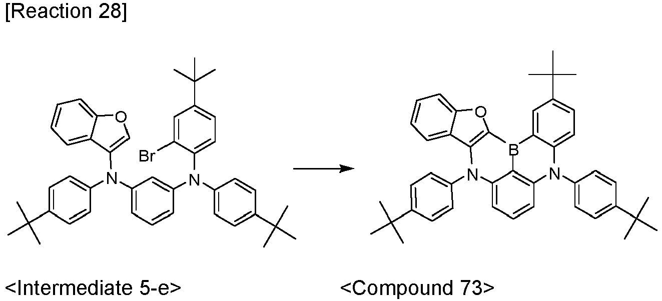

Compound 73 (2.4 g, yield 15%) was synthesized in the same manner as in Synthesis Example 1-7, except that Intermediate 5-e was used instead of Intermediate 1-f.
MS (MALDI-TOF) : m/z 628.36 [M⁺]

### Synthesis Example 6. Synthesis of Compound 109

### Synthesis Example 6-1. Synthesis of Intermediate 6-a

Intermediate 6-a was synthesized by Reaction 29:

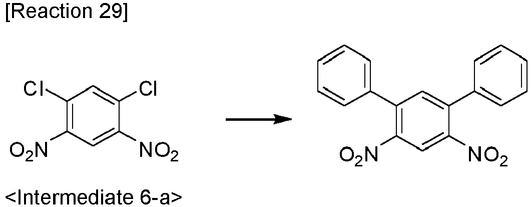

1,5-Dichloro-2,4-dinitrobenzene (40.0 g, 123 mmol), phenylboronic acid (44.9 g, 368 mmol), tetrakis(triphenylphosphine)palladium (2.8 g, 2.5 mmol), potassium carbonate (50.9 g, 368 mmol), 1,4-dioxane (120 mL), toluene (200 mL), and water (120 mL) were placed in a 1 L reactor. The mixture was refluxed with stirring. After completion of the reaction, the reaction mixture was extracted with water and ethyl acetate. The organic layer was concentrated and purified by column chromatography to afford Intermediate 6-a (27.5 g, yield 70%).

### Synthesis Example 6-2. Synthesis of Intermediate 6-b

Intermediate 6-b was synthesized by Reaction 30:

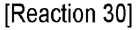

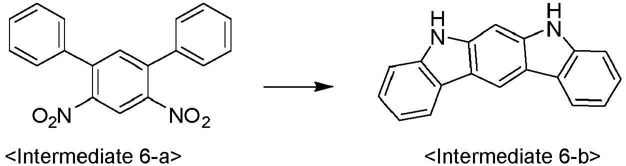

Intermediate 6-a (27.5 g, 86 mmol), triphenylphosphine (57.8 g, 348 mmol), and dichlorobenzene (300 mL) were placed in a 1 L reactor. The mixture was refluxed with stirring for 3 days. After completion of the reaction, the dichlorobenzene was removed, followed by column chromatography to afford Intermediate 6-b (10.8 g, yield 49.0%).

### Synthesis Example 6-3. Synthesis of Intermediate 6-c

Intermediate 6-c was synthesized by Reaction 31:

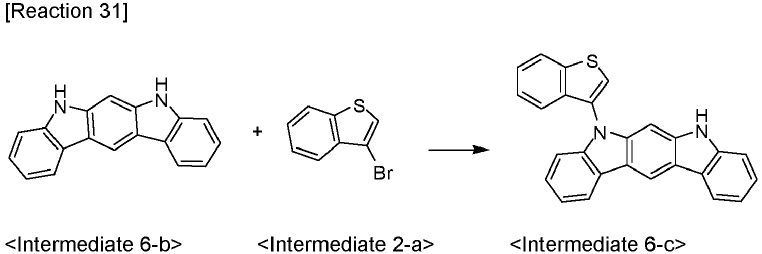

Intermediate 6-b (10.8 g, 42 mmol), Intermediate 2-a (11.0 g, 10.8 mmol), a copper powder (10.7 g, 1 mmol), 18-crown-6-ether (4.5 g, 17 mmol), and potassium carbonate (34.9 g, 253 mmol) were placed in a 250 mL reactor, and dichlorobenzene (110 mL) was added thereto. The mixture was refluxed with stirring at 180 °C for 24 h. After completion of the reaction, the dichlorobenzene was removed, followed by column chromatography to afford Intermediate 6-c (9.5 g, yield 52%).

### Synthesis Example 6-4. Synthesis of Intermediate 6-d

Intermediate 6-d was synthesized by Reaction 32:

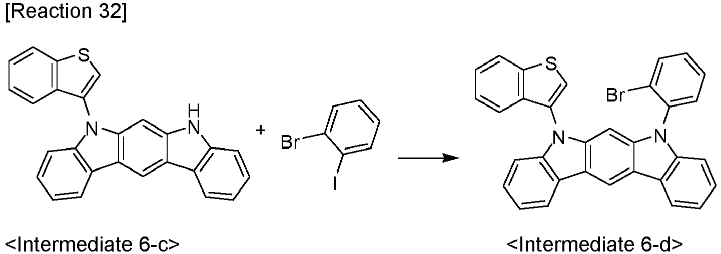

Intermediate 6-d (14 g, yield 67.1%) was synthesized in the same manner as in Synthesis Example 6-3, except that Intermediate 6-c and 1-bromo-2-iodobenzene were used instead of Intermediate 1-c and Intermediate 2-a.

### Synthesis Example 6-5. Synthesis of Compound 109

Compound 109 was synthesized by Reaction 33:

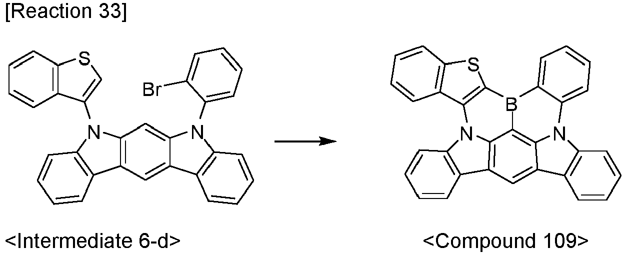

Compound 109 (2.1 g, yield 14%) was synthesized in the same manner as in Synthesis Example 1-7, except that Intermediate 6-d was used instead of Intermediate 1-f.
MS (MALDI-TOF) : m/z 472.12 [M⁺]

### Synthesis Example 7. Synthesis of Compound 126

### Synthesis Example 7-1. Synthesis of Intermediate 7-a

Intermediate 7-a was synthesized by Reaction 34:

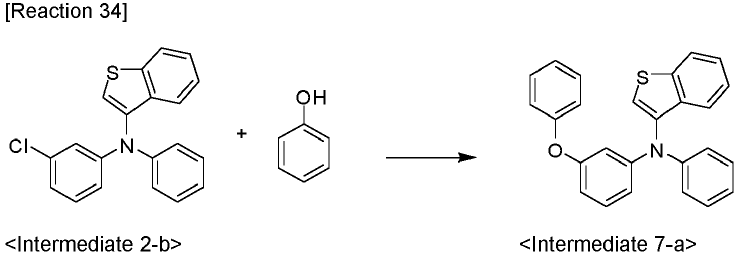

Intermediate 2-b (30.0 g, 150 mmol), phenol (31.2 g, 160 mmol), potassium carbonate (45.7 g, 300 mmol), and NMP (250 mL) were placed in a 500 mL reactor. The mixture was refluxed with stirring at 160 °C for 12 h. After completion of the reaction, the reaction mixture was cooled to room temperature, distilled under reduced pressure to remove the NMP, and extracted with water and ethyl acetate. The organic layer was concentrated under reduced pressure and purified by column chromatography to afford Intermediate 7-a (22 g, yield 68%).

### Synthesis Example 7-2. Synthesis of Compound 126

Compound 126 was synthesized by Reaction 35:

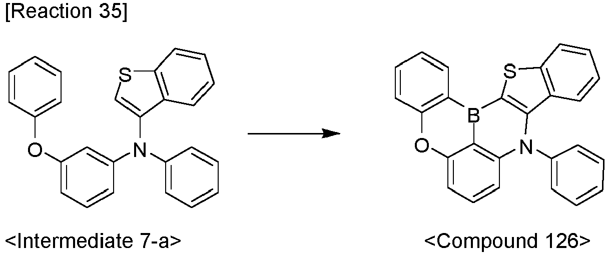

Compound 126 (1.2 g, yield 13.4%) was synthesized in the same manner as in Synthesis Example 1-7, except that Intermediate 7-a was used instead of Intermediate 1-f.
MS (MALDI-TOF) : m/z 401.10 [M⁺]

### Synthesis Example 8. Synthesis of Compound 145

### Synthesis Example 8-1. Synthesis of 8-a

8-a was synthesized by Reaction 36:

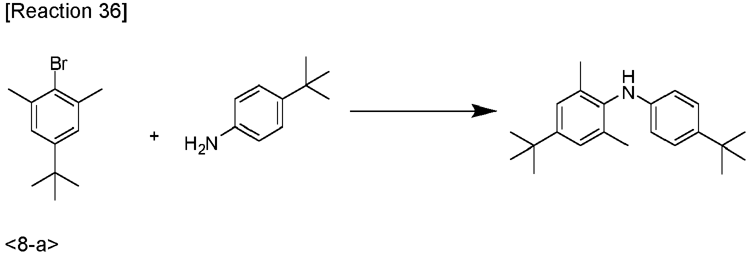

8-a (41.6 g, yield 88.2%) was synthesized in the same manner as in Synthesis Example 1-3, except that 2-bromo-5-tert-butyl-1,3-dimethylbenzene and 4-tert-butylaniline were used instead of 1-bromo-3-iodobenzene and aniline.

### Synthesis Example 8-2. Synthesis of 8-b

8-b was synthesized by Reaction 37:

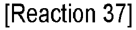

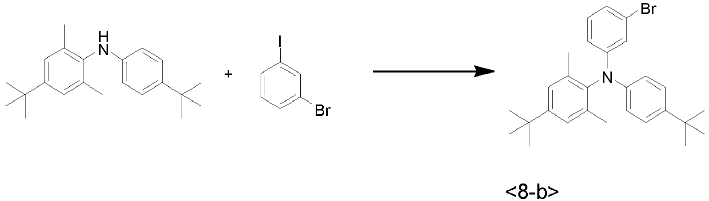

8-b (37.6 g, yield 78.4%) was synthesized in the same manner as in Synthesis Example 4-2, except that 8-a was used instead of diphenylamine.

### Synthesis Example 8-3. Synthesis of 8-c

8-c was synthesized by Reaction 38:

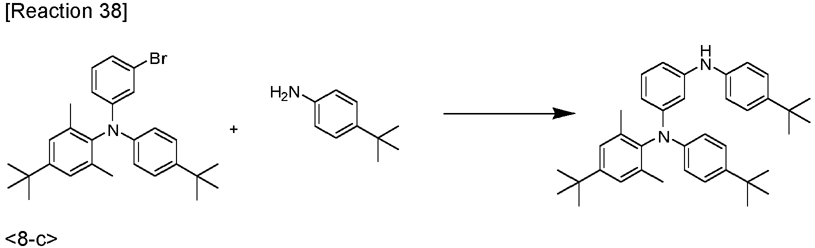

8-c (31.2 g, yield 74.2%) was synthesized in the same manner as in Synthesis Example 1-3, except that 8-b and 4-tert-butylaniline were used instead of 1-bromo-3-iodobenzene and aniline.

### Synthesis Example 8-4. Synthesis of 8-d

8-d was synthesized by Reaction 39:

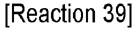

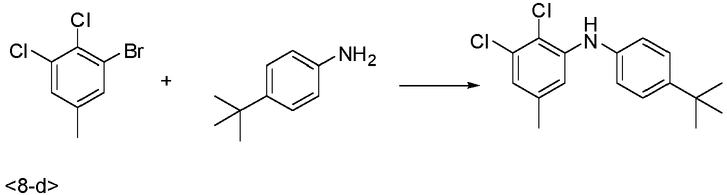

8-d (30.3 g, yield 89.8%) was synthesized in the same manner as in Synthesis Example 1-3, except that 1-bromo-2,3-dichloro-5-ethylbenzene and 4-tert-butylaniline were used instead of 1-bromo-3-iodobenzene and aniline.

### Synthesis Example 8-5. Synthesis of 8-e

8-e was synthesized by Reaction 40:

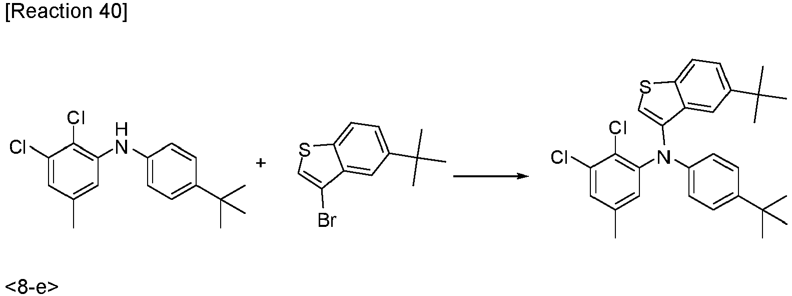

8-e (27.4 g, yield 77.1%) was synthesized in the same manner as in Synthesis Example 1-4, except that 8-d and 3-bromo-5-tert-butylbenzothiophene were used instead of 1-c and 1-b.

### Synthesis Example 8-6. Synthesis of 8-f

8-f was synthesized by Reaction 41:

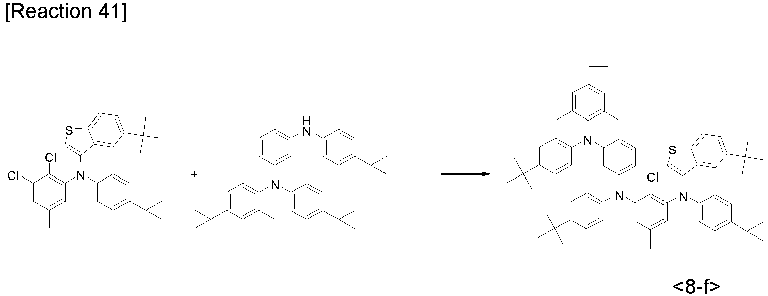

8-f (21 g, yield 74.1%) was synthesized in the same manner as in Synthesis Example 1-4, except that 8-e and 8-c were used instead of 1-c and 1-b.

### Synthesis Example 8-7. Synthesis of Compound 145

Compound 145 was synthesized by Reaction 42:

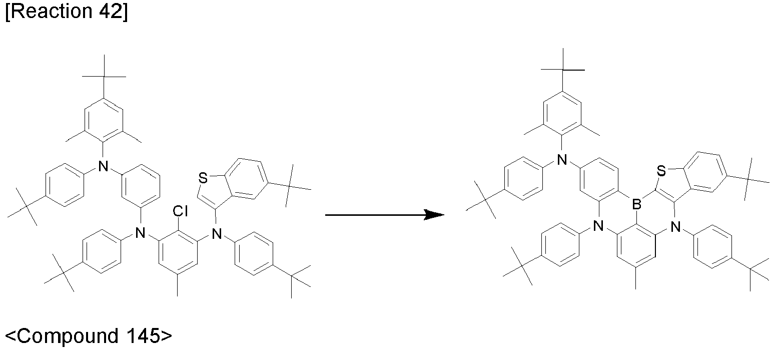

Compound 145 (3.4 g, yield 19.4%) was synthesized in the same manner as in Synthesis Example 1-7, except that 8-f was used instead of 1-f.
MS [M]⁺979.60

### Synthesis Example 9. Synthesis of Compound 150

### Synthesis Example 9-1. Synthesis of 9-a

9-a was synthesized by Reaction 43:

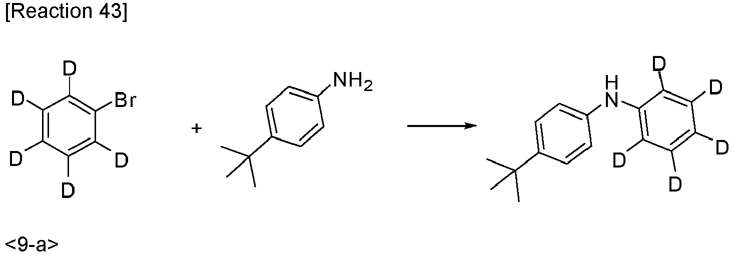

9-a (32.7 g, yield 78.2%) was synthesized in the same manner as in Synthesis Example 1-3, except that 1-bromobenzene-d5 and 4-tert-butylaniline were used instead of 1-bromo-3-iodobenzene and aniline.

### Synthesis Example 9-2. Synthesis of 9-b

### 9-b was synthesized by Reaction 44:

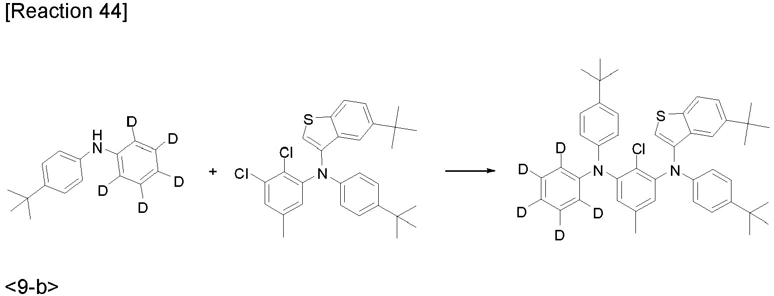

9-b (34.2 g, yield 84.1%) was synthesized in the same manner as in Synthesis Example 1-4, except that 8-e and 9-a were used instead of 1-c and 1-b.

### Synthesis Example 9-3. Synthesis of Compound 150

Compound 150 was synthesized by Reaction 45:

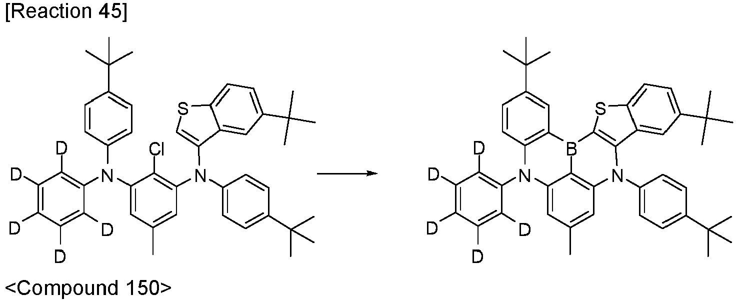

Compound 150 (2.7 g, yield 11.4%) was synthesized in the same manner as in Synthesis Example 1-7, except that 9-b was used instead of 1-f.
MS [M]⁺663.39

### Synthesis Example 10. Synthesis of Compound 153

### Synthesis Example 10-1. Synthesis of 10-a

10-a was synthesized by Reaction 46:

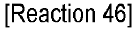

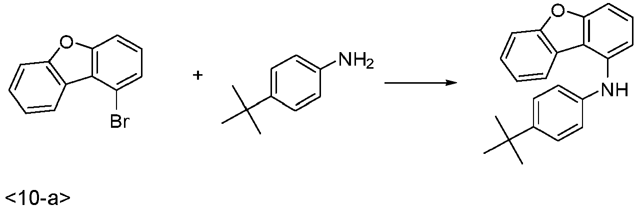

10-a (25.6 g, yield 79.2%) was synthesized in the same manner as in Synthesis Example 1-3, except that 1-bromo-dibenzofuran and 4-tert-butylaniline were used instead of 1-bromo-3-iodobenzene and aniline.

### Synthesis Example 10-2. Synthesis of 10-b

10-b was synthesized by Reaction 47:

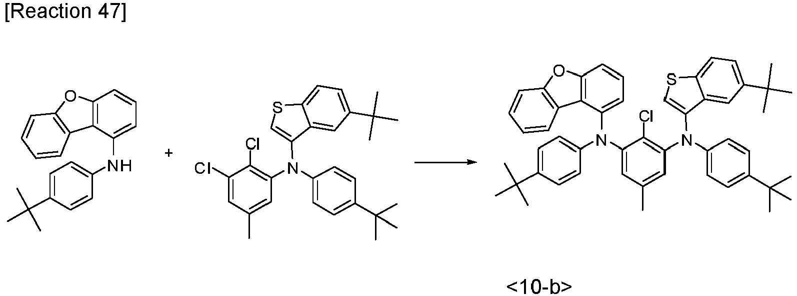

10-b (18.6 g, yield 74.1%) was synthesized in the same manner as in Synthesis Example 1-4, except that 8-e and 10-a were used instead of 1-c and 1-b.

### Synthesis Example 10-3. Synthesis of Compound 153

Compound 153 was synthesized by Reaction 48:

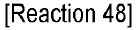

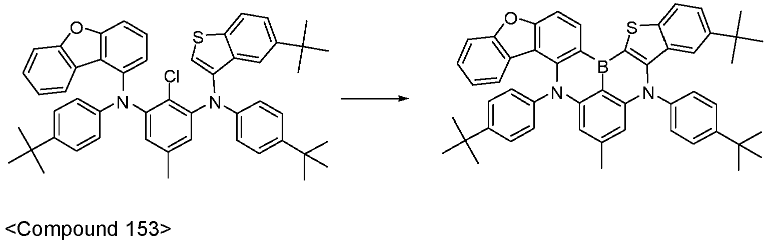

Compound 153 (3.4 g, yield 15.4%) was synthesized in the same manner as in Synthesis Example 1-7, except that 10-b was were used instead of 1-f.
MS [M]⁺748.37

### Examples 1-10: Fabrication of organic electroluminescent devices

ITO glass was patterned to have a light emitting area of 2 mm × 2 mm, followed by cleaning. After the cleaned ITO glass was mounted in a vacuum chamber, the base pressure was adjusted to 1 × 10⁻⁷ torr. DNTPD (700 Å) and the compound of Formula H (250 Å) were deposited in this order on the ITO. A mixture of BH1 as a host and each of Compound 1, 2, 13, 49, 65, 73, 109, 120, 126, and 141 (3 wt%) was used to form a 250 Å thick light emitting layer. Thereafter, the compound of Formula E-1 and the compound of Formula E-2 in a ratio of 1:1 were used to form a 300 Å thick electron transport layer on the light emitting layer. The compound of Formula E-1 was used to form a 5 Å thick electron injecting layer on the electron transport layer. Al was deposited on the electron injecting layer to form a 1000 Å thick Al electrode, completing the fabrication of an organic electroluminescent device. The luminescent properties of the organic electroluminescent device were measured at 0.4 mA.

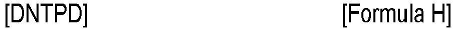

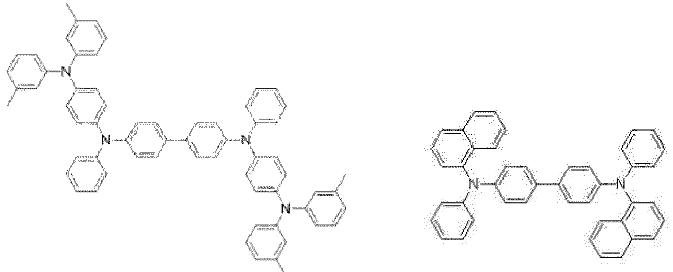

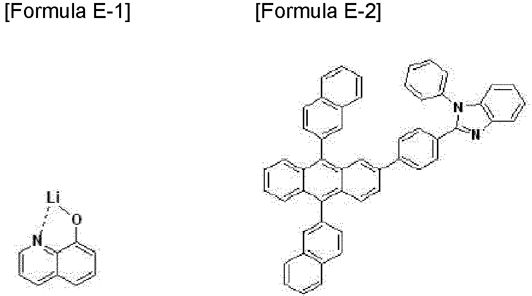

### Comparative Examples 1-3

Organic electroluminescent devices were fabricated in the same manner as in Example 1, except that BD1, BD2, and BD3 were used instead of Compound 1. The luminescent properties of the organic electroluminescent device were measured at 0.4 mA. The structures of BH1, BD1, BD2, and BD3 are as follows.

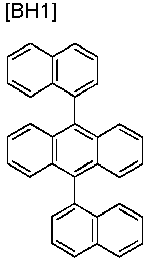

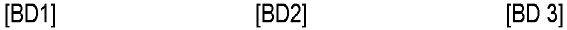

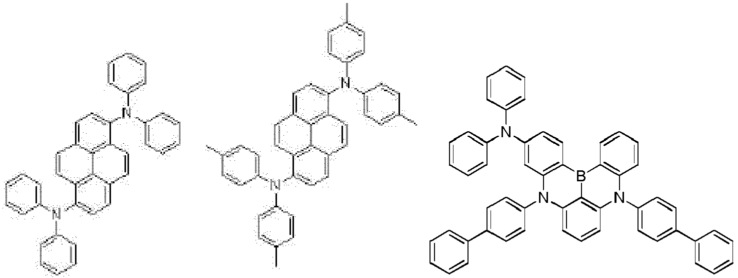

The organic electroluminescent devices of Examples 1-10 and Comparative Examples 1-3 were measured for voltage, current, luminance, color coordinates, and lifetime. The results are shown in Table 1.

**TABLE 1**

| Example No. | Dopant | Current density (mA/cm²) | Voltage (V) | External quantum efficiency (%) | T90 (hr) |
|---|---|---|---|---|---|
| Example 1 | Compound 1 | 10 | 3.89 | 8.9 | 185 |
| Example 2 | Compound 2 | 10 | 3.95 | 8.8 | 175 |
| Example 3 | Compound 13 | 10 | 3.69 | 8.9 | 153 |
| Example 4 | Compound 49 | 10 | 3.75 | 8.3 | 191 |
| Example 5 | Compound 65 | 10 | 3.81 | 8.8 | 185 |
| Example 6 | Compound 73 | 10 | 3.92 | 8.7 | 166 |
| Example 7 | Compound 109 | 10 | 3.81 | 8.5 | 189 |
| Example 8 | Compound 120 | 10 | 3.92 | 8.9 | 178 |
| Example 9 | Compound 126 | 10 | 4.01 | 9.1 | 177 |
| Example 10 | Compound 141 | 10 | 3.95 | 8.9 | 195 |
| Comparative Example 1 | BD1 | 10 | 4.17 | 7.5 | 142 |
| Comparative Example 2 | BD2 | 10 | 4.22 | 7.1 | 137 |
| Comparative Example 3 | BD3 | 10 | 4.15 | 5.8 | 88 |

As can be seen from the results in Table 1, the organic electroluminescent devices employing the inventive boron compounds (Examples 1-10) showed higher quantum efficiencies and longer lifetimes than the organic electroluminescent devices of Comparative Examples 1-3.

### Examples 11-19: Fabrication of organic electroluminescent devices

ITO glass was patterned to have a light emitting area of 2 mm × 2 mm, followed by cleaning. After the cleaned ITO glass was mounted in a vacuum chamber, the base pressure was adjusted to 1 × 10⁻⁷ torr. DNTPD (700 Å) and the compound of Formula F (250 Å) were deposited in this order on the ITO. A mixture of BH2 as a host and each of Compound 145, 146, 153, 155, 157, 159, 164, 165, and 167 (3 wt%) was used to form a 250 Å thick light emitting layer. Thereafter, the compound of Formula E-1 and the compound of Formula E-2 in a ratio of 1:1 were used to form a 300 Å thick electron transport layer on the light emitting layer. The compound of Formula E-1 was used to form a 5 Å thick electron injecting layer on the electron transport layer. Al was deposited on the electron injecting layer to form a 1000 Å thick Al electrode, completing the fabrication of an organic electroluminescent device. The luminescent properties of the organic electroluminescent device were measured at 0.4 mA.

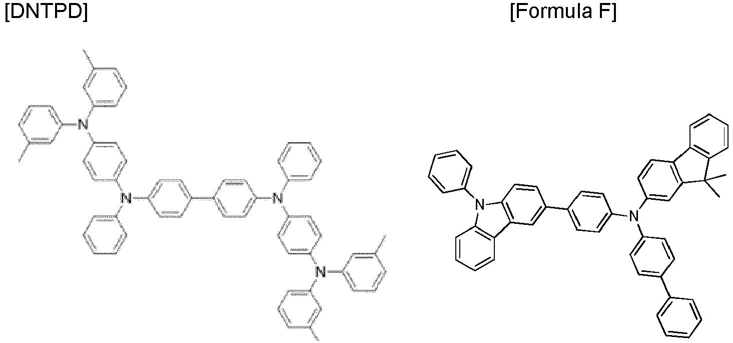

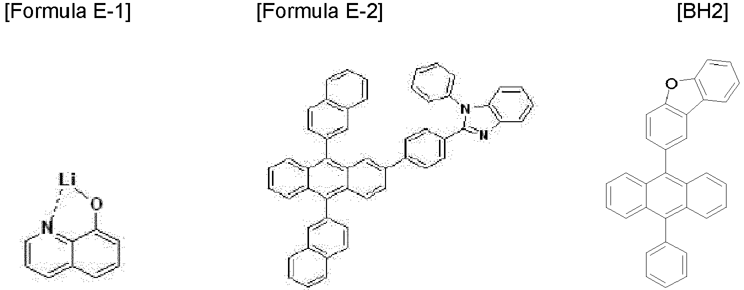

### Comparative Examples 4-5

Organic electroluminescent devices were fabricated in the same manner as in Example 1, except that BD3, BD4, and BD5 were used instead of Compound 1. The luminescent properties of the organic electroluminescent device were measured at 0.4 mA. The structures of BD3, BD4, and BD5 are as follows.

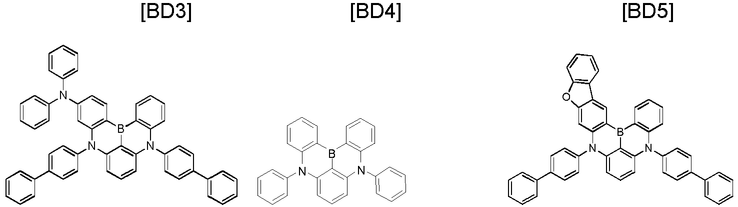

**TABLE 2**

| Example No. | Dopant | Driving voltage | External quantum efficiency (%) | T97 (hr) |
|---|---|---|---|---|
| Example 11 | Compound 145 | 3.8 | 8.36 | 180 |
| Example 12 | Compound 146 | 3.8 | 9.24 | 145 |
| Example 13 | Compound 153 | 3.8 | 8.54 | 160 |
| Example 14 | Compound 155 | 3.8 | 8.09 | 186 |
| Example 15 | Compound 157 | 3.8 | 8.18 | 180 |
| Example 16 | Compound 159 | 3.8 | 8.88 | 206 |
| Example 17 | Compound 164 | 3.8 | 7.92 | 165 |
| Example 18 | Compound 165 | 3.8 | 8.45 | 180 |
| Example 19 | Compound 167 | 3.8 | 8.53 | 213 |
| Comparative Example 4 | BD3 | 3.8 | 4.95 | 53 |
| Comparative Example 5 | BD4 | 3.7 | 5.45 | 26 |
| Comparative Example 6 | BD5 | 3.7 | 5.28 | 35 |

As can be seen from the results in Table 2, the organic electroluminescent devices employing the inventive boron compounds (Examples 11-19) showed higher quantum efficiencies and longer lifetimes than the organic electroluminescent devices of Comparative Examples 4-6.

## Claims

1. An organic electroluminescent compound represented by Formula A-3, A-4, A-5 or A-6: 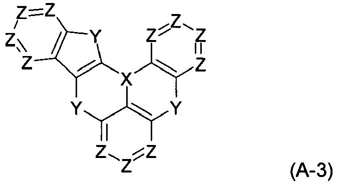 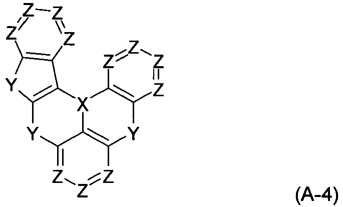 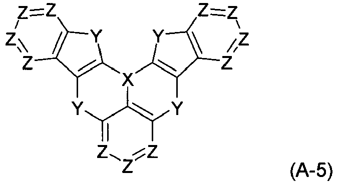 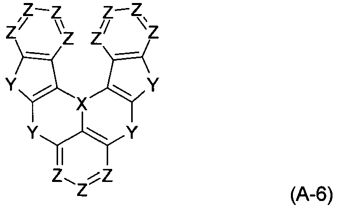 wherein the linkers Y are identical to or different from each other and are each independently selected from N-R₁, CR₂R₃, O, S, Se, and SiR₄R₅, X is B, and R₁ to R₅ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that R₂ and R₃ are optionally linked to each other to form an alicyclic or aromatic monocyclic or polycyclic ring, and R₃ and R₄ are optionally linked to each other to form an alicyclic or aromatic monocyclic or polycyclic ring, each Z is independently CR or N, the substituents R are identical to or different from each other and are independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the substituents R are optionally bonded to each other or are optionally linked to other adjacent substituents to form alicyclic or aromatic monocyclic or polycyclic rings whose carbon atoms are optionally substituted with one or more heteroatoms selected from N, S, and O atoms.

2. The organic electroluminescent compound according to claim 1, **characterized in that** the organic electroluminescent compound represented by Formula A-3, A-4, A-5 or A-6 is selected from the following compounds:

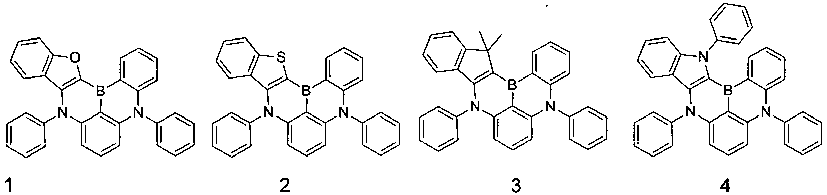

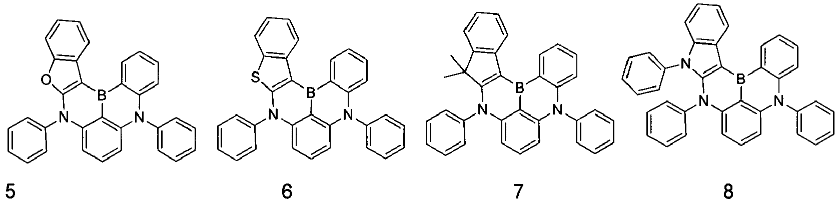

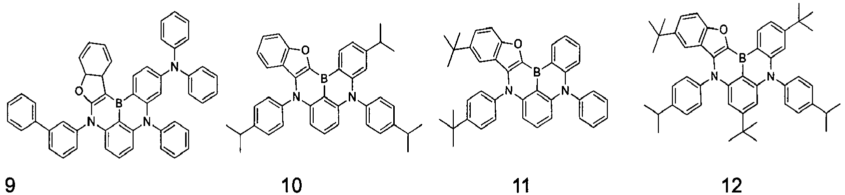

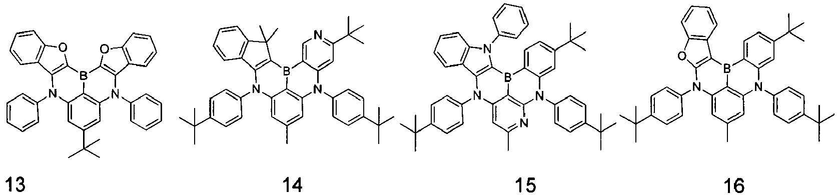

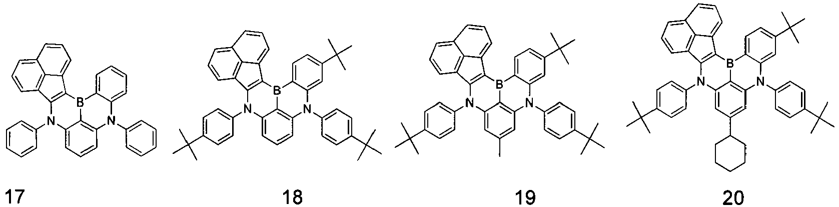

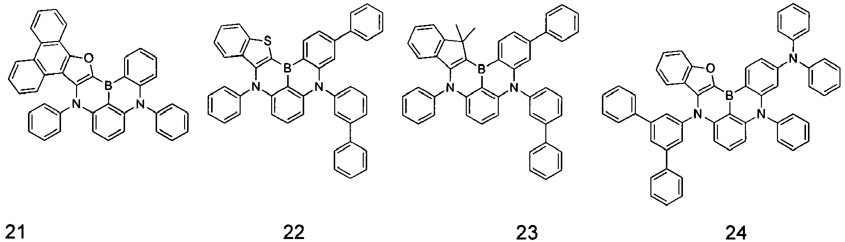

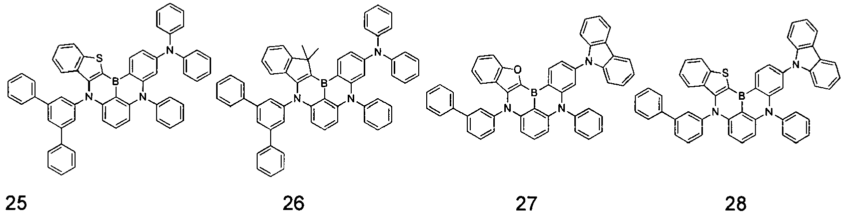

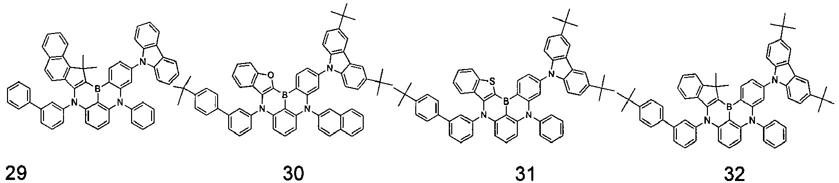

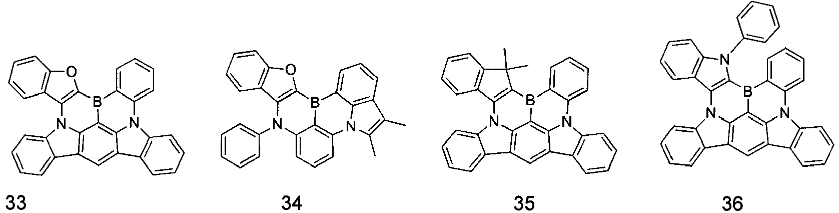

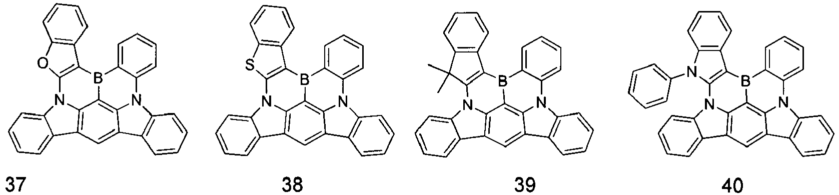

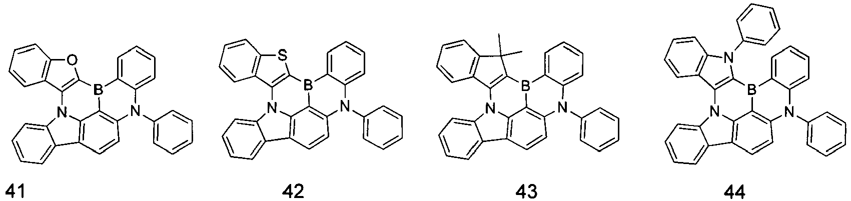

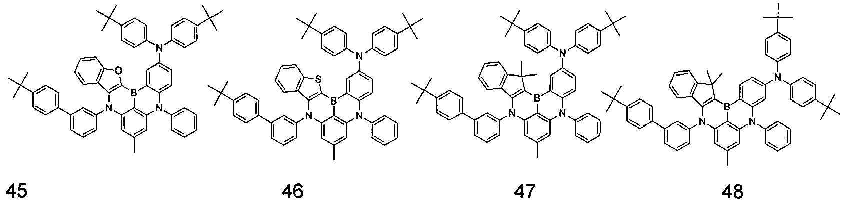

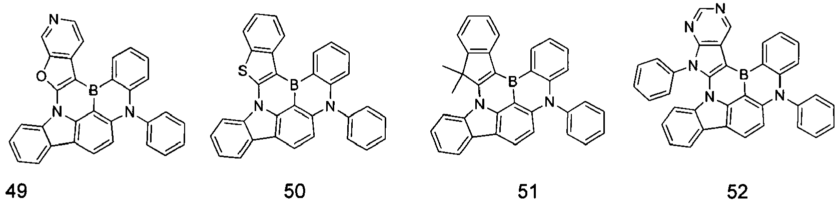

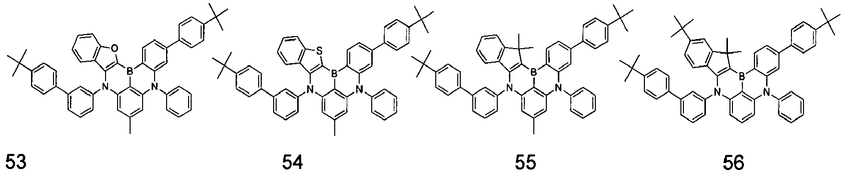

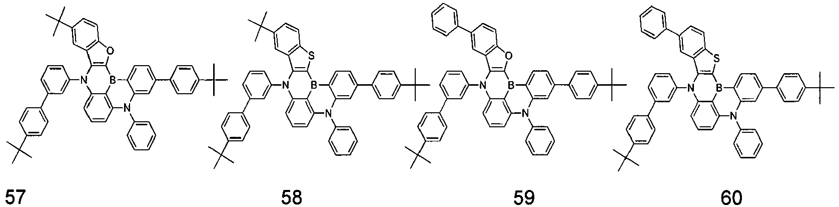

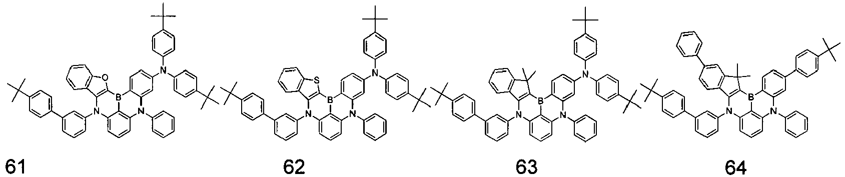

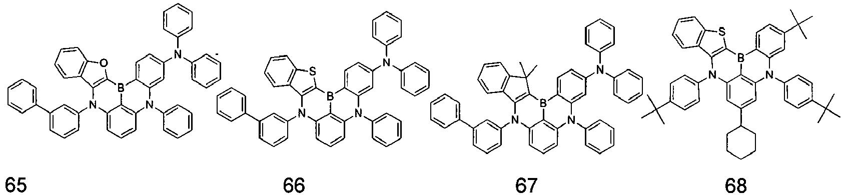

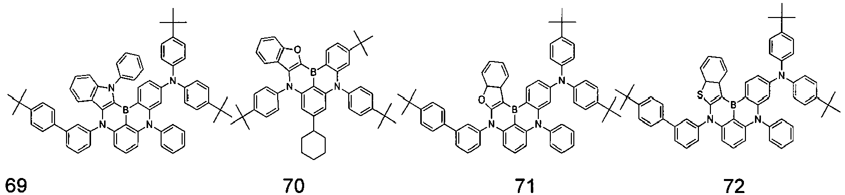

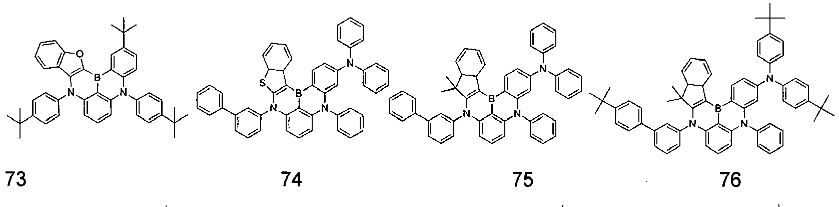

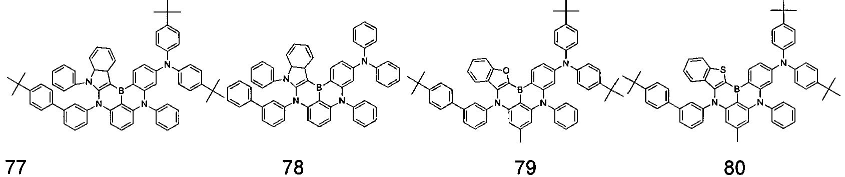

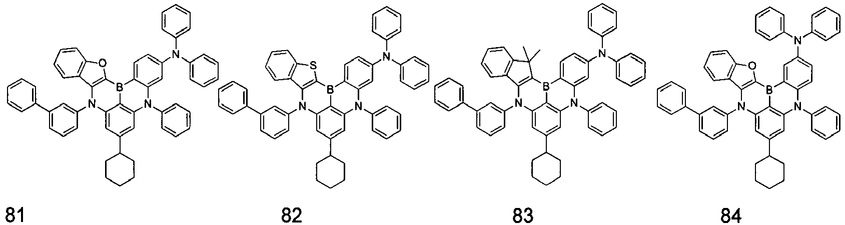

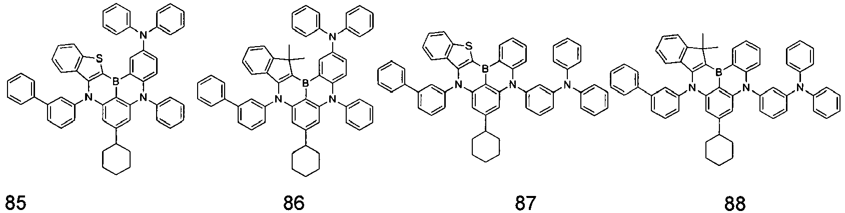

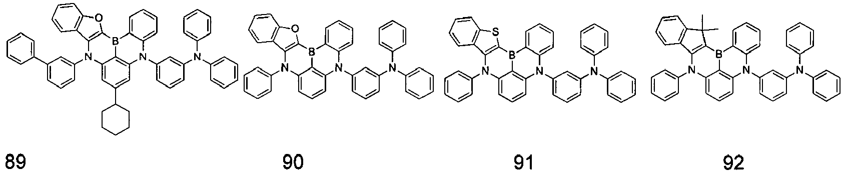

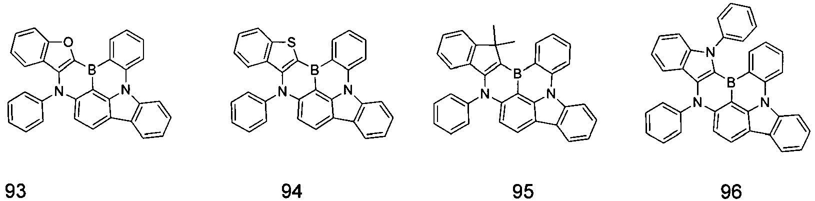

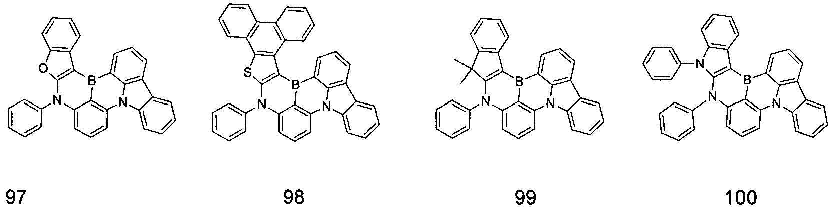

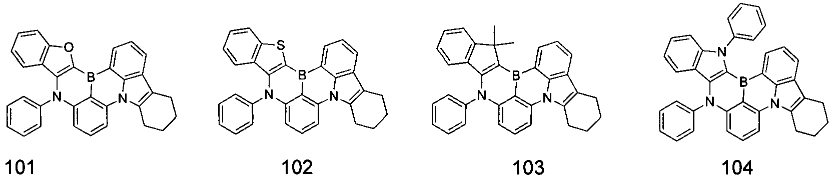

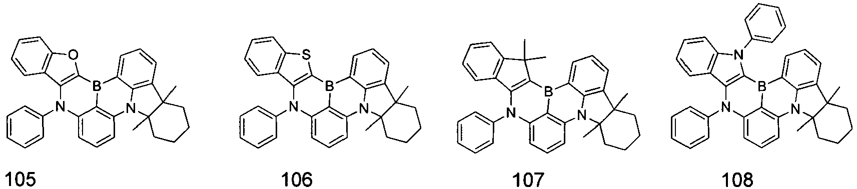

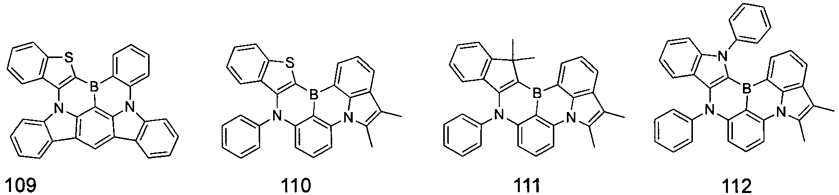

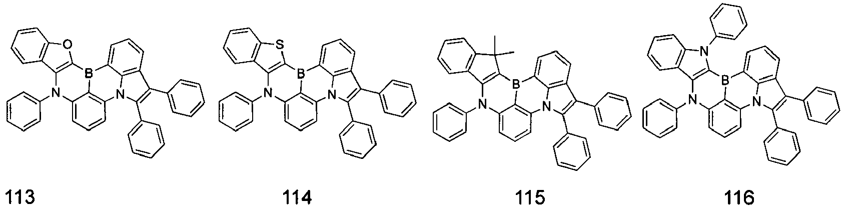

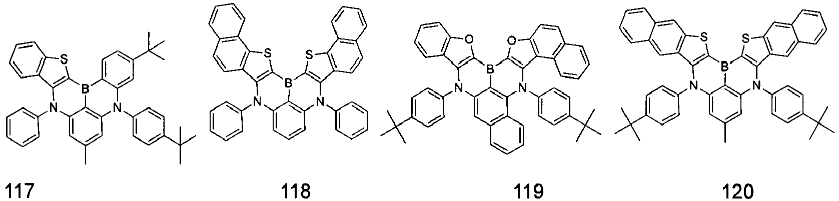

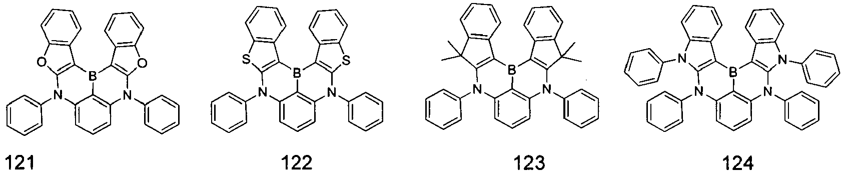

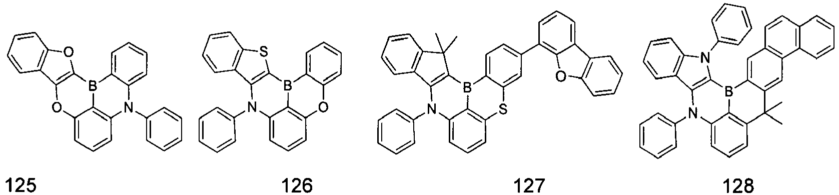

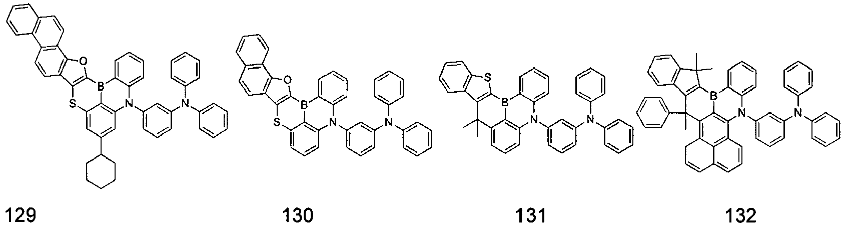

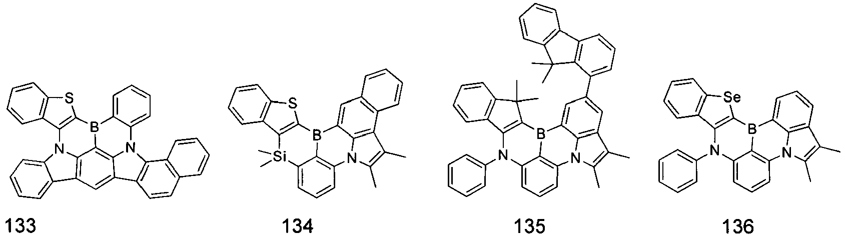

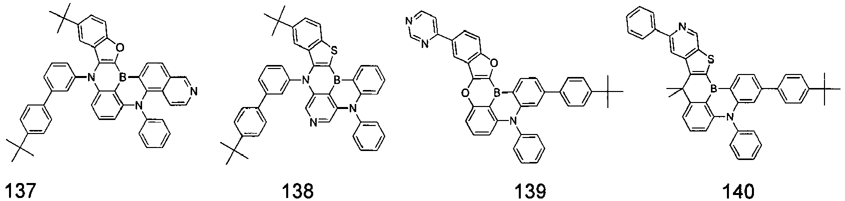

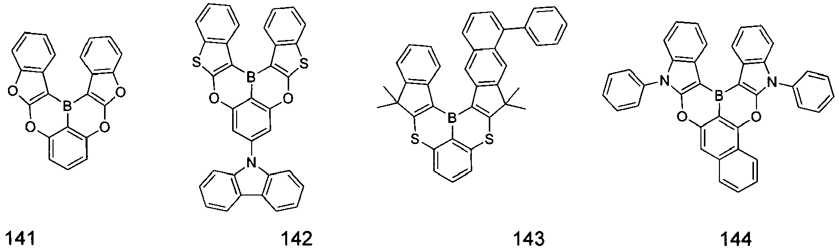

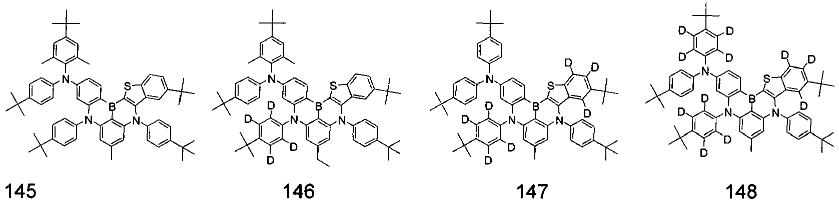

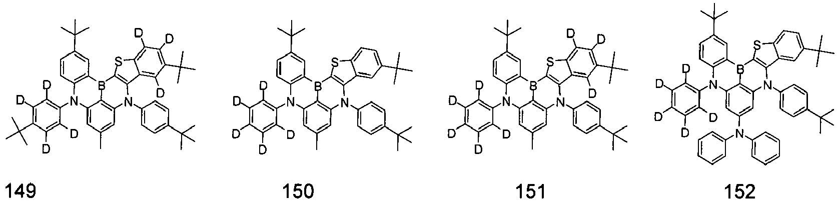

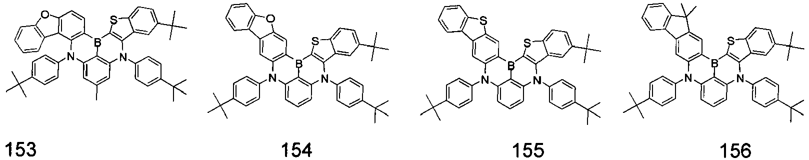

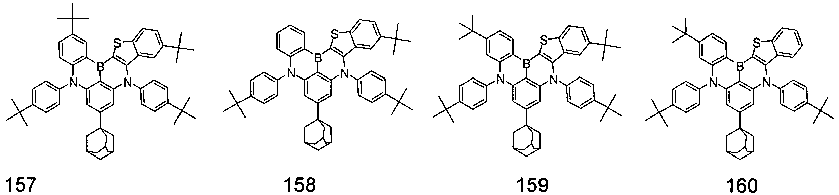

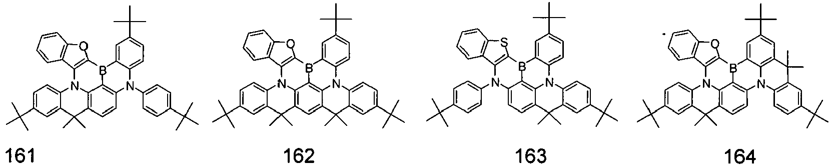

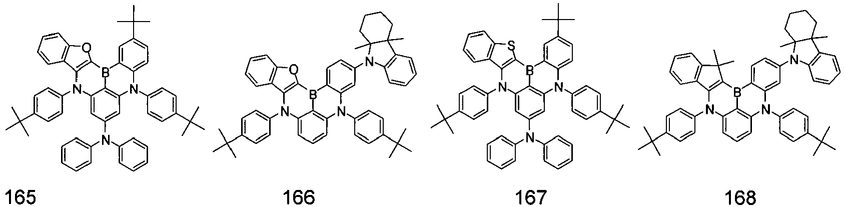

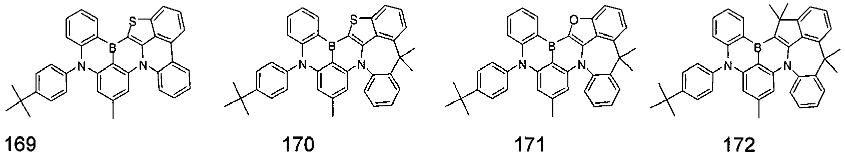

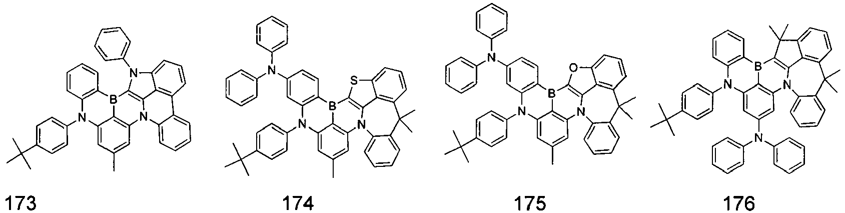

3. An organic electroluminescent device comprising a first electrode, a second electrode opposite to the first electrode, and one or more organic layers interposed between the first and second electrodes **characterized in that** at least one of the organic layers comprises the organic electroluminescent compound according to claim 1 or 2 and optionally another organic electroluminescent compound according to claim 1 or 2.

4. The organic electroluminescent device according to claim 3, **characterized in that** the organic layers comprise an electron injecting layer, an electron transport layer, a hole injecting layer, a hole transport layer, an electron blocking layer, a hole blocking layer, and a light emitting layer, and at least one of the organic layers comprises the organic electroluminescent compound according to claim 1 or 2.

5. The organic electroluminescent device according to claim 4, **characterized in that** the light emitting layer comprises, as a host compound, an anthracene derivative represented by Formula C: 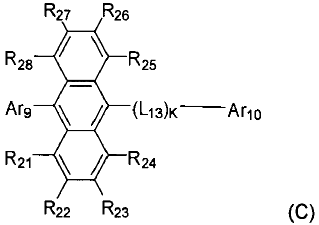 wherein R₂₁ to R₂₈ are identical to or different from each other and are as defined for R₁ to R₄ in Formula A-3, A-4, A-5 or A-6 representing the organic electroluminescent compound according to claim 1, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, and k is an integer from 1 to 3, provided that when k is 2 or more, the linkers L₁₃ are identical to or different from each other.

6. The organic electroluminescent device according to claim 5, **characterized in that** Ar₉ in Formula C is represented by Formula C-1: 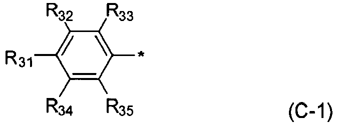 wherein R₃₁ to R₃₅ are identical to or different from each other and are as defined for R₁ to R₄ in Formula A-3, A-4, A-5 or A-6 representing the organic electroluminescent compound according to claim 1 and each of R₃₁ to R₃₅ is optionally bonded to an adjacent substituent to form a saturated or unsaturated ring.

7. The organic electroluminescent device according to claim 5 or 6, **characterized in that** L₁₃ in Formula C is a single bond or is substituted or unsubstituted C₆-C₂₀ arylene.

8. The organic electroluminescent device according to claim 5, **characterized in that** the compound of Formula C is selected from the compounds of Formulae C1 to C48:

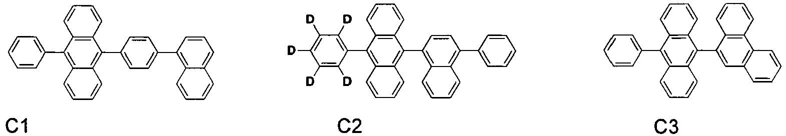

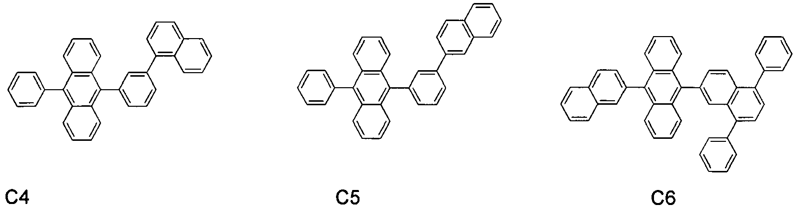

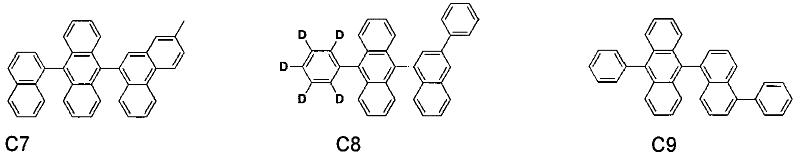

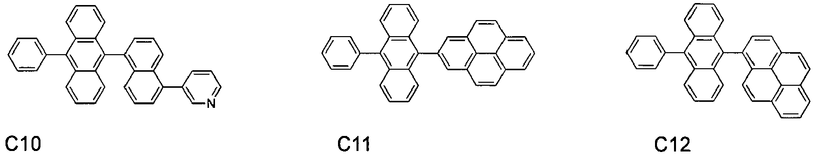

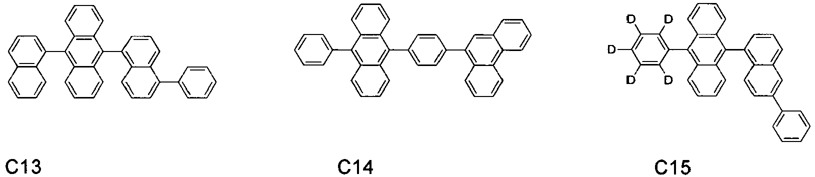

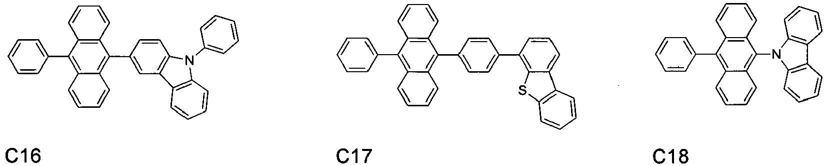

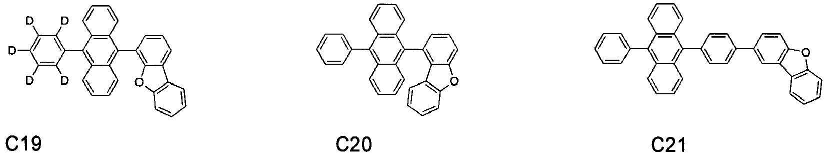

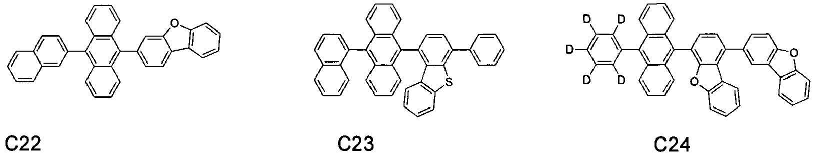

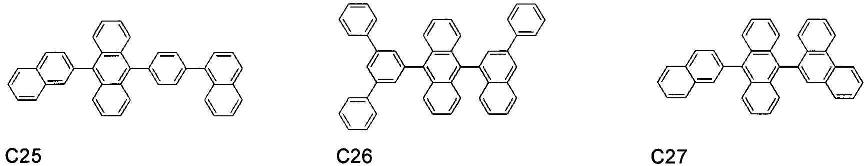

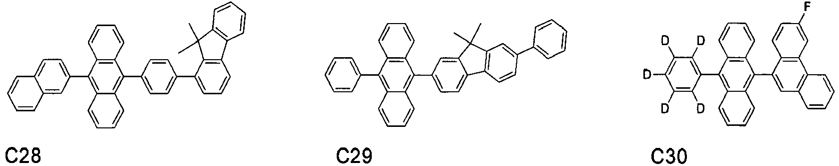

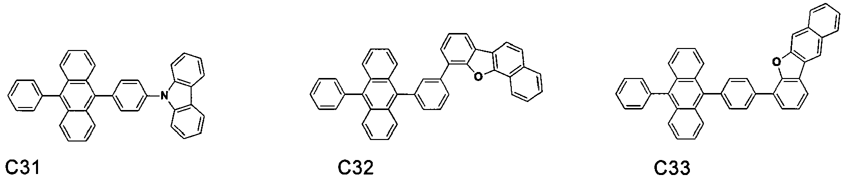

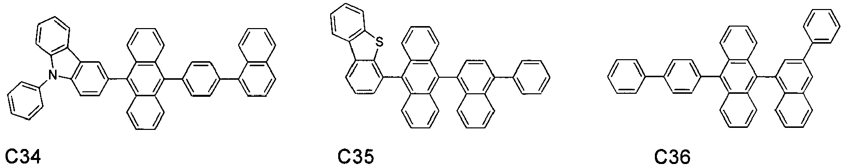

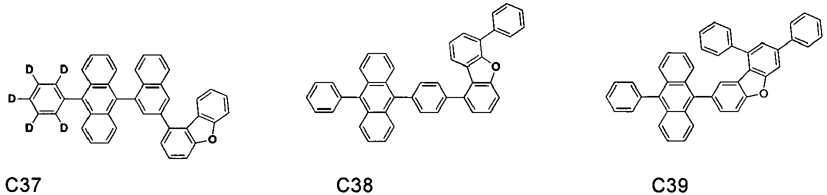

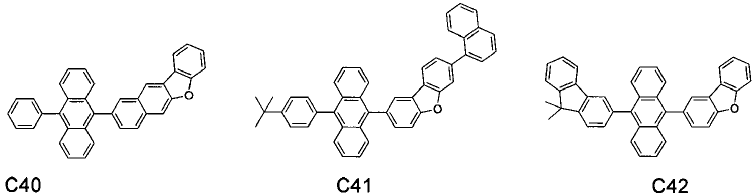

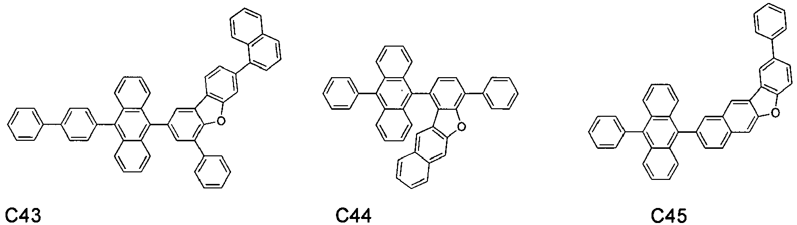

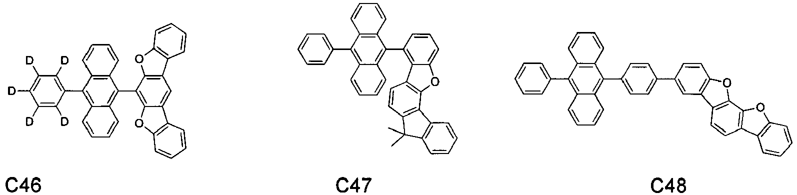

9. The organic electroluminescent device according to any one of claims 4 to 8, **characterized in that** each of the hole transport layer and the electron blocking layer comprises a compound represented by Formula D: 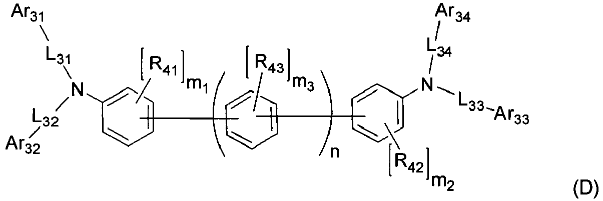 wherein R₄₁ to R₄₃ are identical to or different from each other and are each independently selected from hydrogen, deuterium, substituted or unsubstituted C₁-C₂₀ alkyl, substituted or unsubstituted C₆-C₅₀ aryl, substituted or unsubstituted C₇-C₅₀ arylalkyl, substituted or unsubstituted C₃-C₃₀ cycloalkyl, substituted or unsubstituted C₁-C₃₀ alkylsilyl, substituted or unsubstituted C₆-C₃₀ arylsilyl, and halogen, L₃₁ to L₃₄ are identical to or different from each other and are each independently single bonds or selected from substituted or unsubstituted C₆-C₅₀ arylene and substituted or unsubstituted C₂-C₅₀ heteroarylene, Ar₃₁ to Ar₃₄ are identical to or different from each other and are each independently selected from substituted or unsubstituted C₆-C₅₀ aryl and substituted or unsubstituted C₂-C₅₀ heteroaryl, n is an integer from 0 to 4, provided that when n is 2 or greater, the aromatic rings containing R₄₃ are identical to or different from each other, m₁ to m₃ are integers from 0 to 4, provided that when both m₁ and m₃ are 2 or more, the R₄₁, R₄₂, and R₄₃ groups are identical to or different from each other, and hydrogen or deuterium atoms are bonded to the carbon atoms of the aromatic rings to which R₄₁ to R₄₃ are not attached.

10. The organic electroluminescent device according to claim 9, **characterized in that** at least one of Ar₃₁ to Ar₃₄ in Formula D is represented by Formula E: 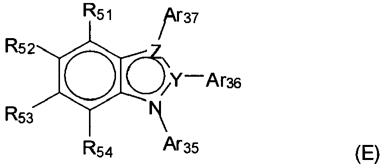 wherein R₅₁ to R₅₄ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, which are optionally linked to each other to form a ring, Y is a carbon or nitrogen atom, Z is a carbon, oxygen, sulfur or nitrogen atom, Ar₃₅ to Ar₃₇ are identical to or different from each other and are each independently selected from substituted or unsubstituted C₆-C₅₀ aryl and substituted or unsubstituted C₃-C₅₀ heteroaryl, provided that when Z is an oxygen or sulfur atom, Ar₃₇ is nothing, provided that when Y and Z are nitrogen atoms, only one of Ar₃₅, Ar₃₆, and Ar₃₇ is present, provided that when Y is a nitrogen atom and Z is a carbon atom, Ar₃₆ is nothing, with the proviso that one of R₅₁ to R₅₄ and Ar₃₅ to Ar₃₇ is a single bond linked to one of the linkers L₃₁ to L₃₄ in Formula D.

11. The organic electroluminescent device according to claim 9, **characterized in that** the compound of Formula D is selected from the compounds of Formulae D1 to D79:

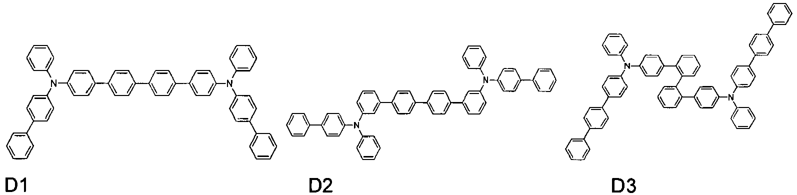

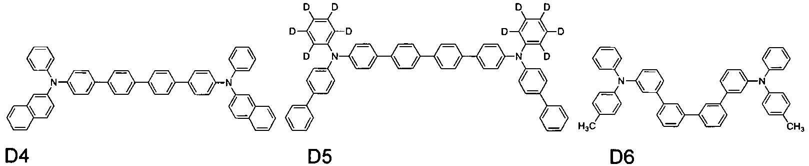

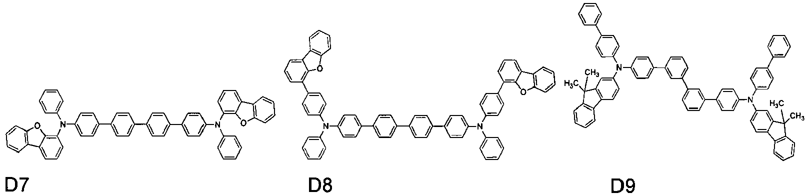

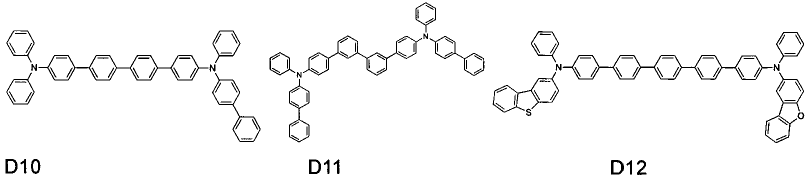

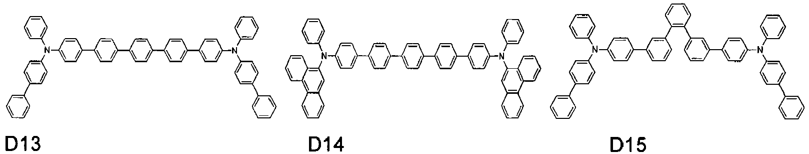

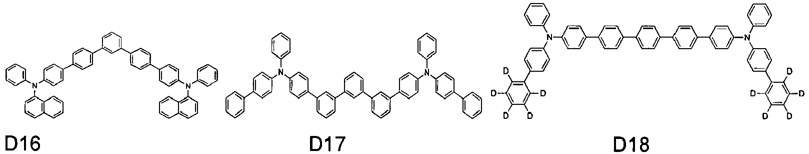

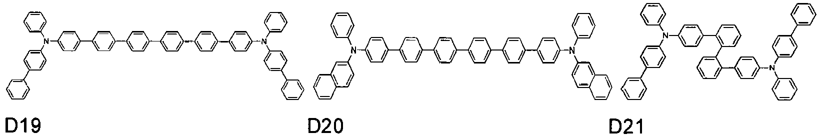

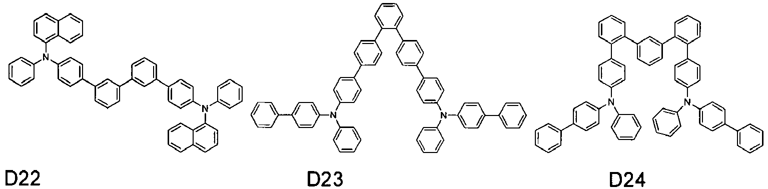

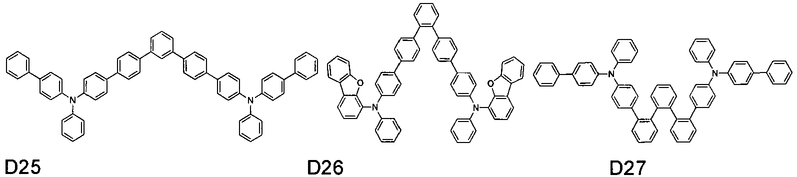

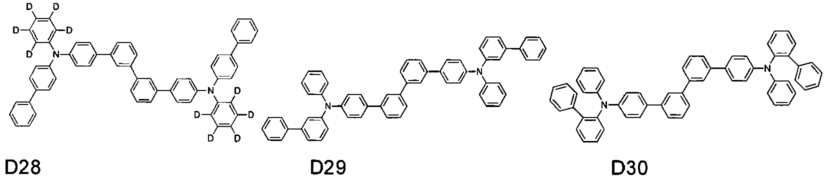

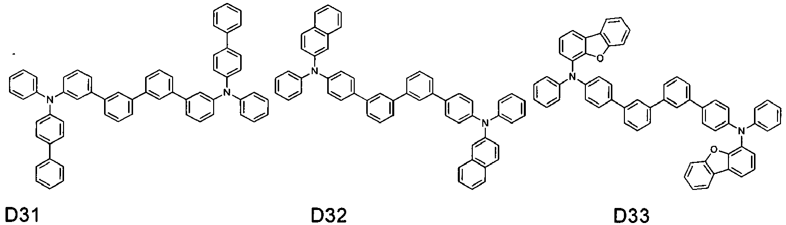

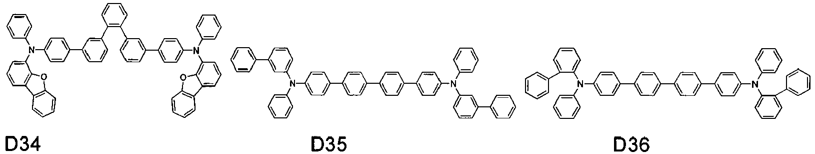

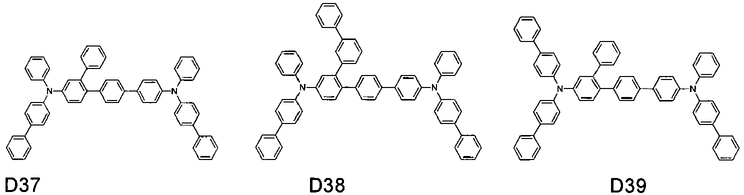

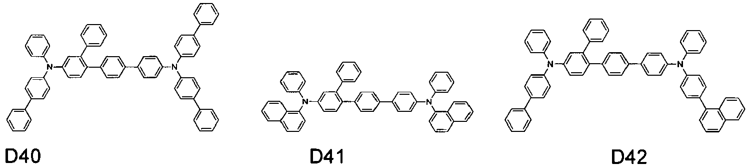

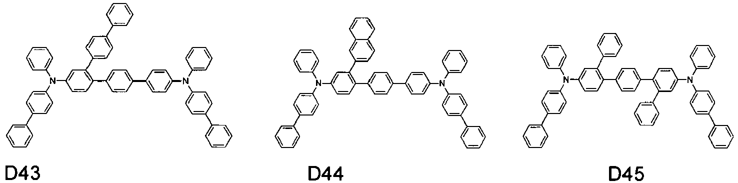

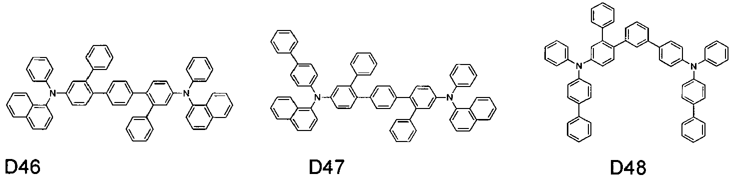

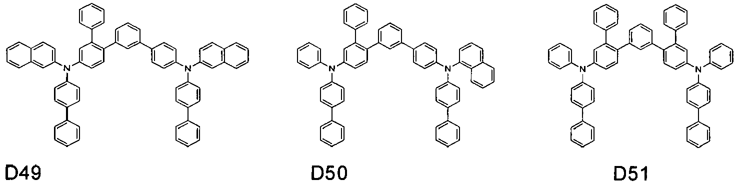

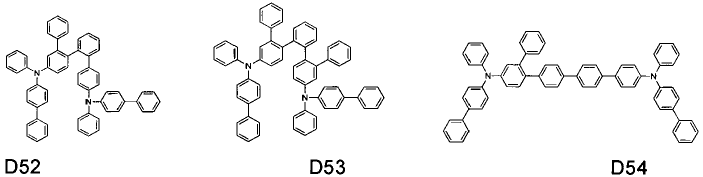

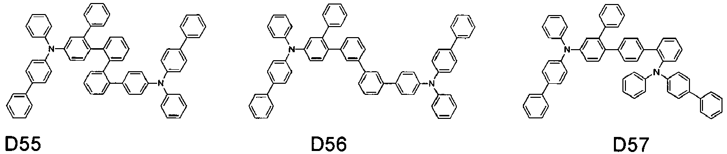

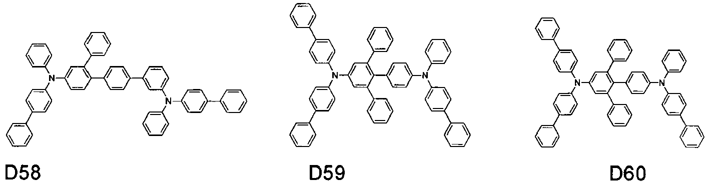

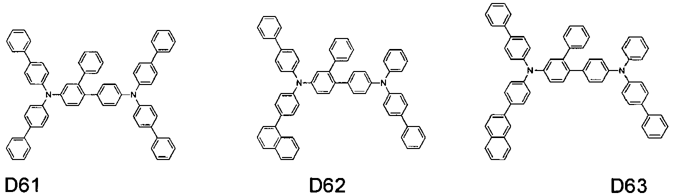

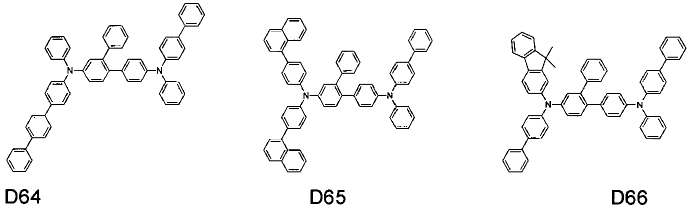

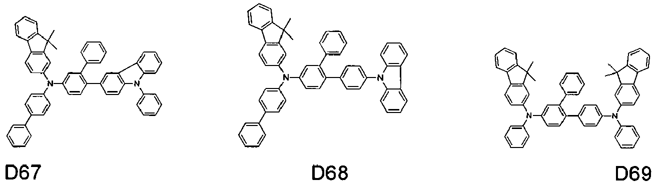

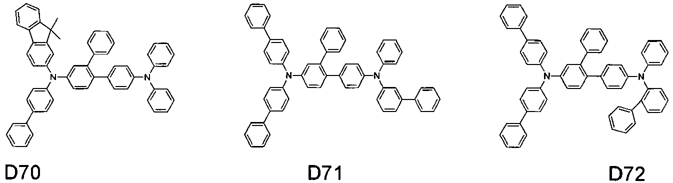

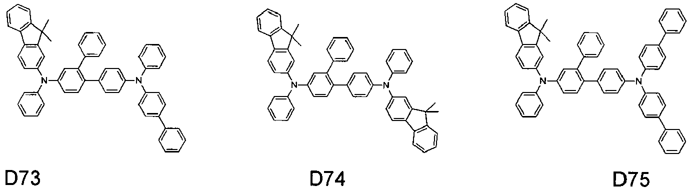

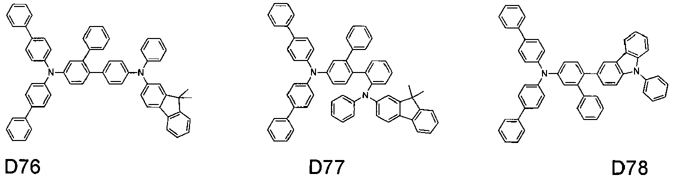

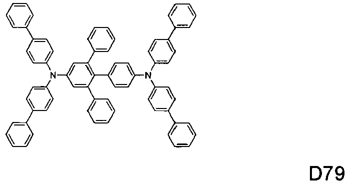

12. The organic electroluminescent device according to claim 9, **characterized in that** the compound of Formula D is selected from the compounds of Formulae D101 to D145:

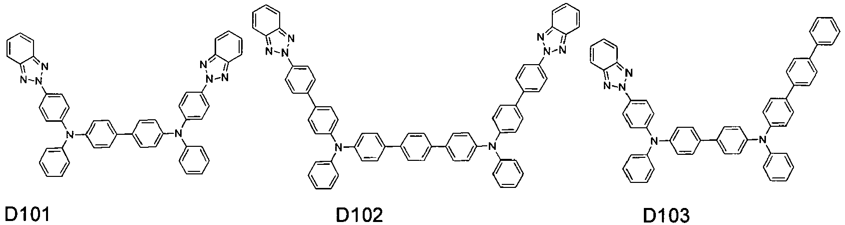

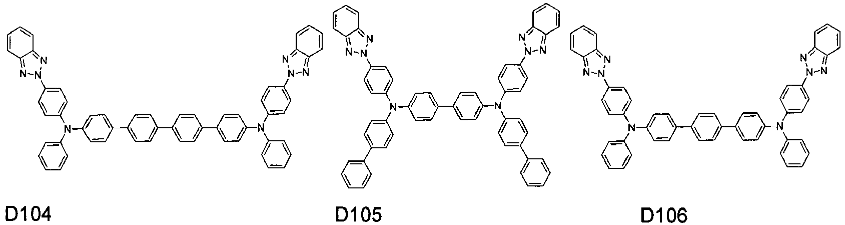

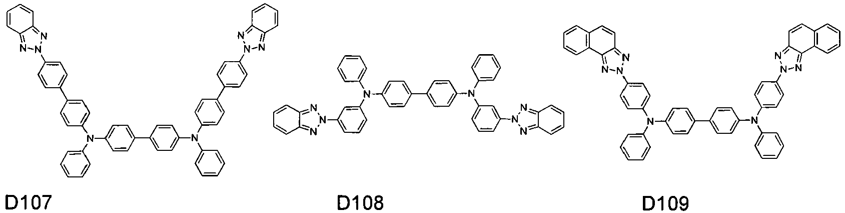

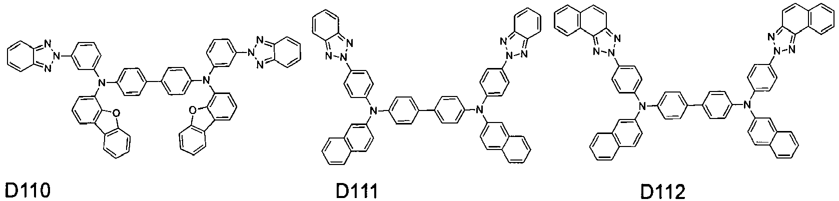

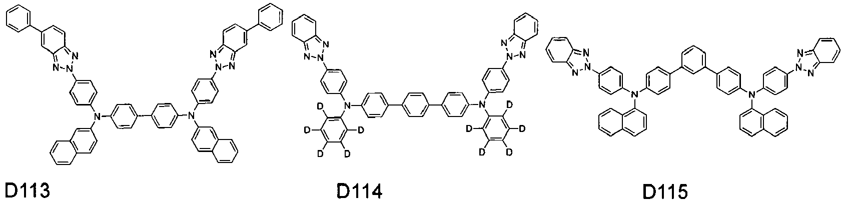

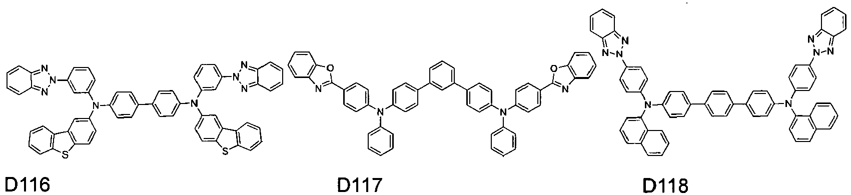

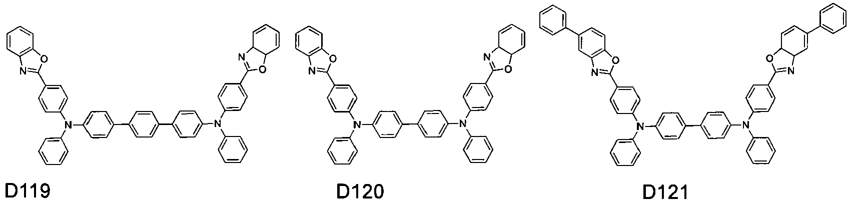

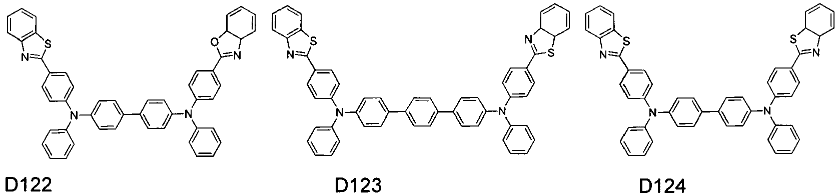

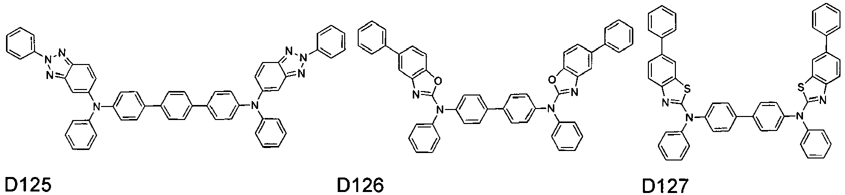

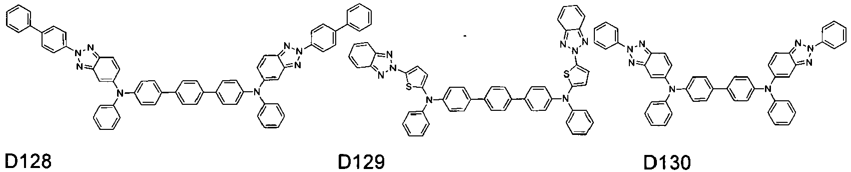

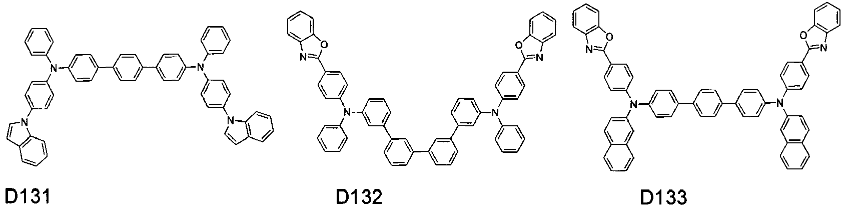

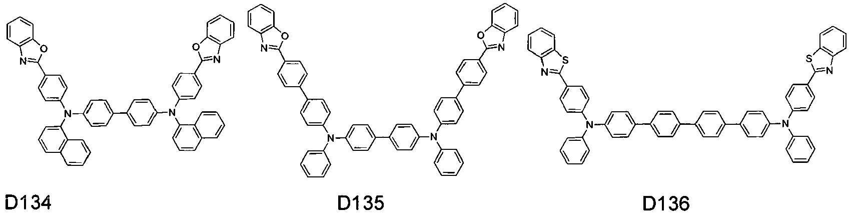

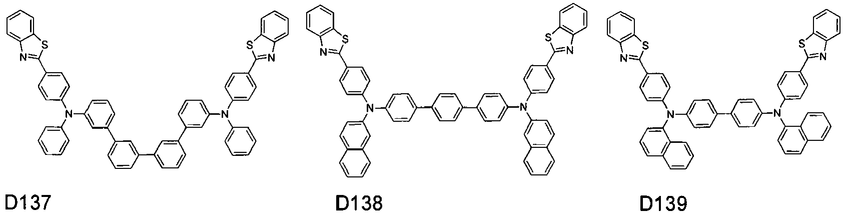

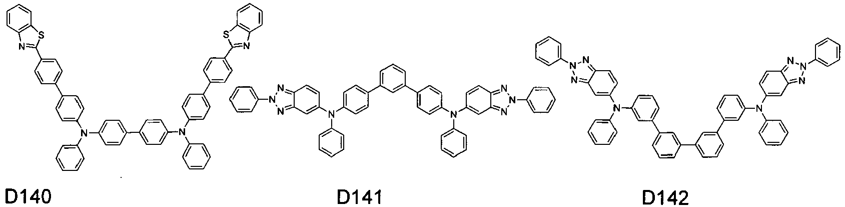

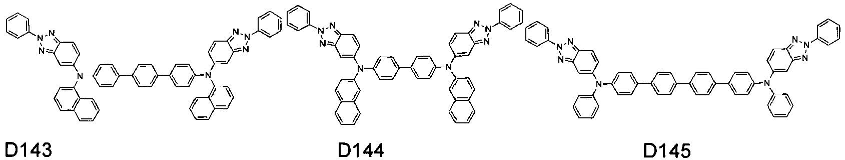

13. The organic electroluminescent device according to any one of claims 4 to 12, **characterized in that** each of the hole transport layer and the electron blocking layer comprises a compound represented by Formula F: 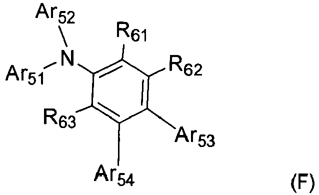 wherein R₆₁ to R₆₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, substituted or unsubstituted C₅-C₃₀ arylsilyl, substituted or unsubstituted C₁-C₃₀ alkylgermanium, substituted or unsubstituted C₁-C₃₀ arylgermanium, cyano, nitro, and halogen, and Ar₅₁ to Ar₅₄ are identical to or different from each other and are each independently substituted or unsubstituted C₆-C₄₀ aryl or substituted or unsubstituted C₂-C₃₀ heteroaryl.

14. The organic electroluminescent device according to claim 13, **characterized in that** the compound of Formula F is selected from the compounds of Formulae F1 to F33:

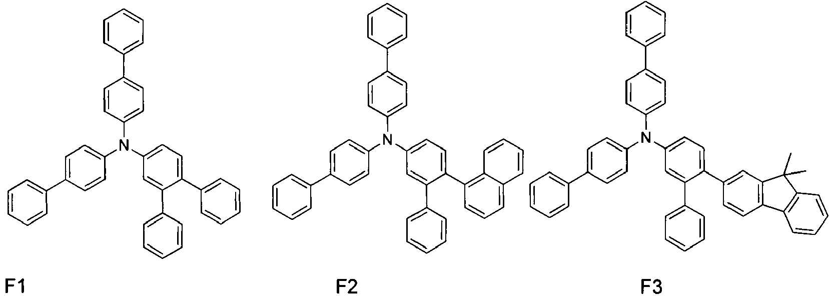

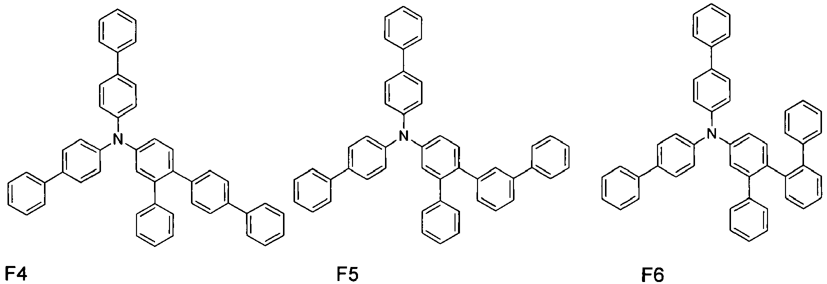

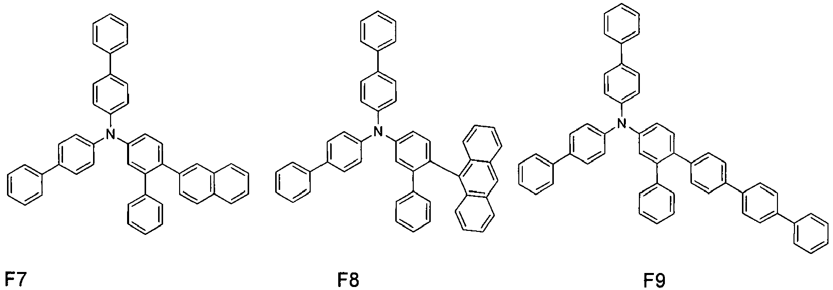

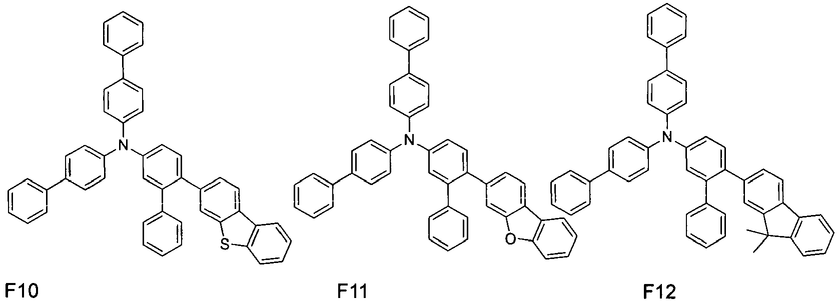

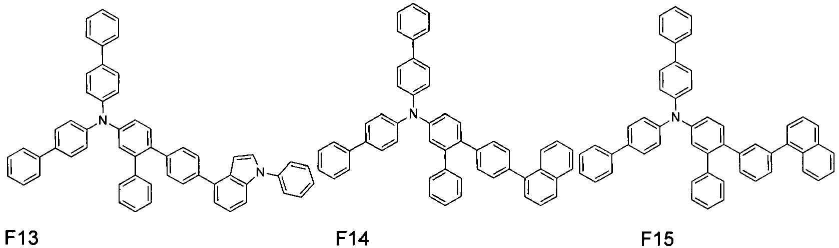

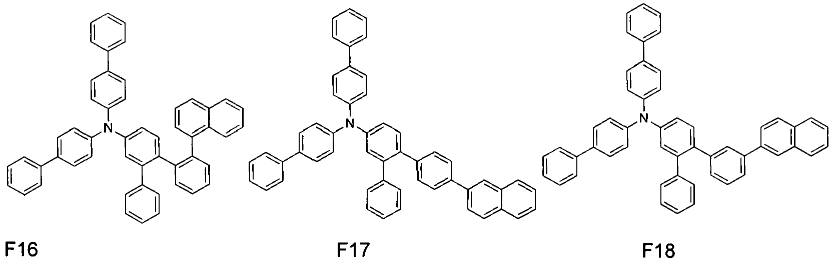

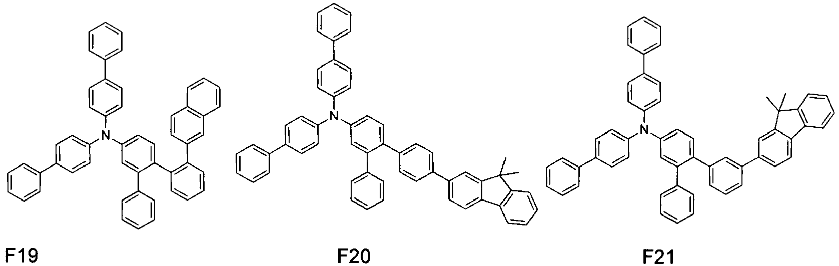

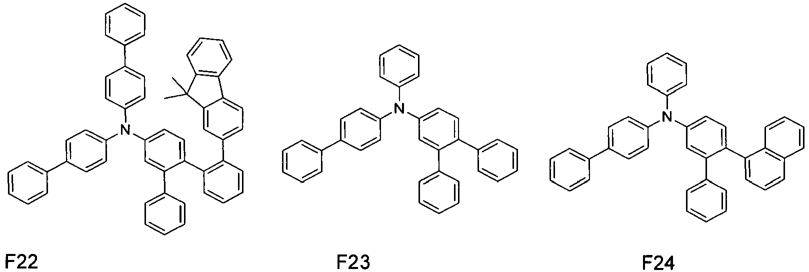

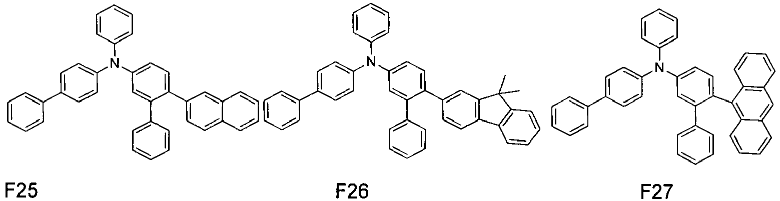

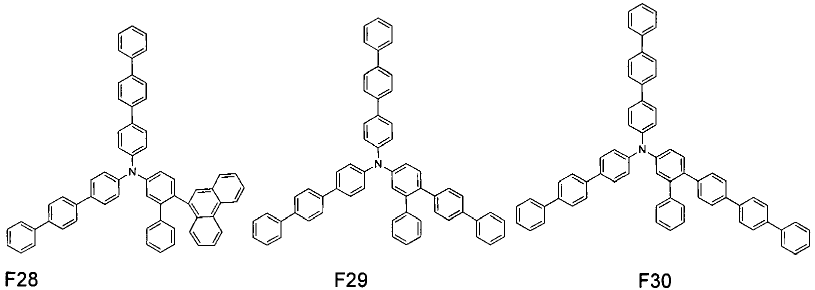

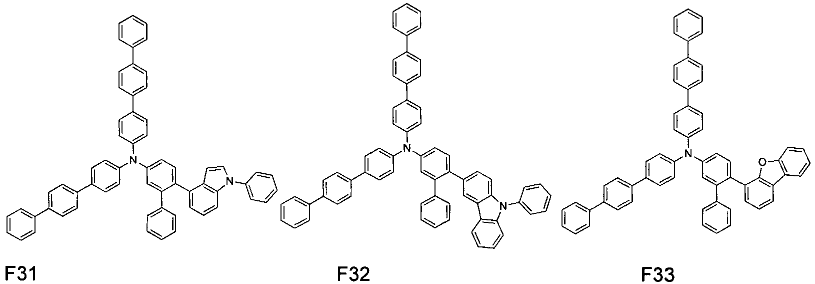

15. The organic electroluminescent device according to any one of claims 4 to 14, **characterized in that** one or more of the layers are formed by a deposition or solution process.

16. The organic electroluminescent device according to any one of claims 3 to 15, wherein the organic electroluminescence device is used in a display or lighting system selected from flat panel displays, flexible displays, monochromatic flat panel lighting systems, white flat panel lighting systems, flexible monochromatic lighting systems, and flexible white lighting systems.

## Patentansprüche

1. Organische elektrolumineszierende Verbindung, repräsentiert durch die Formel A-3, A-4, A-5 oder A-6: 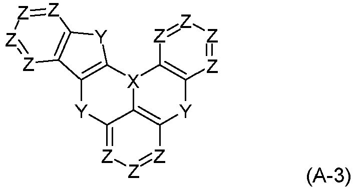 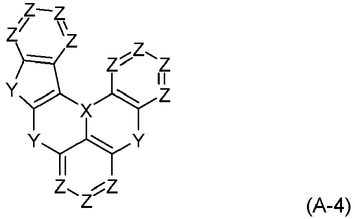 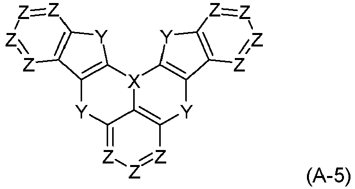 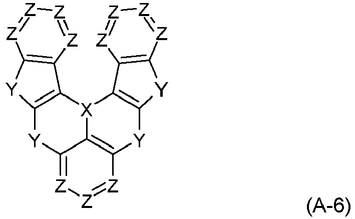 wobei die Verbindungsglieder Y identisch oder verschieden voneinander sind und jeweils unabhängig voneinander ausgewählt sind aus N-R₁, CR₂R₃, O, S, Se, und SiR₄R₅, X gleich B ist, und R₁ bis R₅ identisch oder voneinander verschieden sind und jeweils unabhängig ausgewählt sind aus Wasserstoff, Deuterium, substituiertem oder unsubstituiertem C₁-C₃₀ Akyl, substituiertem oder unsubstituiertem C₆-C₅₀ Aryl, substituiertem oder unsubstituiertem C₃-C₃₀ Cycloalkyl, substituiertem oder unsubstituiertem C₂-C₅₀ Heteroaryl, substituiertem oder unsubstituiertem C₁-C₃₀ Alkoxy, substituiertem oder unsubstituiertem C₆-C₃₀ Aryloxy, substituiertem oder unsubstituiertem C₁-C₃₀ Alkylthioxy, substituiertem oder unsubstituiertem C₅-C₃₀ Arylthioxy, substituiertem oder unsubstituiertem C₁-C₃₀ Alkylamin, substituiertem oder unsubstituiertem C₅-C₃₀ Arylamin, substituiertem oder unsubstituiertem C₁-C₃₀ Alkylsilyl, substituiertem oder unsubstituiertem C₅-C₃₀ Arylsilyl, Nitro, Cyano und Halogen, mit der Maßgabe, dass R₂ und R₃ optional miteinander verbunden sind, um einen alicyclischen oder aromatischen monocyclischen oder polycyclischen Ring zu bilden, und dass R₃ und R₄ optional miteinander verbunden sind, um einen alicyclischen oder aromatischen monocyclischen oder polycyclischen Ring zu bilden, jedes Z unabhängig voneinander CR oder N ist, die Substituenten R identisch oder voneinander verschieden sind und unabhängig voneinander ausgewählt sind aus Wasserstoff, Deuterium, substituiertem oder unsubstituiertem C₁-C₃₀ Alkyl, substituiertem oder unsubstituiertem C₆-C₅₀ Aryl, substituiertem oder unsubstituiertem C₃-C₃₀ Cycloalkyl, substituiertem oder unsubstituiertem C₂-C₅₀ Heteroaryl, substituiertem oder unsubstituiertem C₁-C₃₀ Alkoxy, substituiertem oder unsubstituiertem C₆-C₃₀ Aryloxy, substituiertem oder unsubstituiertem C₁-C₃₀ Alkylthioxy, substituiertem oder unsubstituiertem C₅-C₃₀ Arylthioxy, substituiertem oder unsubstituiertem C₁-C₃₀ Alkylamin, substituiertem oder unsubstituiertem C₅-C₃₀ Arylamin, substituiertem oder unsubstituiertem C₁-C₃₀ Alkylsilyl, substituiertem oder unsubstituiertem C₅-C₃₀ Arylsilyl, Nitro, Cyano und Halogen, mit der Maßgabe, dass die Substituenten R gegebenenfalls aneinander gebunden sind oder gegebenenfalls mit anderen benachbarten Substituenten verbunden sind, um alicyclische oder aromatische monocyclische oder polycyclische Ringe zu bilden, deren Kohlenstoffatome gegebenenfalls mit einem oder mehreren Heteroatomen, ausgewählt aus N-, S- und O-Atomen, substituiert sind.

2. Die organische elektrolumineszierende Verbindung nach Anspruch 1, **dadurch gekennzeichnet, dass** die organische elektrolumineszierende Verbindung repräsentiert durch die Formel A-3, A-4, A-5 oderA-6 aus den folgenden Verbindungen ausgewählt wird:

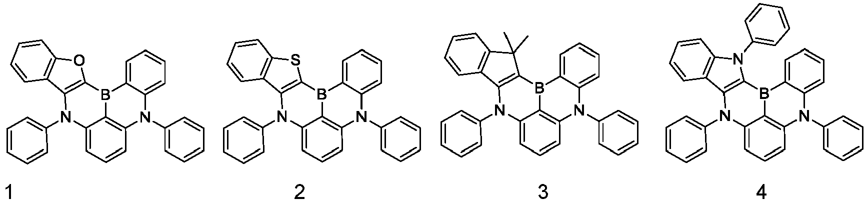

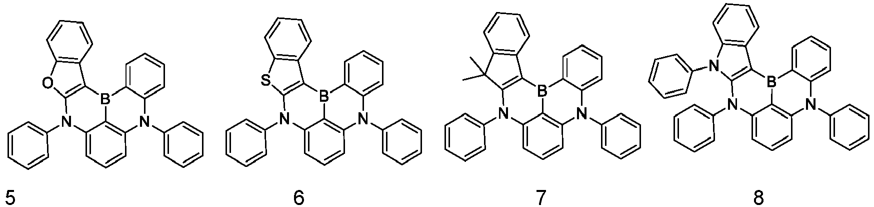

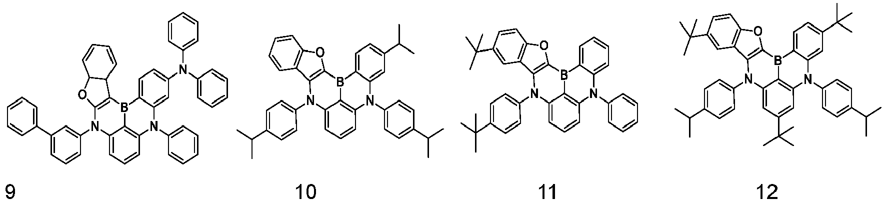

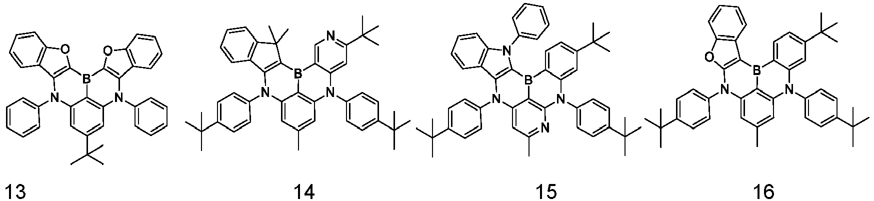

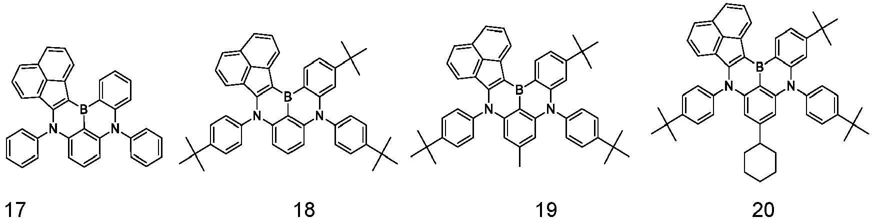

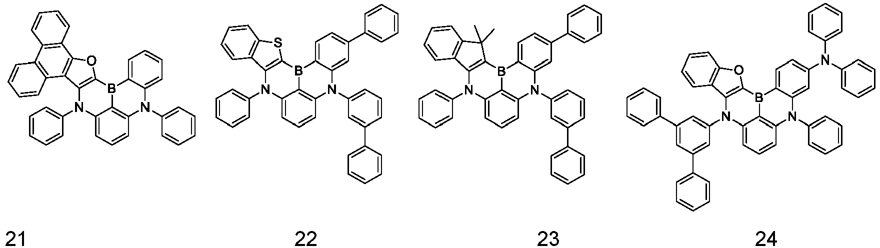

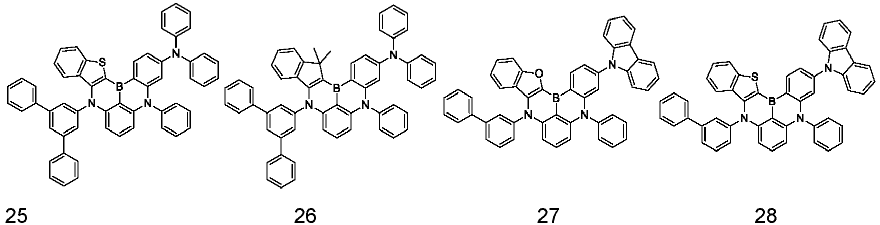

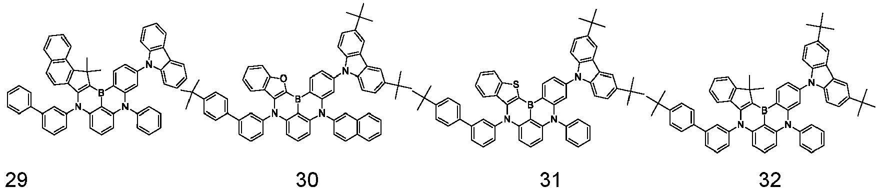

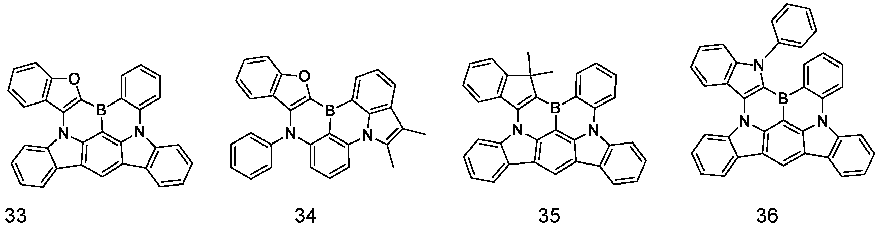

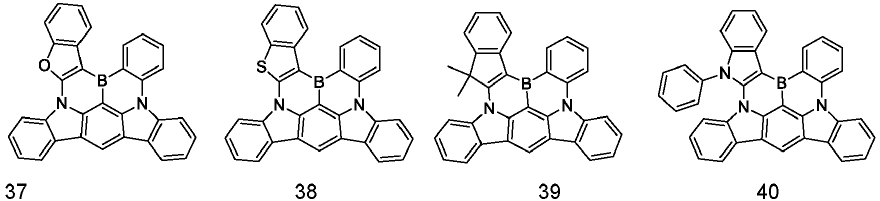

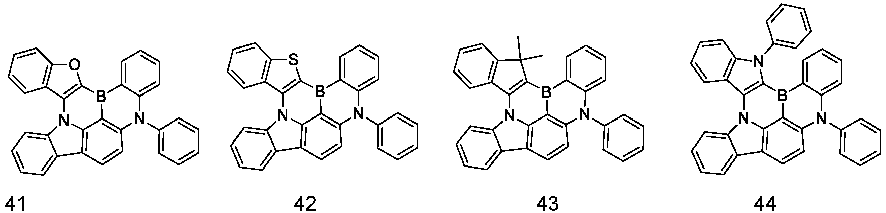

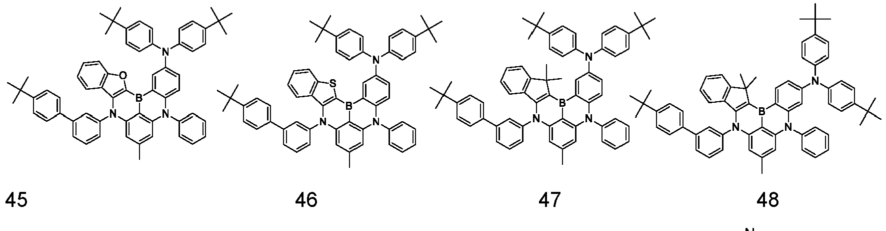

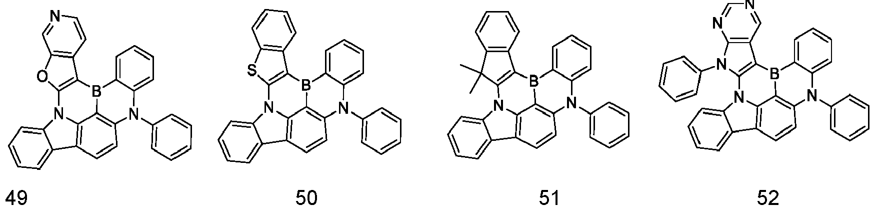

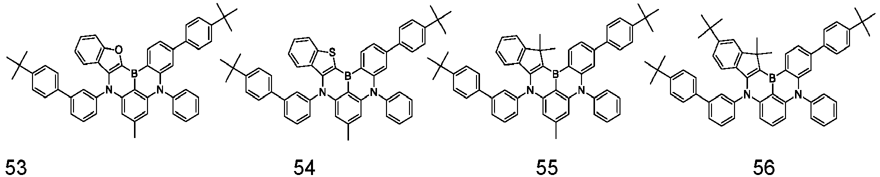

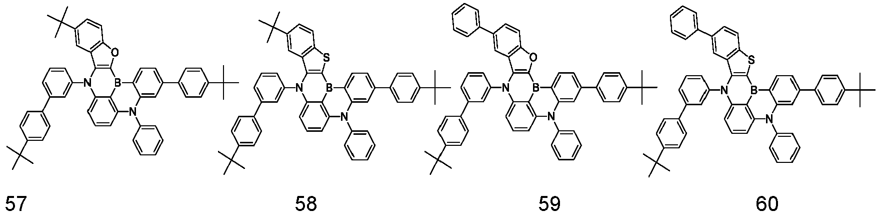

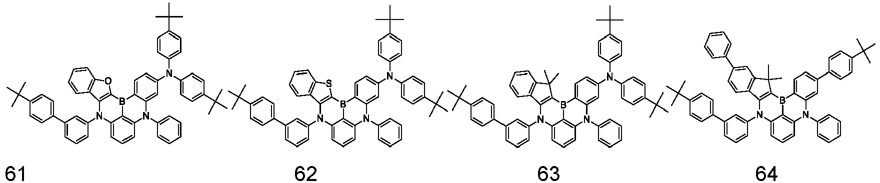

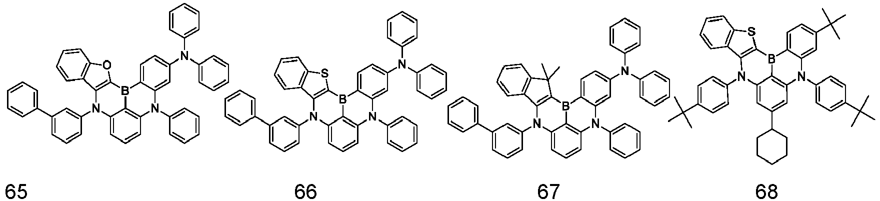

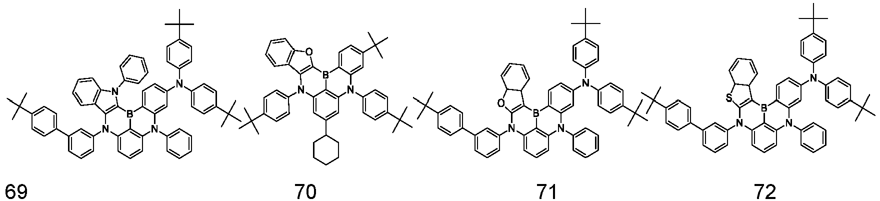

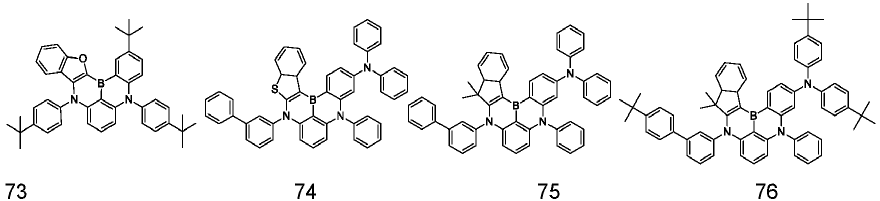

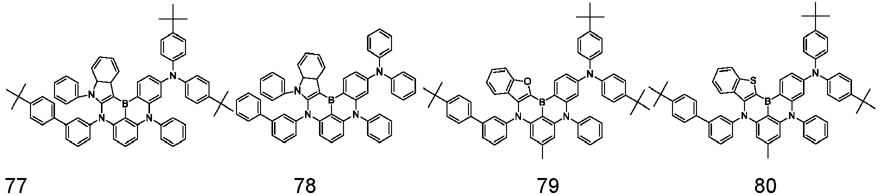

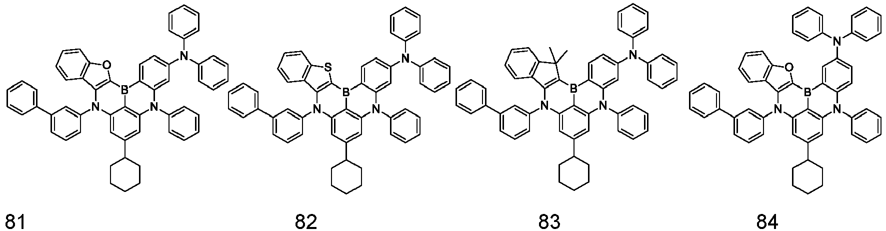

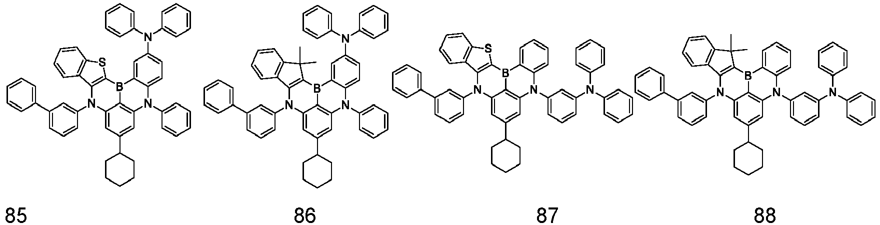

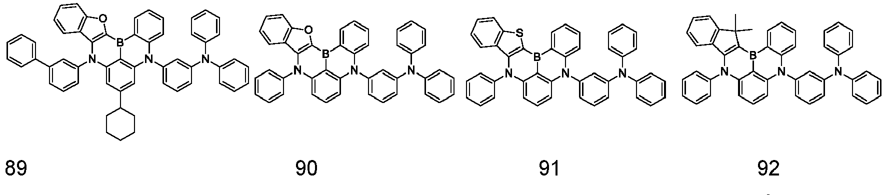

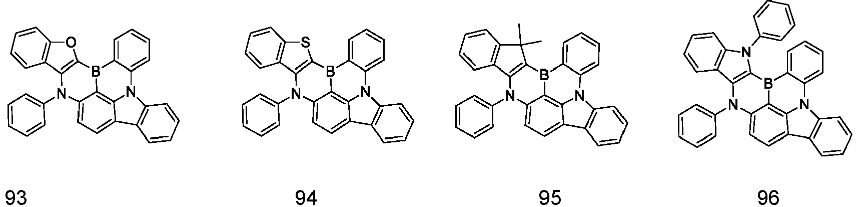

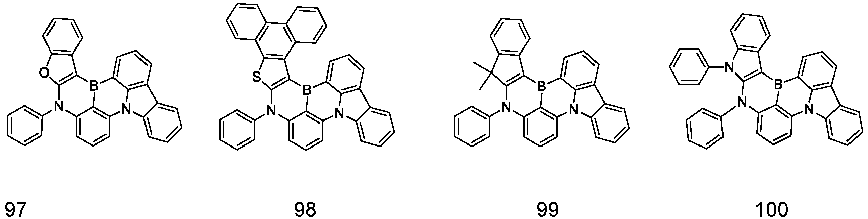

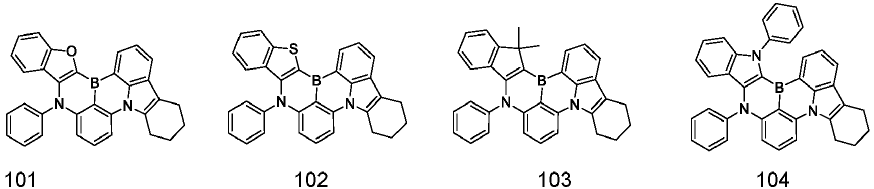

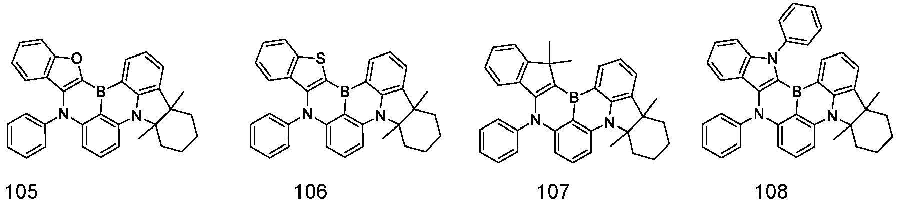

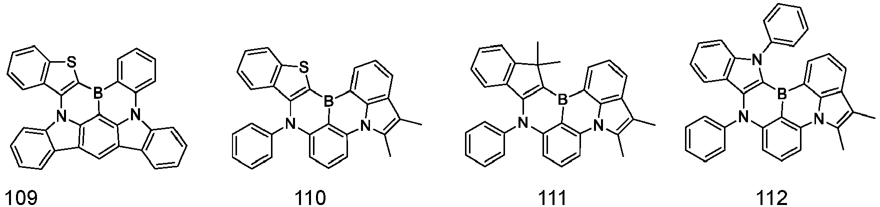

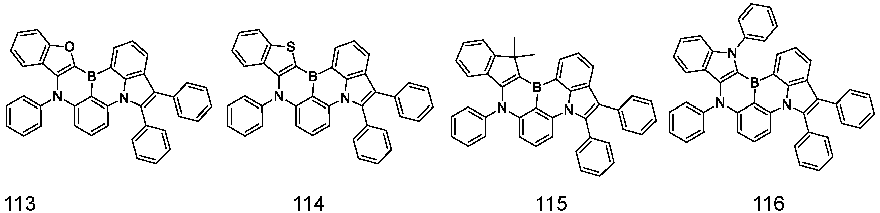

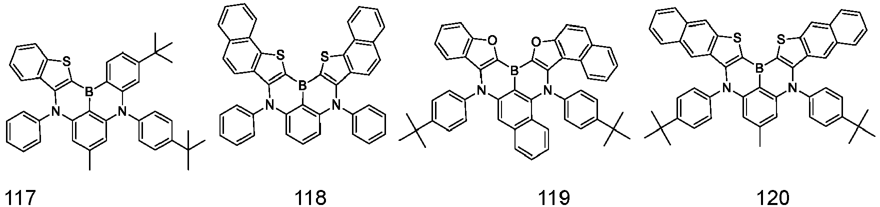

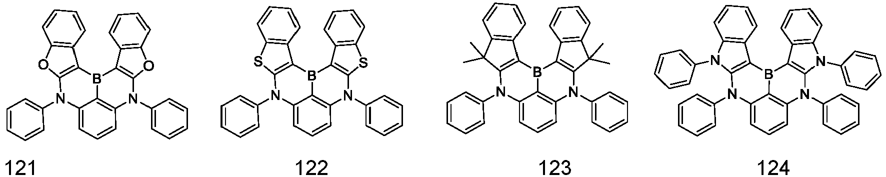

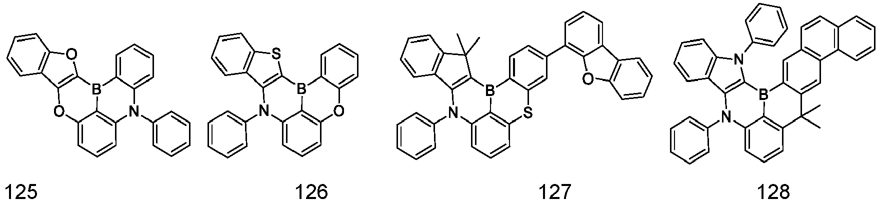

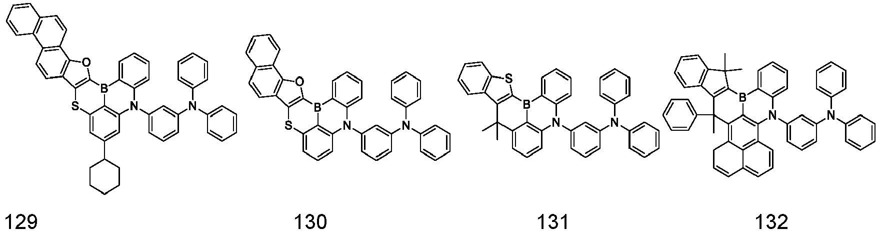

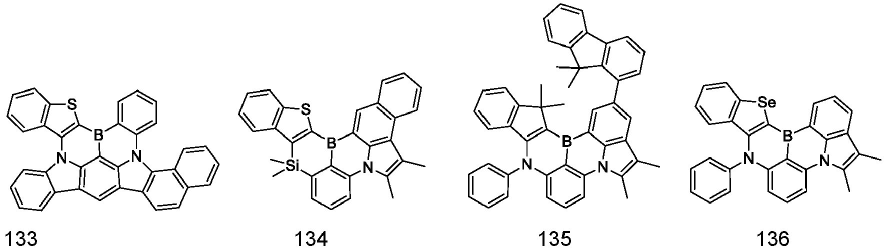

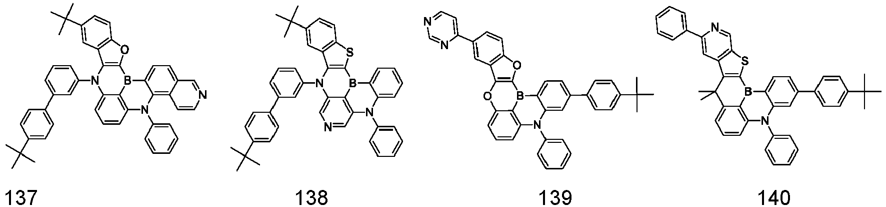

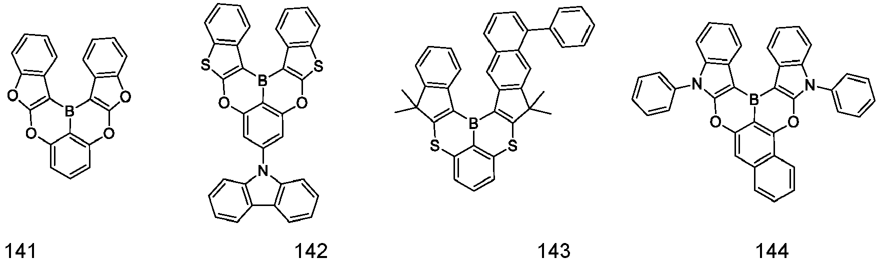

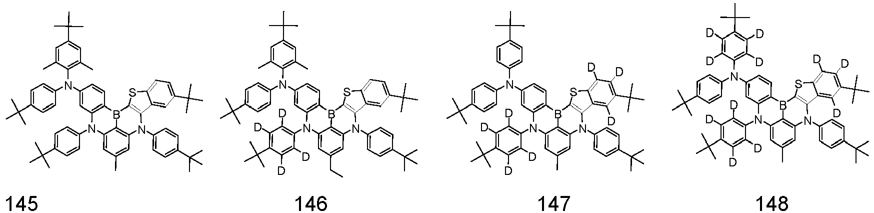

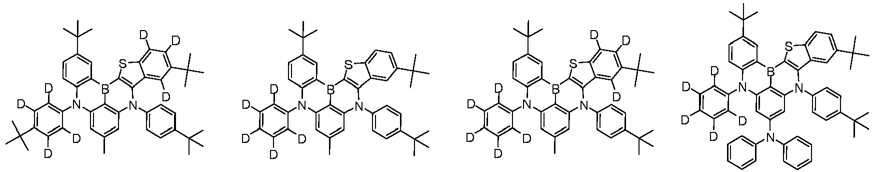

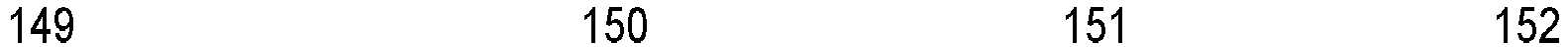

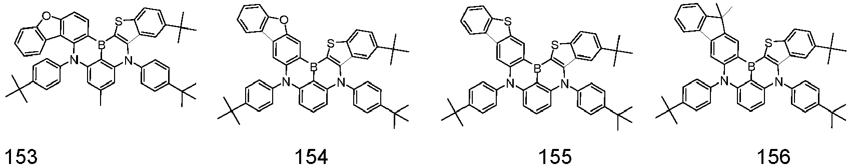

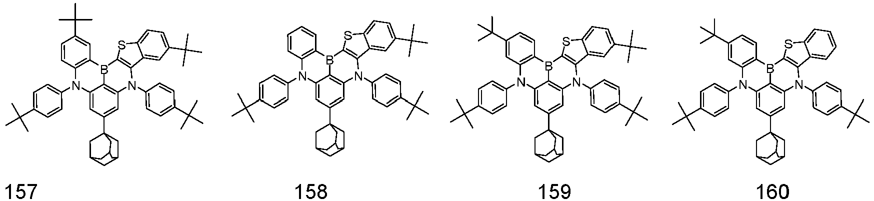

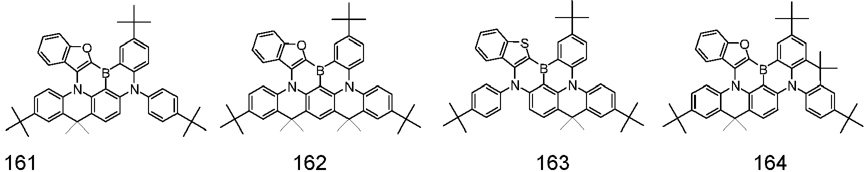

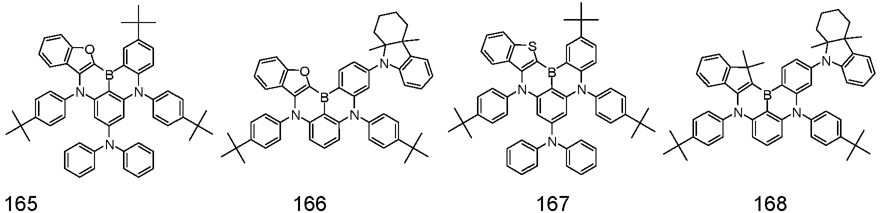

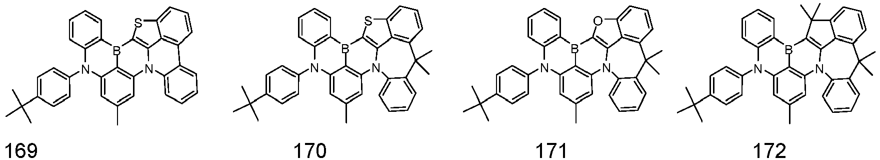

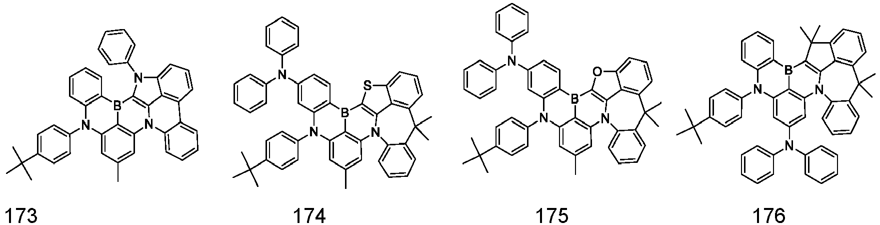

3. Eine organisch elektrolumineszierende Vorrichtung umfassend eine erste Elektrode, eine zweite Elektrode, die der ersten Elektrode gegenüberliegt, und eine oder mehrere organische Schichten, die zwischen der ersten und der zweiten Elektrode angeordnet sind, **dadurch gekennzeichnet, dass** mindestens eine der organischen Schichten die organische elektrolumineszierende Verbindung nach Anspruch 1 oder 2 umfasst und optional eine weitere organische elektrolumineszierende Verbindung nach Anspruch 1 oder 2.

4. Die organisch elektrolumineszierende Vorrichtung nach Anspruch 3, **dadurch gekennzeichnet, dass** die organischen Schichten eine Elektroneninjektionsschicht, eine Elektronentransportschicht, eine Lochinjektionsschicht, eine Lochtransportschicht, eine Elektronensperrschicht, eine Lochsperrschicht und eine lichtemittierende Schicht umfassen, und dass mindestens eine der organischen Schichten die organische elektrolumineszierende Verbindung nach Anspruch 1 oder 2 umfasst.

5. Die organisch elektrolumineszierende Vorrichtung nach Anspruch 4, **dadurch gekennzeichnet, dass** die lichtemittierende Schicht als Wirtsverbindung ein Anthracenderivat der Formel C umfasst: 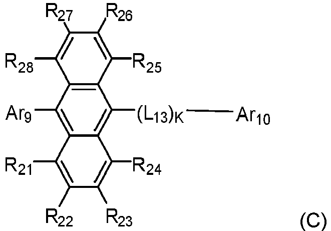 wobei R₂₁ bis R₂₈ identisch oder voneinander verschieden sind und definiert sind wie R₁ bis R₄ in Formel A-3, A-4, A-5 oder A-6 die die organische elektrolumineszierende Verbindung nach Anspruch 1 repräsentieren, Ar₉ und Ar₁₀ identisch oder voneinander verschieden sind und jeweils unabhängig voneinander ausgewählt sind aus Wasserstoff, Deuterium, substituiertem oder unsubstituiertem C₁-C₃₀ Alkyl, substituiertem oder unsubstituiertem C₆-C₅₀ Aryl, substituiertem oder unsubstituiertem C₂-C₃₀ alkenyl, substituiertem oder unsubstituiertem C₂-C₂₀Alkynyl, substituiertem oder unsubstituiertem C₃-C₃₀ Cycloalkyl, substituiertem oder unsubstituiertem C₅-C₃₀ Cycloalkenyl, substituiertem oder unsubstituiertem C₂-C₅₀ Heteroaryl, substituiertem oder unsubstituiertem C₂-C₃₀ Heterocycloalkyl, substituiertem oder unsubstituiertem C₁-C₃₀ Alkoxy, substituiertem oder unsubstituiertem C₆-C₃₀ Aryloxy, substituiertem oder unsubstituiertem C₁-C₃₀ Alkylthioxy, substituiertem oder unsubstituiertem C₆-C₃₀ Arylthioxy, substituiertem oder unsubstituiertem C₁-C₃₀ Alkylamin, substituiertem oder unsubstituiertem C₆-C₃₀ Arylamin, substituiertem oder unsubstituiertem C₁-C₃₀ Alkylsilyl und substituiertem oder unsubstituiertem C₆-C₃₀Arylsilyl, L₁₃ eine Einfachbindung ist oder ausgewählt ist aus substituiertem oder unsubstituiertem C₆-C₂₀ Arylen und substituiertem oder unsubstituiertem C₂-C₂₀ Heteroarylen, und k eine ganze Zahl von 1 bis 3 ist mit der Maßgabe, dass, wenn k 2 oder mehr ist, das Verbindungsglied L₁₃ identisch oder verschieden voneinander sind.

6. Die organisch elektrolumineszierende Vorrichtung nach Anspruch 5, **dadurch gekennzeichnet, dass** Arg in Formel C repräsentiert wird von Formula C-1: 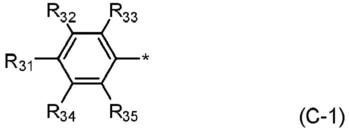 wobei R₃₁ bis R₃₅ identisch oder voneinander verschieden sind und definiert sind wie R₁ bis R₄ in Formel A-3, A-4, A-5 oder A-6 die die organische elektrolumineszierende Verbindung nach Anspruch 1 repräsentieren und R₃₁ bis R₃₅ jeweils optional an einen benachbarten Substituenten gebunden ist, um einen gesättigten oder ungesättigten Ring zu bilden.

7. Die organisch elektrolumineszierende Vorrichtung nach Anspruch 5 oder 6, **dadurch gekennzeichnet, dass** L₁₃ in Formel C eine Einfachbindung oder substituiertes oder unsubstituiertes C₆-C₂₀ Arylen ist.

8. Die organisch elektrolumineszierende Vorrichtung nach Anspruch 5, **dadurch gekennzeichnet, dass** die Verbindung der Formel C ausgewählt ist aus den Verbindungen der Formeln C1 bis C48:

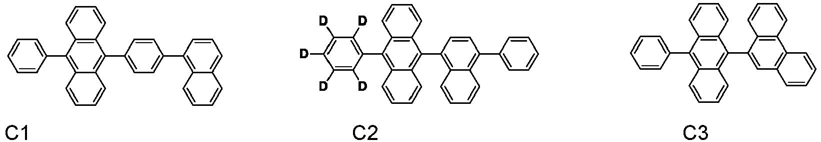

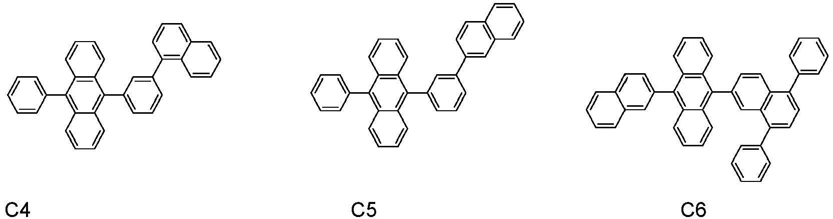

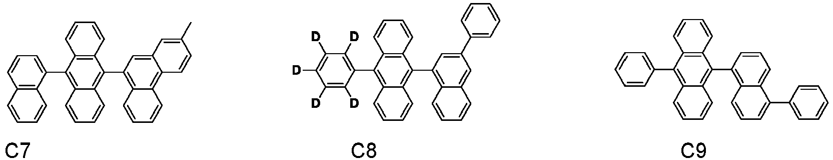

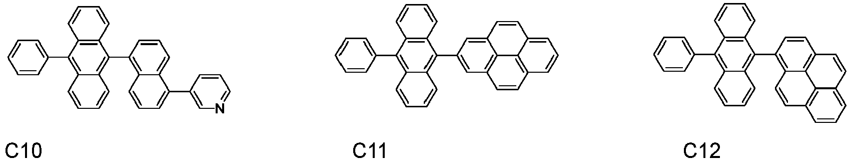

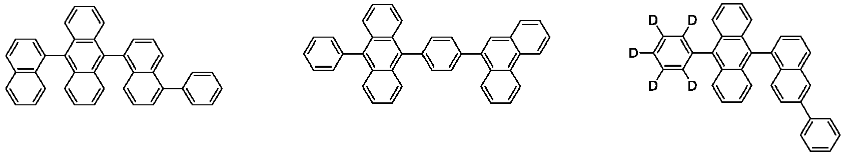

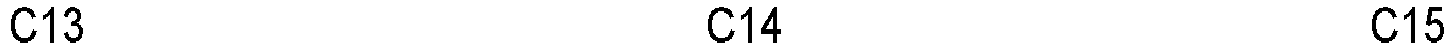

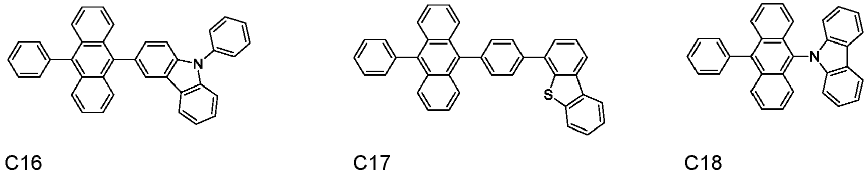

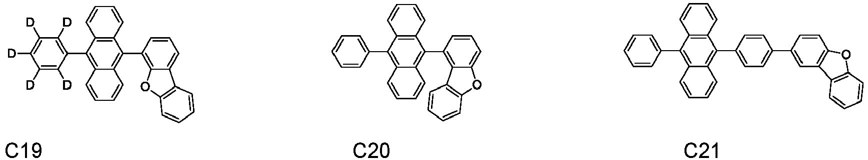

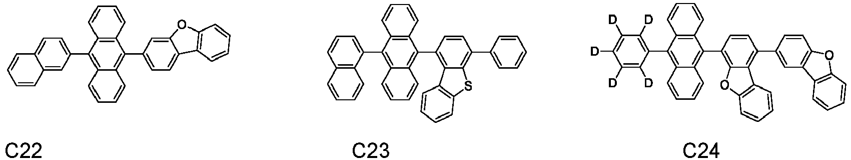

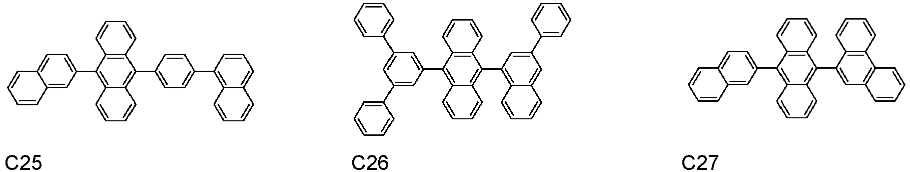

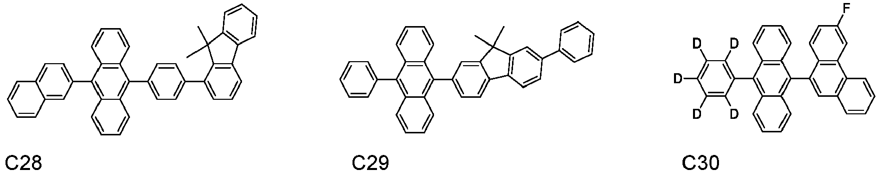

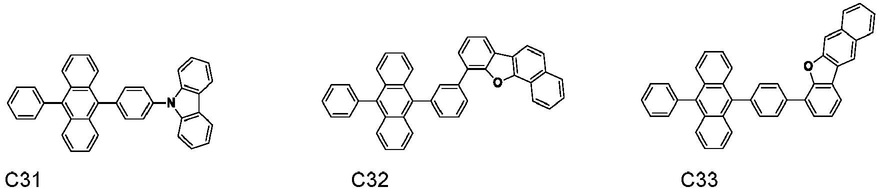

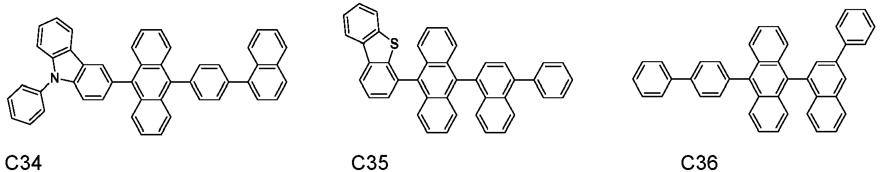

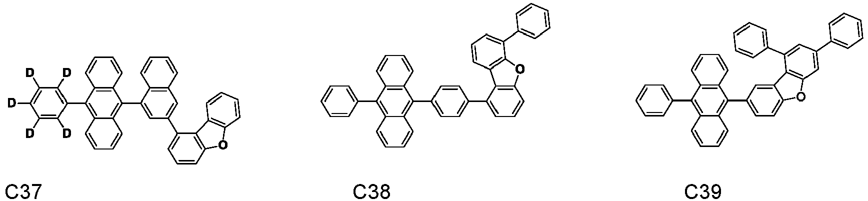

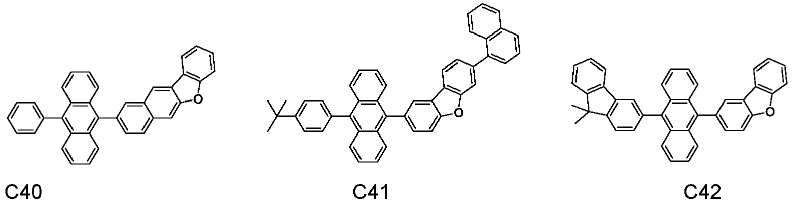

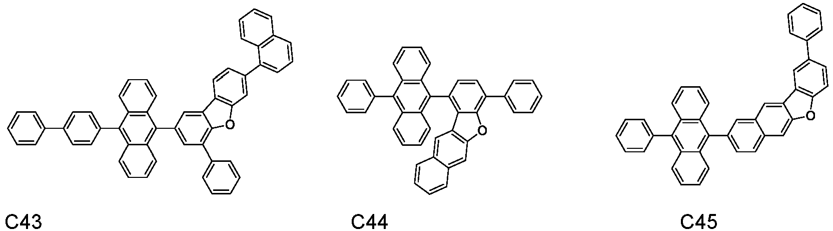

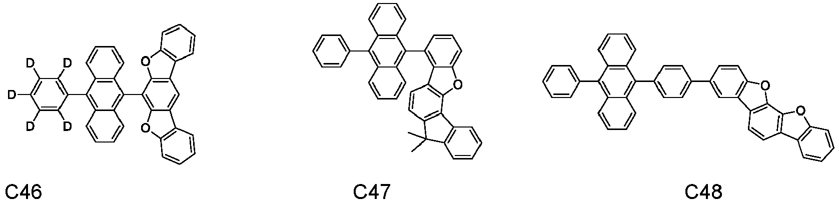

9. Die organisch elektrolumineszierende Vorrichtung nach einem der Ansprüche 4 bis 8, **dadurch gekennzeichnet, dass** die Lochtransportschicht und die Elektronensperrschicht jeweils eine Verbindung der Formel D umfassen: 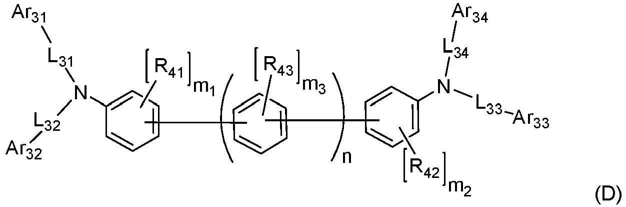 wobei R₄₁ bis R₄₃ identisch oder voneinander verschieden sind und jeweils unabhängig voneinander ausgewählt sind aus Wasserstoff, Deuterium, substituiertem oder unsubstituiertem C₁-C₂₀ Alkyl, substituiertem oder unsubstituiertem C₆-C₅₀ Aryl, substituiertem oder unsubstituiertem C₇-C₅₀ Arylalkyl, substituiertem oder unsubstituiertem C₃-C₃₀ Cycloalkyl, substituiertem oder unsubstituiertem C₁-C₃₀ Alkylsilyl, substituiertem oder unsubstituiertem C₆-C₃₀ Arylsilyl und Halogen, L₃₁ bis L₃₄ identisch oder voneinander verschieden sind und jeweils unabhängig voneinander Einfachbindungen sind oder ausgewählt sind aus substituiertem oder unsubstituiertem C₆-C₅₀ Arylen und substituiertem oder unsubstituiertem C₂-C₅₀ Heteroarylen, Ar₃₁ bis Ar₃₄ identisch oder voneinander verschieden sind und jeweils unabhängig voneinander ausgewählt sind aus substituiertem oder unsubstituiertem C₆-C₅₀ Aryl und substituiertem oder unsubstituiertem C₂-C₅₀ Heteroaryl, n eine ganze Zahl von 0 bis 4 ist, mit der Maßgabe, dass, wenn n 2 oder größer ist, die aromatischen Ringe, die R₄₃ enthalten, identisch oder voneinander verschieden sind, m₁ bis m₃ ganze Zahlen von 0 bis 4 sind, mit der Maßgabe, dass, wenn sowohl m₁ als auch m₃ 2 oder mehr sind, die Gruppen R₄₁, R₄₂, und R₄₃ identisch oder voneinander verschieden sind, und Wasserstoff- oder Deuteriumatome an die Kohlenstoffatome der aromatischen Ringe gebunden sind, an die R₄₁ bis R₄₃ nicht gebunden sind.

10. Die organisch elektrolumineszierende Vorrichtung nach Anspruch 9, **dadurch gekennzeichnet, dass** mindestens einer von Ar₃₁ bis Ar₃₄ in Formel D repräsentiert wird von Formel E: 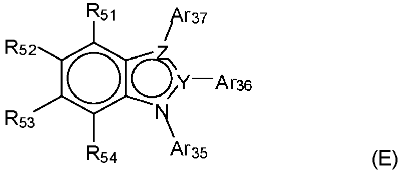 wobei R₅₁ bis R₅₄ identisch oder voneinander verschieden sind und jeweils unabhängig voneinander ausgewählt sind aus Wasserstoff, Deuterium, substituiertem oder unsubstituiertem C₁-C₃₀ Alkyl, substituiertem oder unsubstituiertem C₆-C₅₀ Aryl, substituiertem oder unsubstituiertem C₂-C₃₀ Alkenyl, substituiertem oder unsubstituiertem C₂-C₂₀ Alkynyl, substituiertem oder unsubstituiertem C₃-C₃₀ Cycloalkyl, substituiertem oder unsubstituiertem C₅-C₃₀ Cycloalkenyl, substituiertem oder unsubstituiertem C₂-C₅₀ Heteroaryl, substituiertem oder unsubstituiertem C₂-C₃₀ Heterocycloalkyl, substituiertem oder unsubstituiertem C₁-C₃₀ Alkoxy, substituiertem oder unsubstituiertem C₆-C₃₀ Aryloxy, substituiertem oder unsubstituiertem C₁-C₃₀ Alkylthioxy, substituiertem oder unsubstituiertem C₅-C₃₀ Arylthioxy, substituiertem oder unsubstituiertem C₁-C₃₀ Alkylamin, substituiertem oder unsubstituiertem C₅-C₃₀ Arylamin, substituiertem oder unsubstituiertem C₁-C₃₀ Alkylsilyl, substituiertem oder unsubstituiertem C₅-C₃₀ Arylsilyl, Nitro, Cyano und Halogen, die optional miteinander verbunden sind, um einen Ring zu bilden, Y ein Kohlenstoff- oder Stickstoffatom ist, Z ein Kohlenstoff-, Sauerstoff-, Schwefel- oder Stickstoffatom ist, Ar₃₅ bis Ar₃₇ identisch oder voneinander verschieden sind und jeweils unabhängig voneinander ausgewählt sind aus substituiertem oder unsubstituiertem C₅-C₅₀ Aryl und substituiertem oder unsubstituiertem C₃-C₅₀ Heteroaryl, mit der Maßgabe, dass, wenn Z ein Sauerstoff- oder Schwefelatom ist, Ar₃₇ nichts ist, mit der Maßgabe, dass, wenn Y und Z Stickstoffatome sind, nur eines von Ar₃₅, Ar₃₆ und Ar₃₇ vorhanden ist, mit der Maßgabe, dass, wenn Y ein Stickstoffatom und Z ein Kohlenstoffatom ist, Ar₃₆ nichts ist, mit der Maßgabe, dass eines von R₅₁ bis R₅₄ und Ar₃₅ bis Ar₃₇ eine Einfachbindung ist, die an einen der Verbindungsglieder L₃₁ bis L₃₄ in Formel D gebunden ist.

11. Die organisch elektrolumineszierende Vorrichtung nach Anspruch 9, **dadurch gekennzeichnet, dass** die Verbindung der Formel D ausgewählt ist aus den Verbindungen der Formeln D1 bis D79:

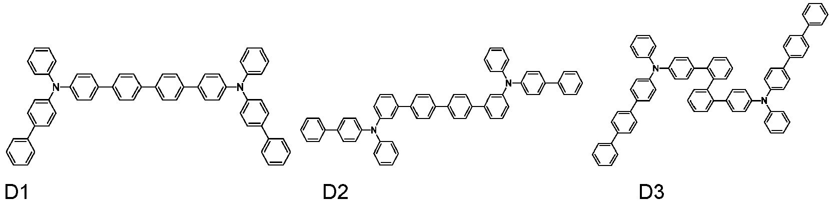

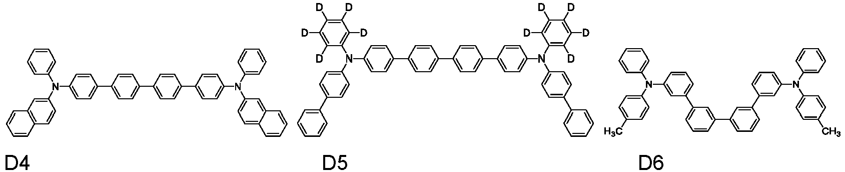

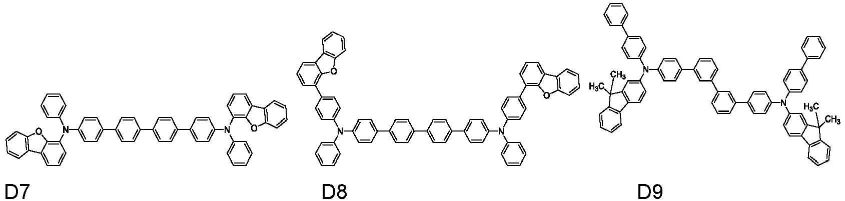

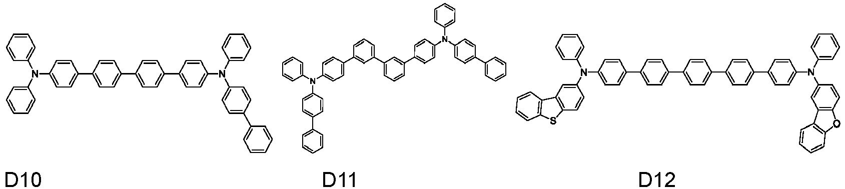

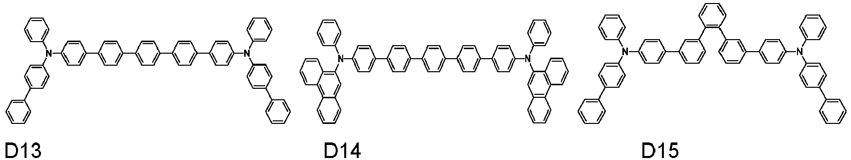

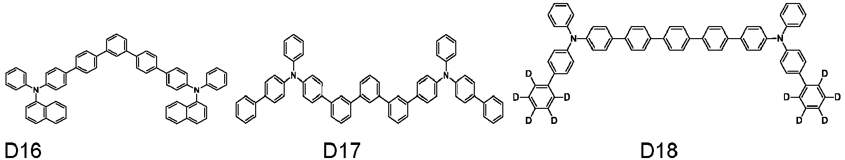

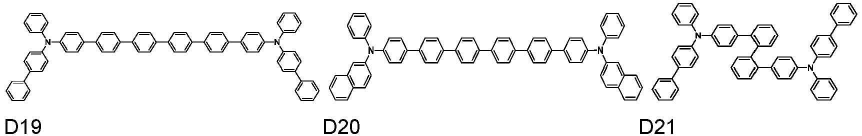

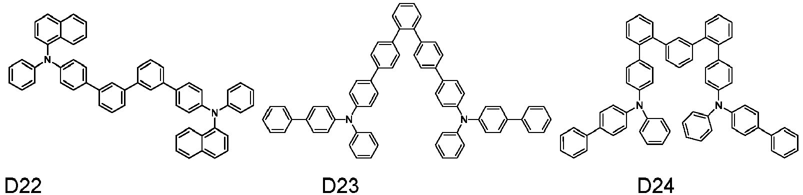

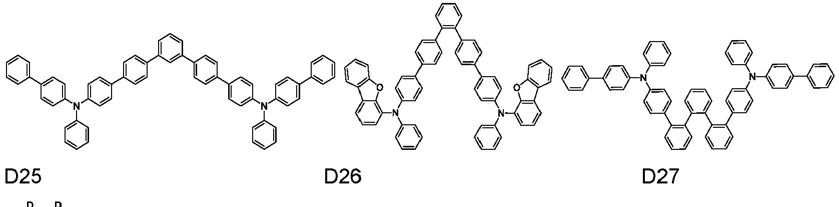

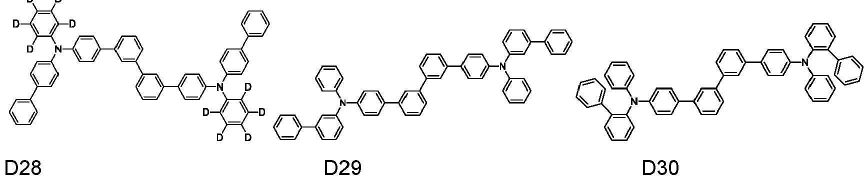

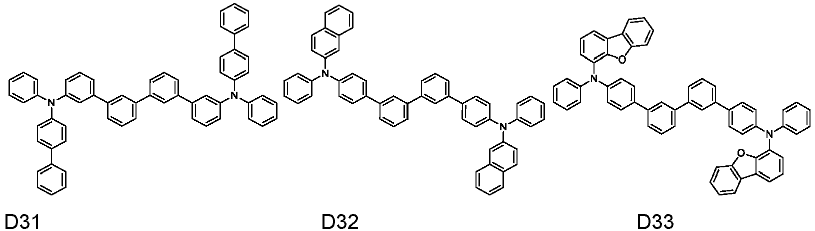

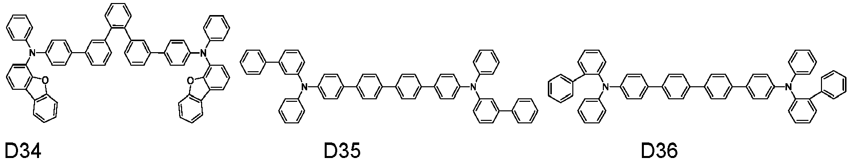

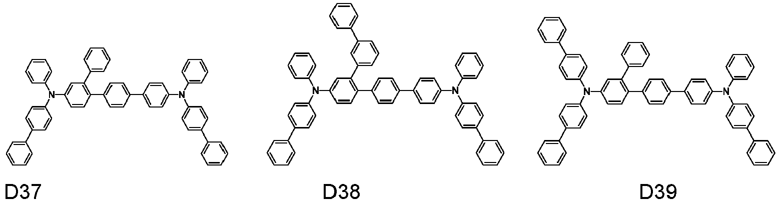

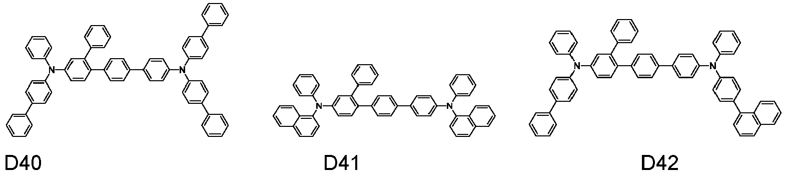

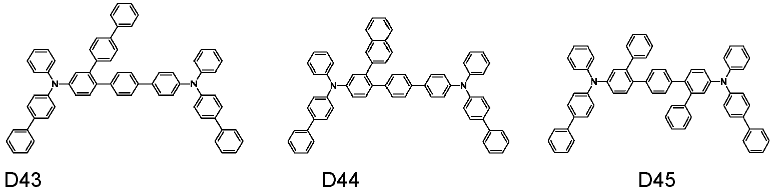

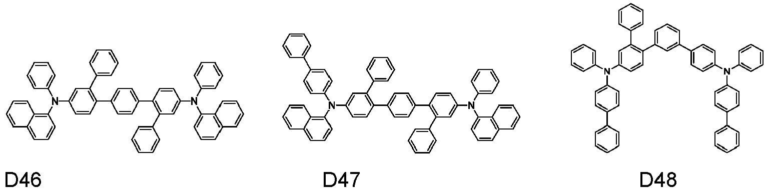

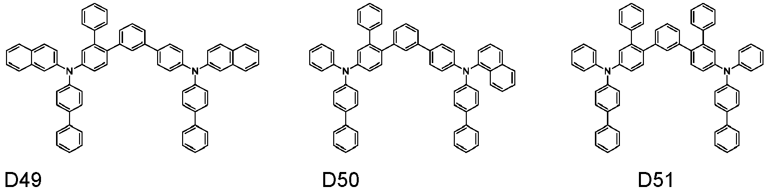

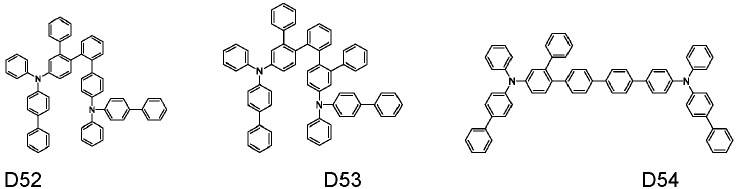

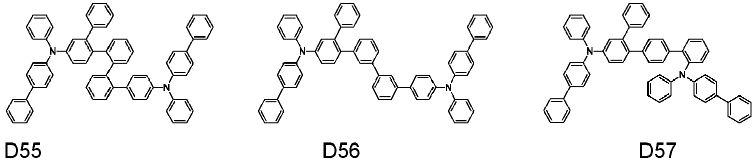

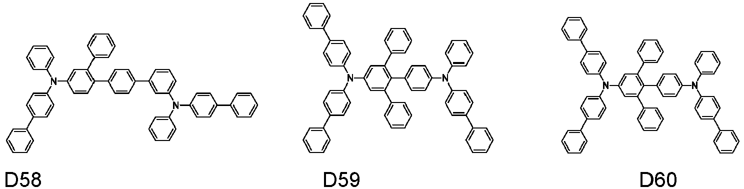

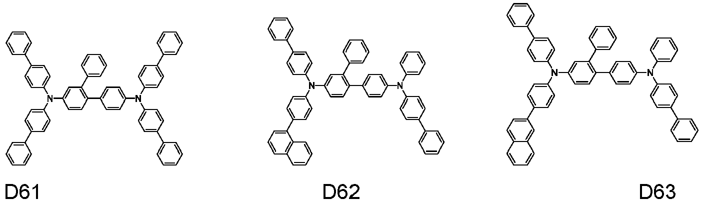

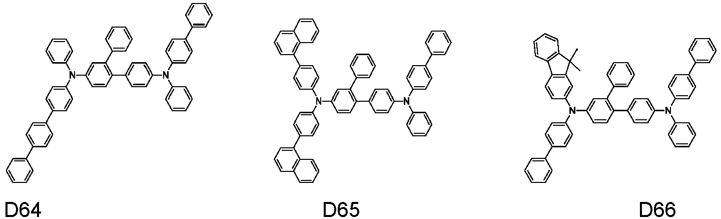

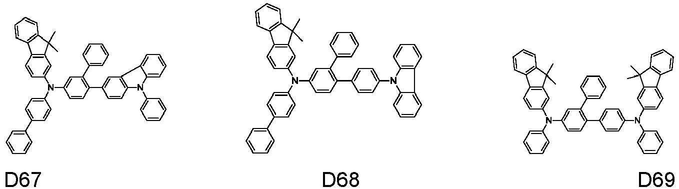

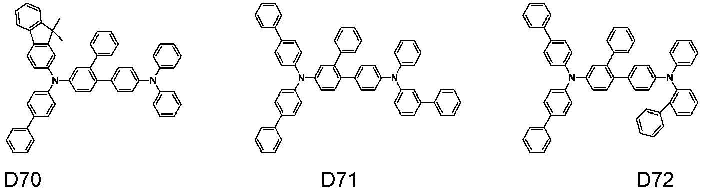

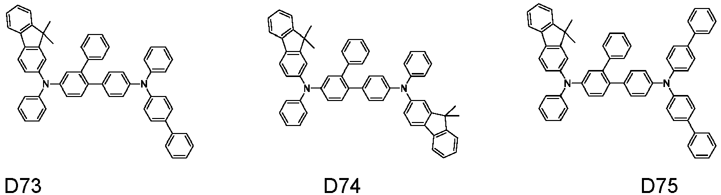

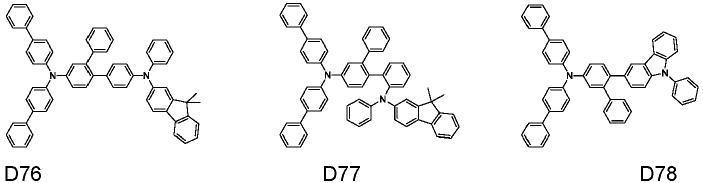

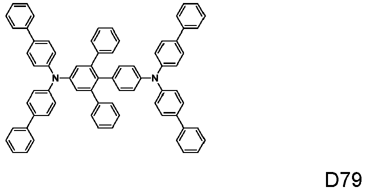

12. Die organisch elektrolumineszierende Vorrichtung nach Anspruch 9, **dadurch gekennzeichnet, dass** die Verbindung der Formel D ausgewählt ist aus den Verbindungen der Formeln D101 bis D145:

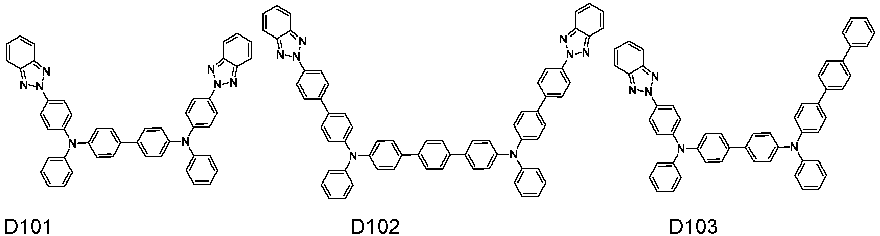

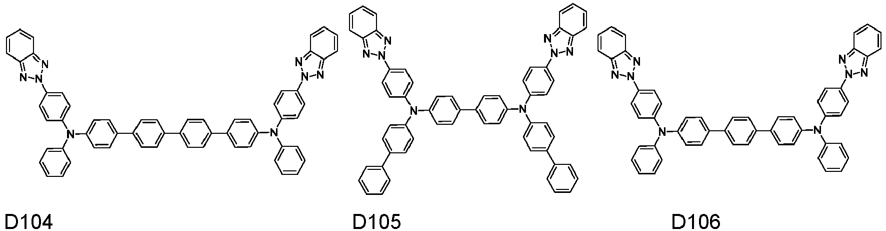

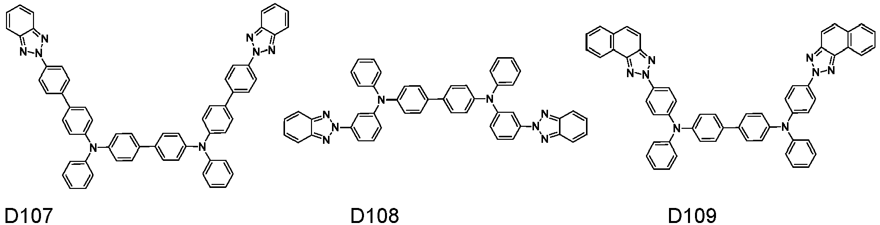

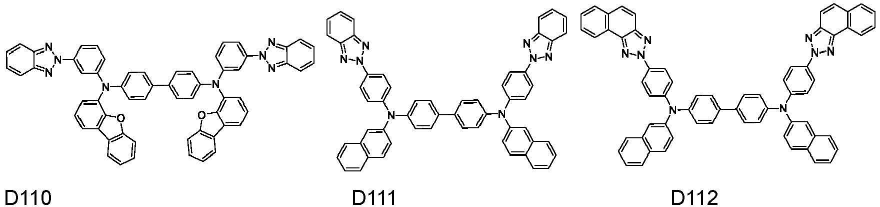

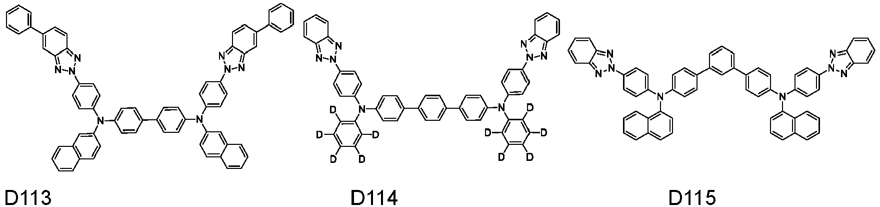

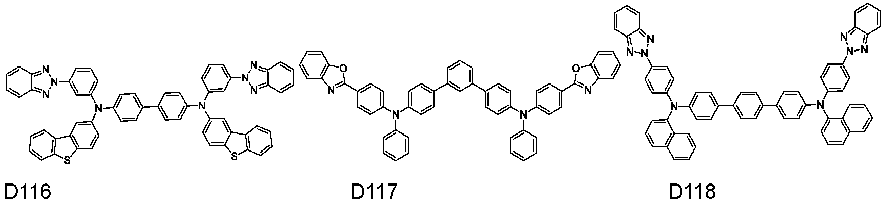

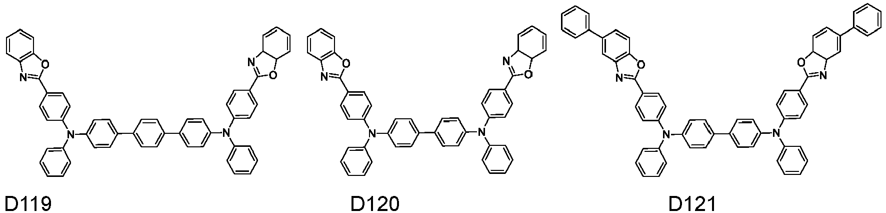

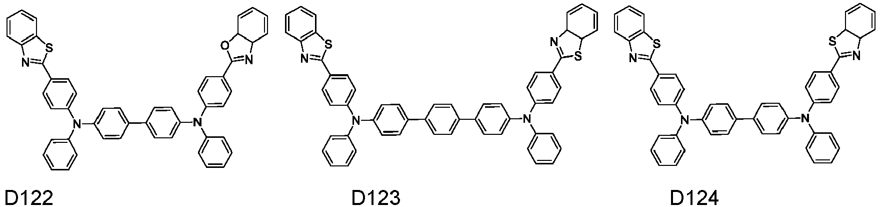

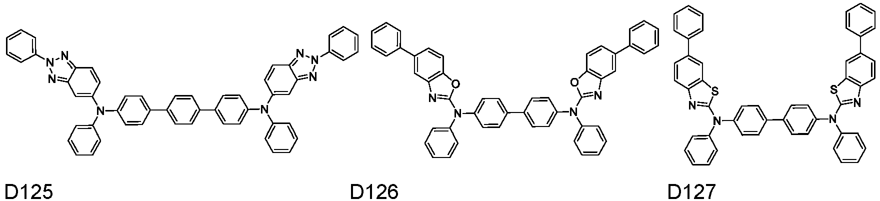

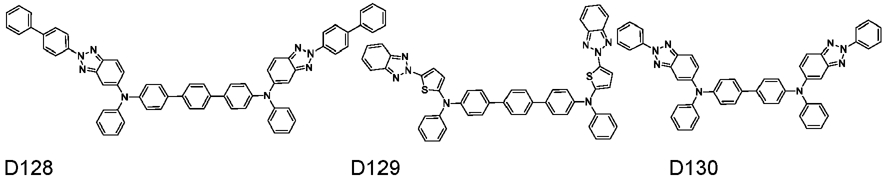

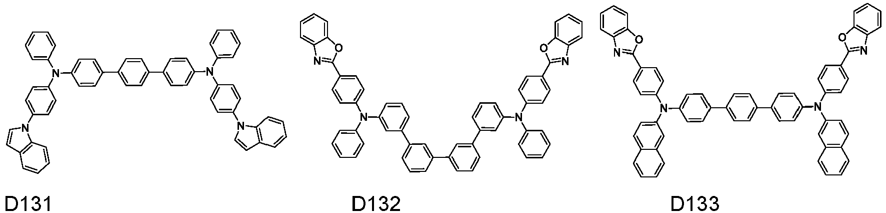

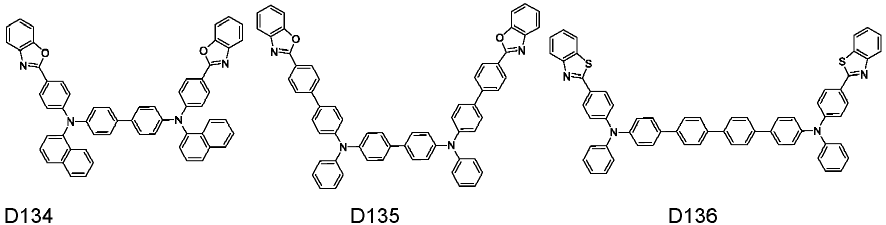

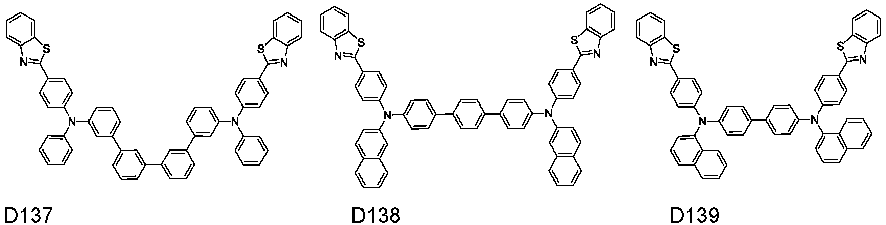

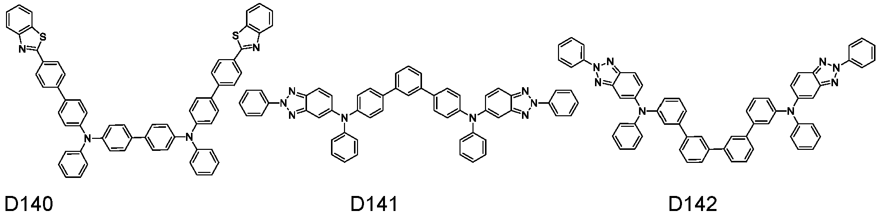

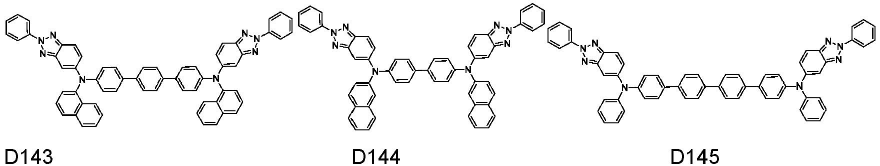

13. Die organisch elektrolumineszierende Vorrichtung nach einem der vorhergehenden Ansprüche 4 bis 12, **dadurch gekennzeichnet, dass** die Lochtransportschicht und die Elektronensperrschicht jeweils eine durch die Formel F dargestellte Verbindung umfassen: 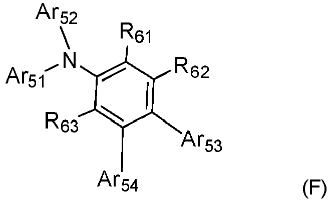 wobei R₆₁ bis R₆₃ identisch oder voneinander verschieden sind und jeweils unabhängig voneinander ausgewählt sind aus Wasserstoff, Deuterium, substituiertem oder unsubstituiertem C₁-C₃₀ Alkyl, substituiertem oder unsubstituiertem C₆-C₅₀ Aryl, substituiertem oder unsubstituiertem C₂-C₃₀ Alkenyl, substituiertem oder unsubstituiertem C₂-C₂₀ Alkynyl, substituiertem oder unsubstituiertem C₃-C₃₀ Cycloalkyl, substituiertem oder unsubstituiertem C₅-C₃₀ Cycloalkenyl, substituiertem oder unsubstituiertem C₂-C₅₀ Heteroaryl, substituiertem oder unsubstituiertem C₂-C₃₀ Heterocycloalkyl, substituiertem oder unsubstituiertem C₁-C₃₀ Alkoxy, substituiertem oder unsubstituiertem C₆-C₃₀ Aryloxy, substituiertem oder unsubstituiertem C₁-C₃₀ Alkylthioxy, substituiertem oder unsubstituiertem C₆-C₃₀ Arylthioxy, substituiertem oder unsubstituiertem C₁-C₃₀ Alkylamin, substituiertem oder unsubstituiertem C₆-C₃₀ Arylamin, substituiertem oder unsubstituiertem C₁-C₃₀ Alkylsilyl, substituiertem oder unsubstituiertem C₆-C₃₀ Arylsilyl, substituiertem oder unsubstituiertem C₁-C₃₀ Alkylgermanium, substituiertem oder unsubstituiertem C₁-C₃₀ Arylgermanium, Cyano, Nitro und Halogen, und Ar₅₁ bis Ar₅₄ identisch oder voneinander verschieden sind und jeweils unabhängig voneinander substituiertes oder unsubstituiertes C₆-C₄₀ Aryl oder substituiertes oder unsubstituiertes C₂-C₃₀ Heteroaryl sind.

14. Die organisch elektrolumineszierende Vorrichtung nach Anspruch 13, **dadurch gekennzeichnet, dass** die Verbindung der Formel F ausgewählt ist aus den Verbindungen der Formeln F1 bis F33:

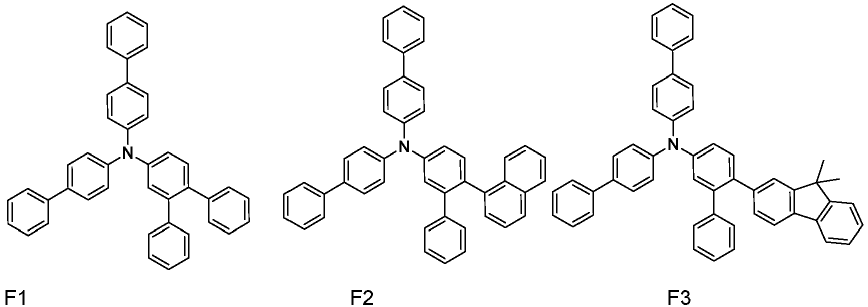

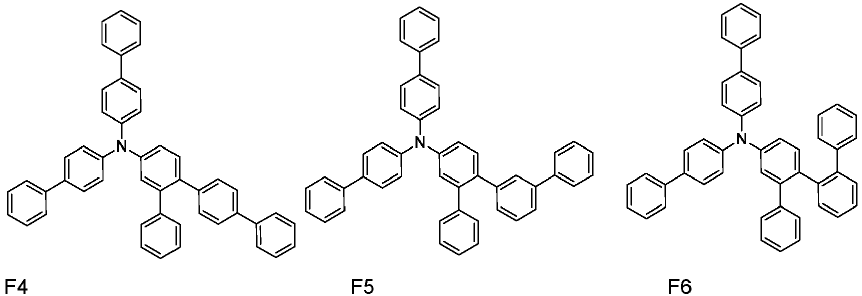

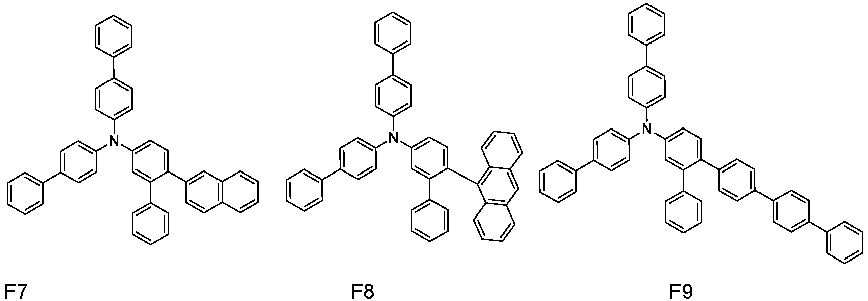

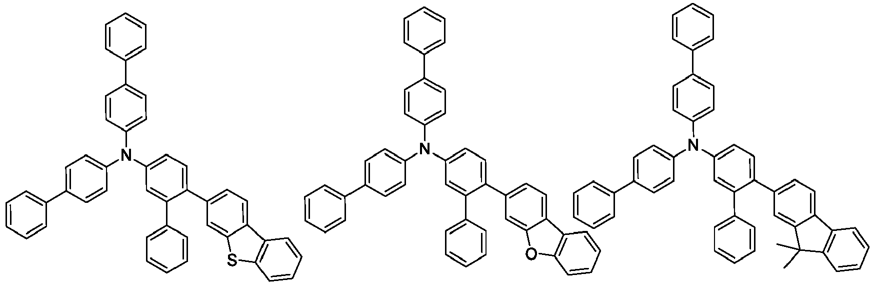

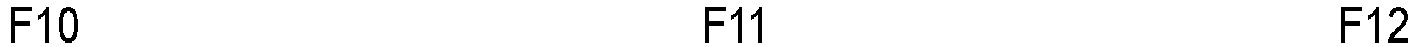

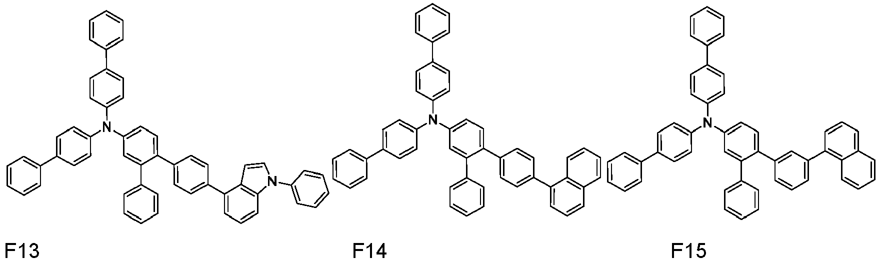

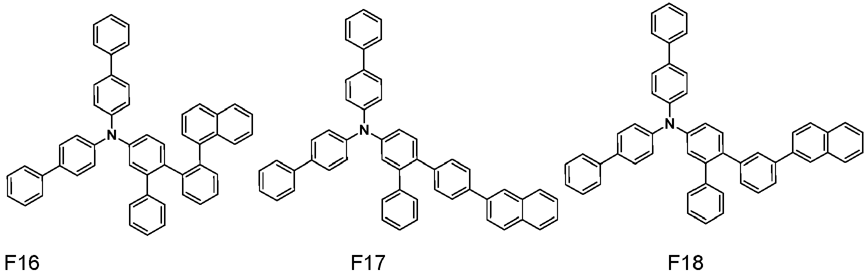

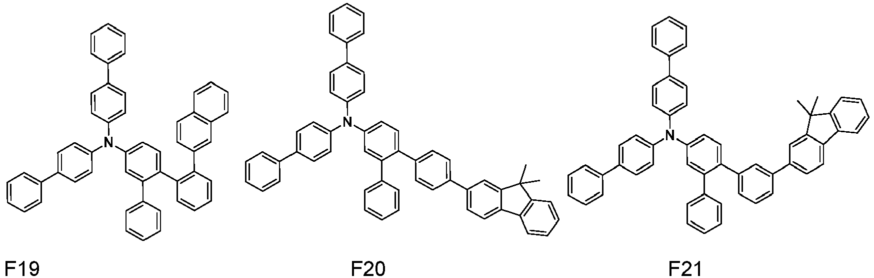

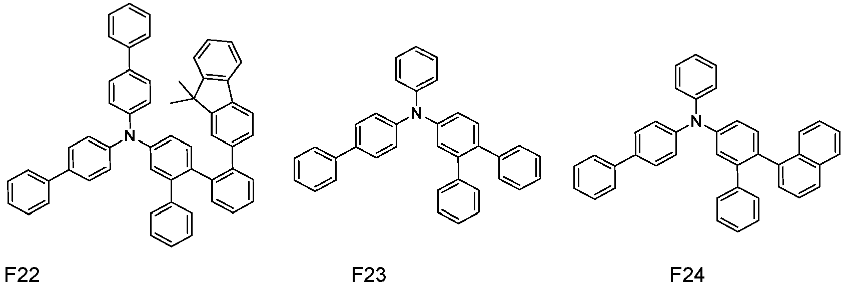

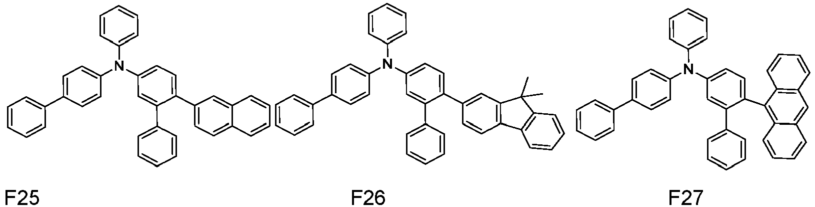

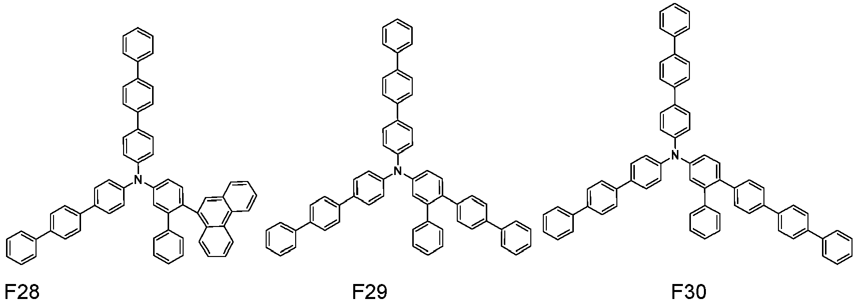

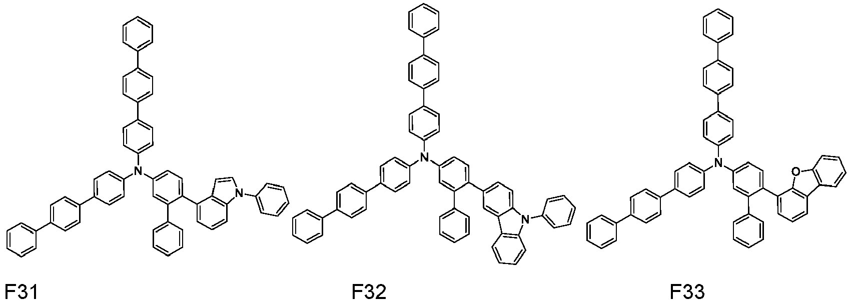

15. Die organisch elektrolumineszierende Vorrichtung nach einem der Ansprüche 4 bis 14, **dadurch gekennzeichnet, dass** eine oder mehrere der Schichten durch ein Abscheidungs- oder Lösungsverfahren gebildet werden.

16. Die organisch elektrolumineszierende Vorrichtung nach einem der Ansprüche 3 bis 15, wobei die organisch elektrolumineszierende Vorrichtung in einem Anzeige- oder Beleuchtungssystem verwendet wird, das ausgewählt ist aus Flachbildschirmen, flexiblen Anzeigen, monochromatischen Flachbildschirm-Beleuchtungssystemen, weißen Flachbildschirm-Beleuchtungssystemen, flexiblen monochromatischen Beleuchtungssystemen und flexiblen weißen Beleuchtungssystemen.

## Revendications

1. Composé électroluminescent organique représenté par la formule A-3, A-4, A-5 ou A-6 : 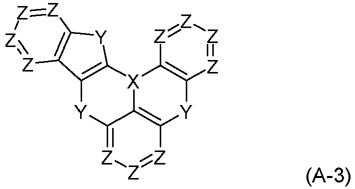 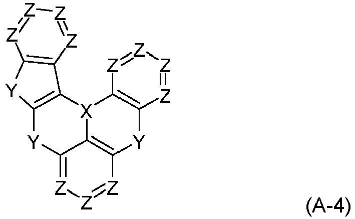 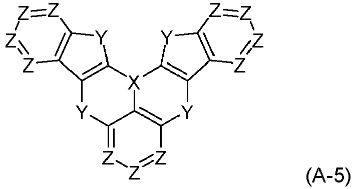 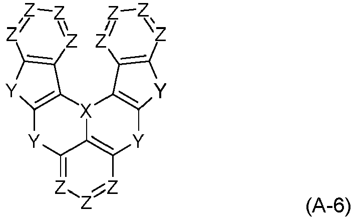 les lieurs Y étant identiques ou différents l'un de l'autre et étant choisis chacun indépendamment parmi N-R₁, CR₂R₃, O, S, Se, et SiR₄R₅, X étant B, et R₁ à R₅ étant identiques ou différents l'un de l'autre et étant choisis chacun indépendamment parmi hydrogène, deutérium, alkyle en C₁-C₃₀ substitué ou non substitué, aryle en C₆-C₅₀ substitué ou non substitué, cycloalkyle en C₃-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, alkylamine en C₁-C₃₀ substituée ou non substituée, arylamine en C₅-C₃₀ substituée ou non substituée, alkylsilyle en C₁-C₃₀ substitué ou non substitué, arylsilyle en C₅-C₃₀ substitué ou non substitué, nitro, cyano, et halogène, sous réserve que R₂ et R₃ sont optionnellement liés l'un à l'autre pour former un alicycle ou un monocycle ou polycycle aromatique, et R₃ et R₄ sont optionnellement liés l'un à l'autre pour former un alicycle ou un monocycle ou polycycle aromatique, chaque Z étant indépendamment CR ou N, les substituants R étant identiques ou différents l'un de l'autre et étant choisis indépendamment parmi hydrogène, deutérium, alkyle en C₁-C₃₀ substitué ou non substitué, aryle en C₆-C₅₀ substitué ou non substitué, cycloalkyle en C₃-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, alkylamine en C₁-C₃₀ substituée ou non substituée, arylamine en C₅-C₃₀ substituée ou non substituée, alkylsilyle en C₁-C₃₀ substitué ou non substitué, arylsilyle en C₅-C₃₀ substitué ou non substitué, nitro, cyano, et halogène, sous réserve que les substituants R sont optionnellement liés l'un à l'autre ou sont optionnellement liés à autre substituants adjacents pour former des alicycles ou des monocycles ou polycycles aromatiques dont les atomes de carbone sont optionnellement substitués par un ou plusieurs hétéroatomes choisis parmi les atomes de N, S, et O.

2. Composé électroluminescent organique selon la revendication 1, **caractérisé en ce que** le composé électroluminescent organique représenté par la formule A-3, A-4, A-5 ou A-6 est choisi parmi les composés suivants :

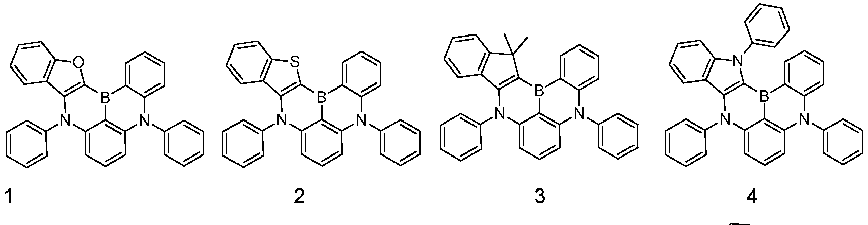

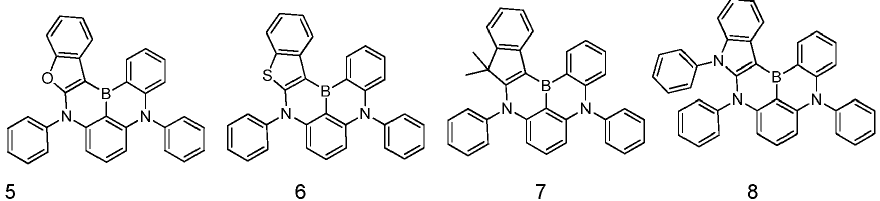

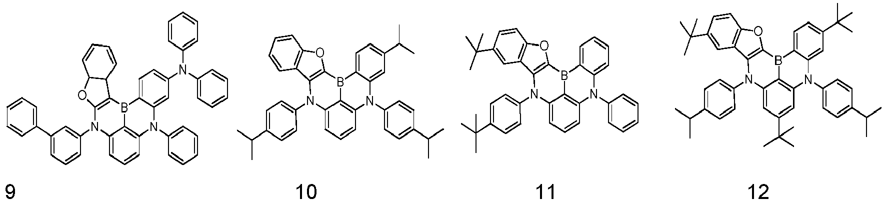

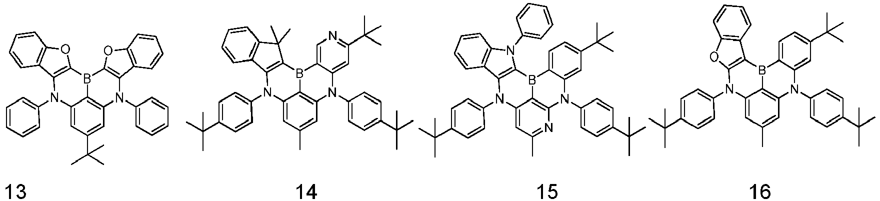

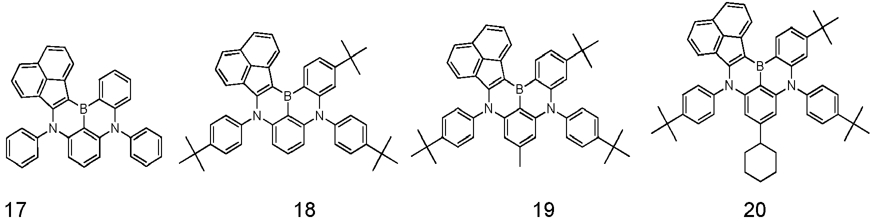

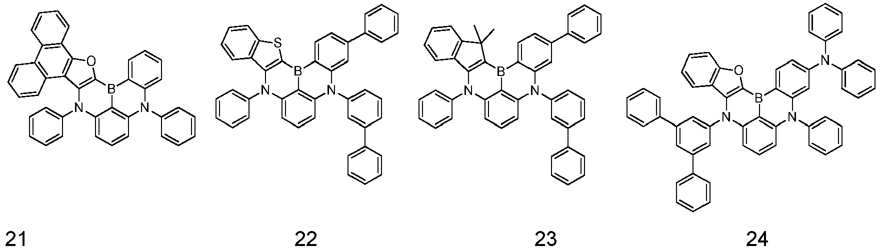

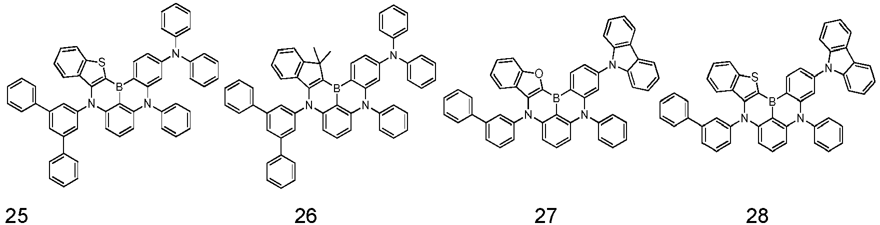

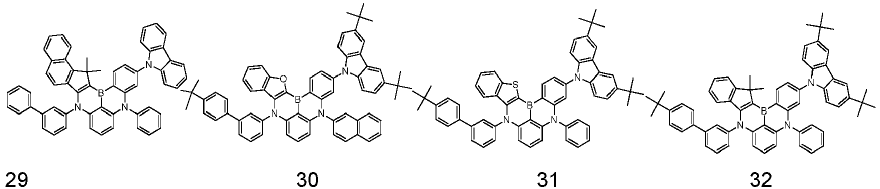

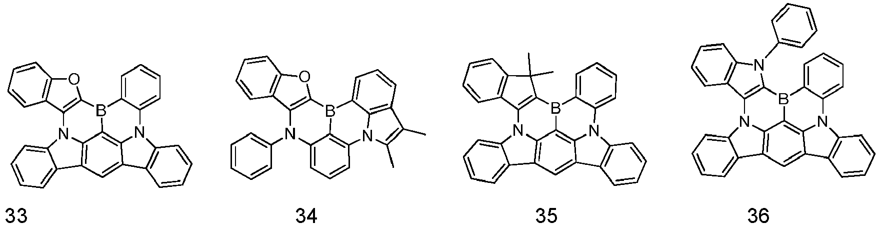

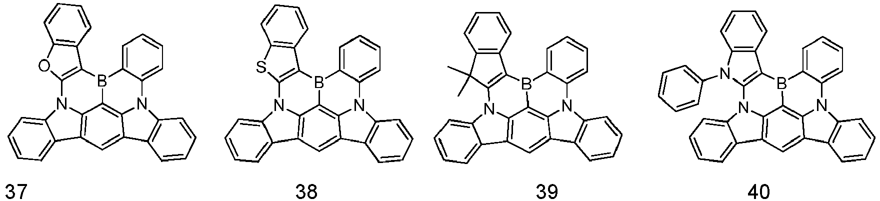

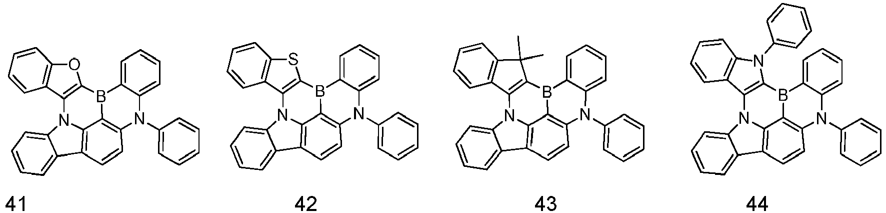

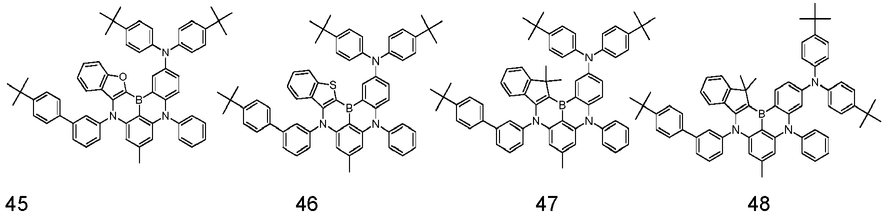

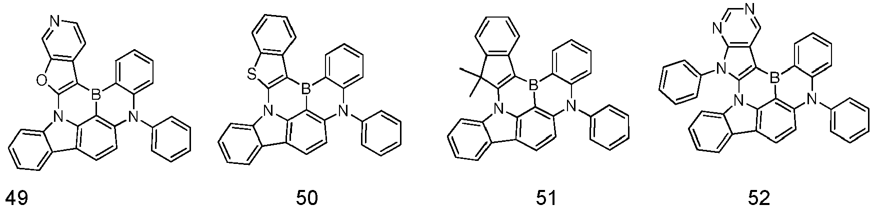

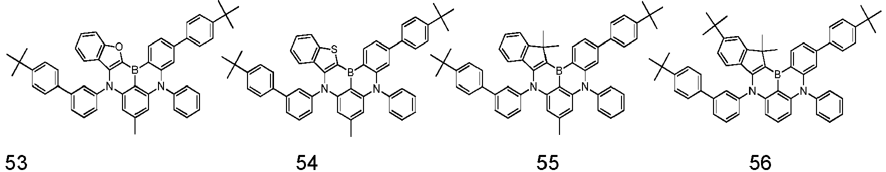

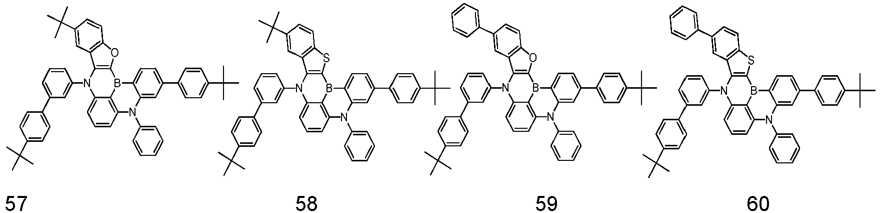

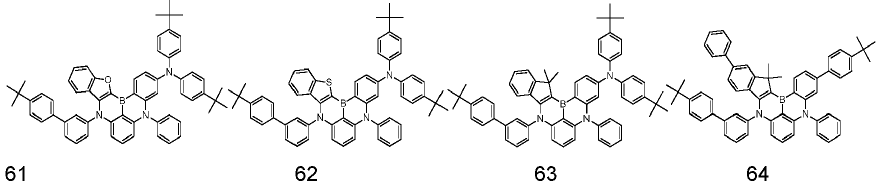

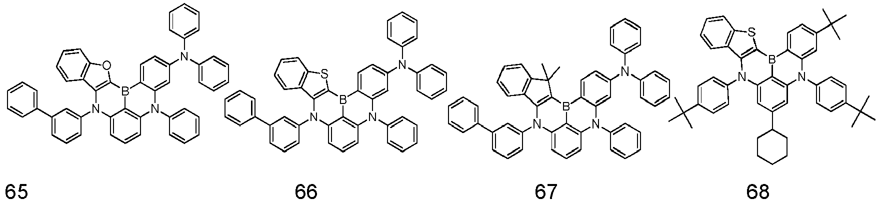

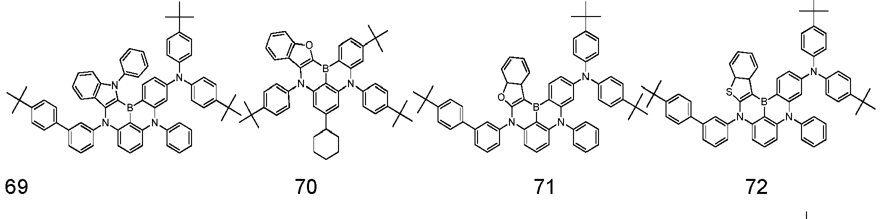

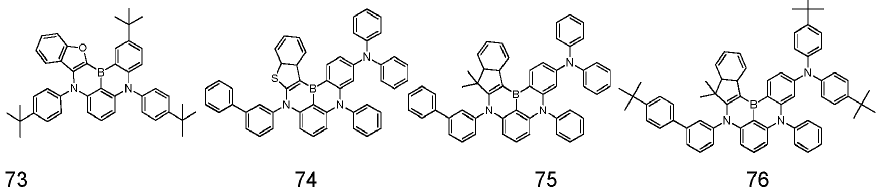

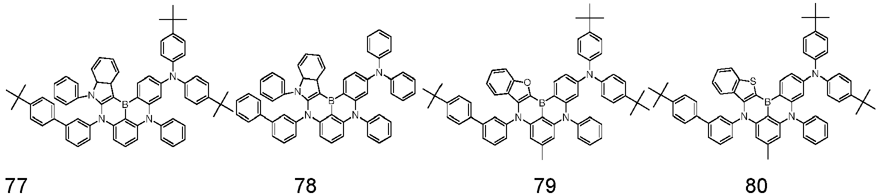

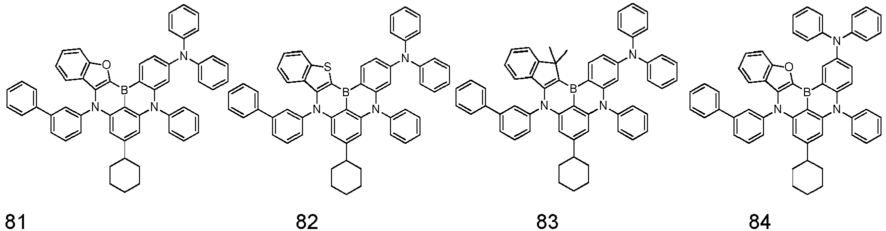

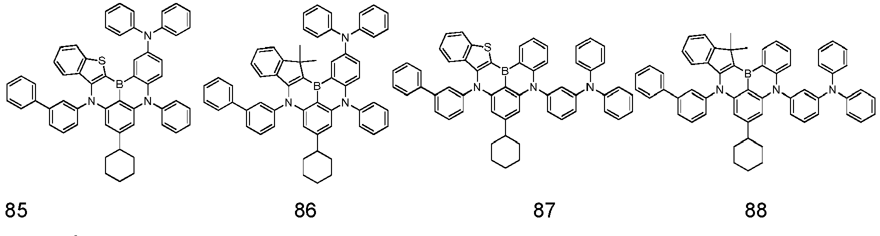

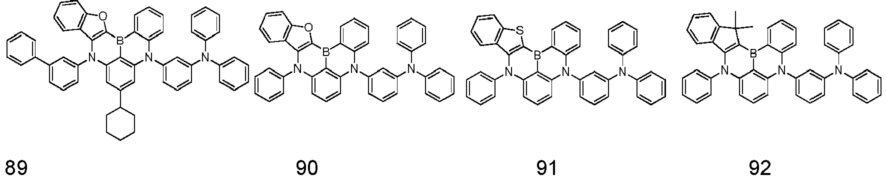

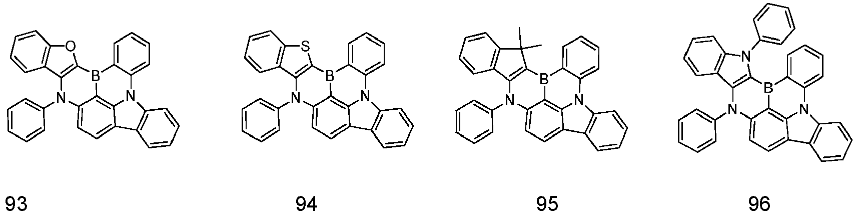

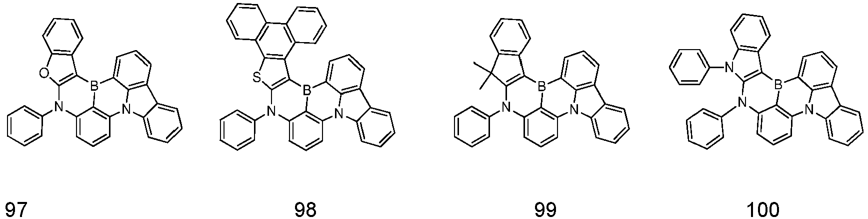

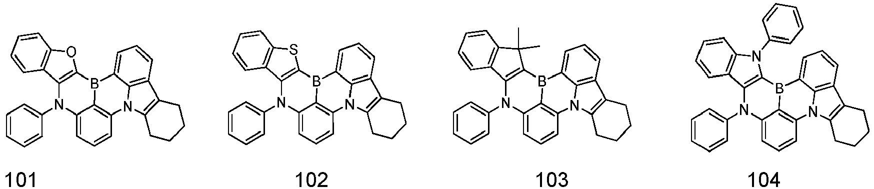

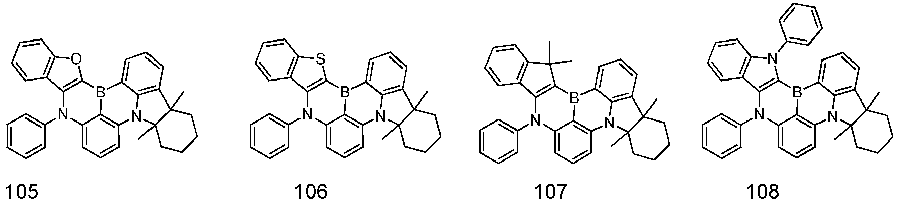

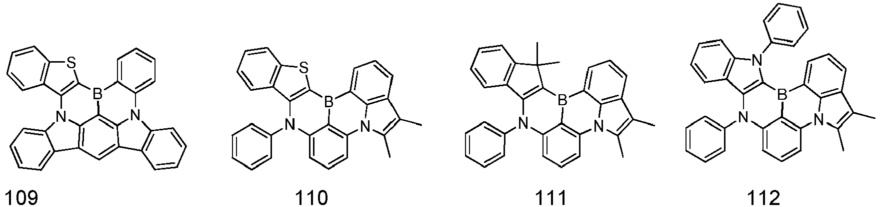

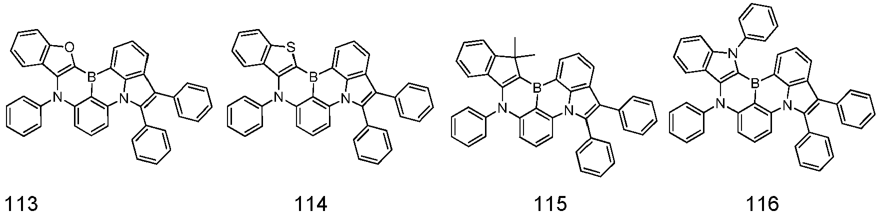

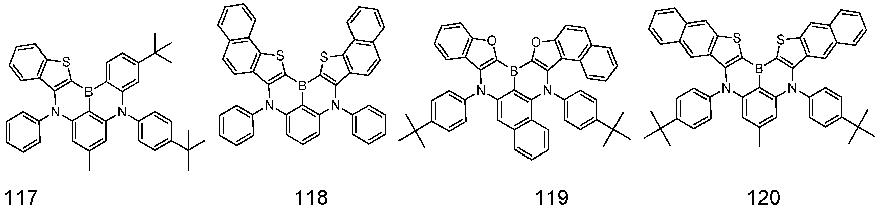

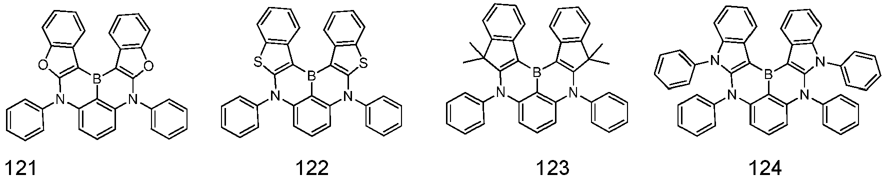

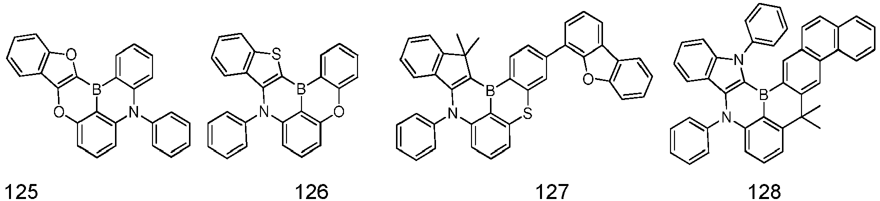

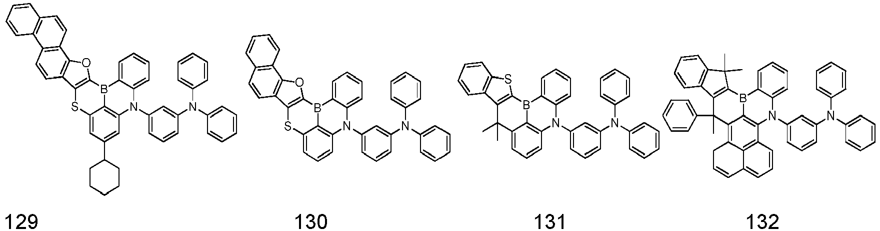

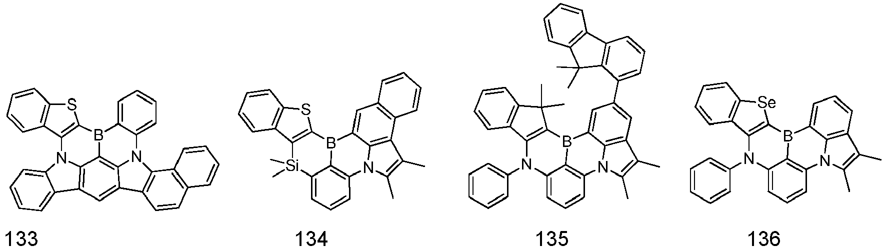

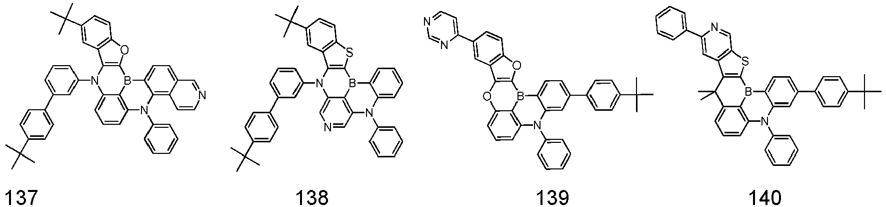

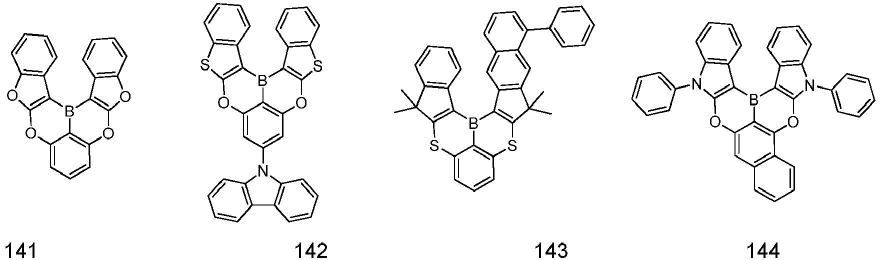

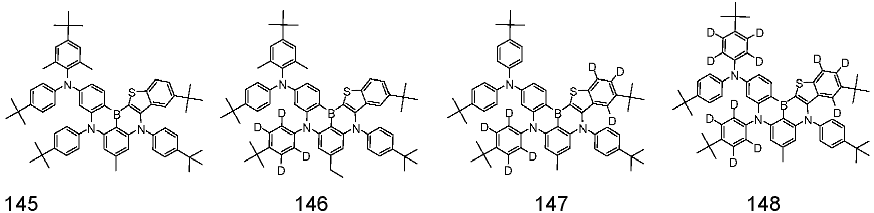

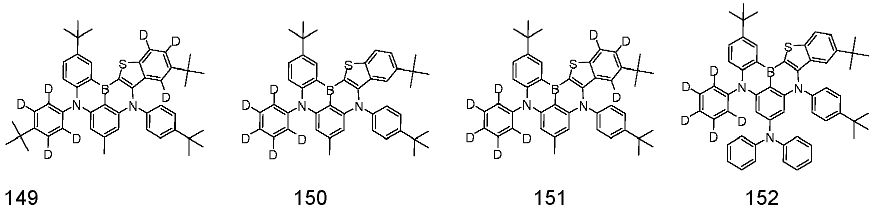

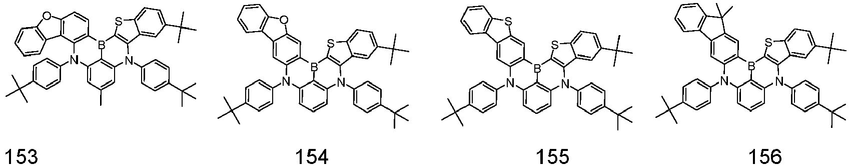

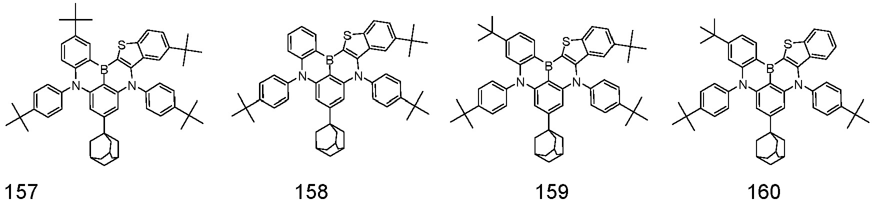

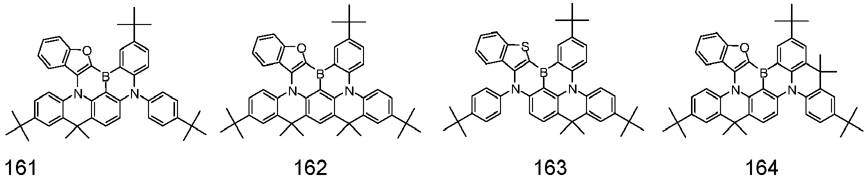

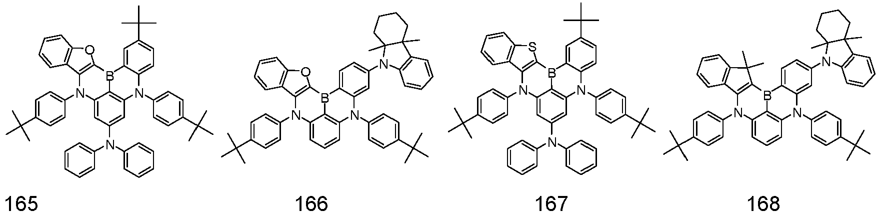

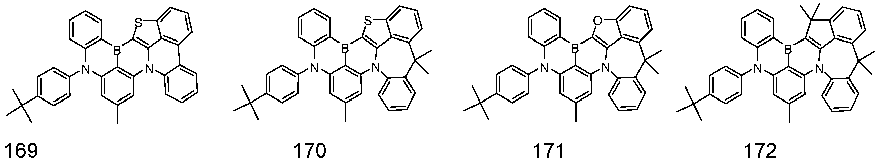

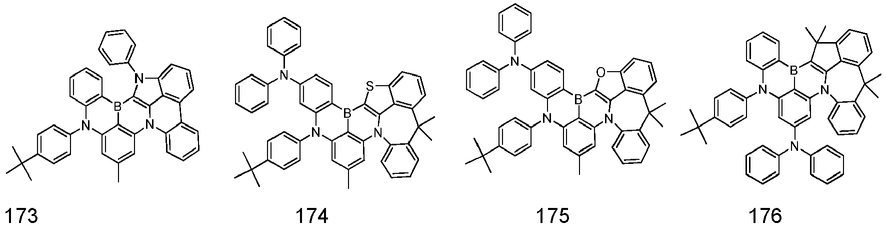

3. Dispositif électroluminescent organique comprenant une première électrode, une deuxième électrode faisant face à ladite première électrode, et une ou plusieurs couches organiques interposées entre lesdites première et deuxième électrodes, **caractérisé en ce qu'**au moins une desdites couches organiques comprend le composé électroluminescent organique selon la revendication 1 ou 2 et optionnellement un autre composé électroluminescent organique selon la revendication 1 ou 2.

4. Dispositif électroluminescent organique selon la revendication 3, **caractérisé en ce que** les couches organiques comprennent une couche d'injection d'électrons, une couche de transport d'électrons, une couche d'injection de trous, une couche de transport de trous, une couche de blocage d'électrons, une couche de blocage de trous, une couche d'émission de lumière, et au moins une desdites couches organiques comprend le composé électroluminescent organique selon la revendication 1 ou 2.

5. Dispositif électroluminescent organique selon la revendication 4, **caractérisé en ce que** ladite couche d'émission de lumière comprend, en tant que composé hôte, un dérivé d'anthracène représenté par la formule C : 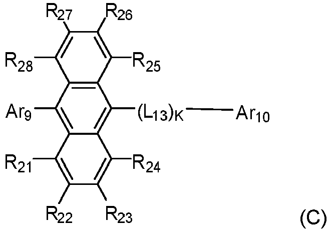 R₂₁ à R₂₈ étant identiques ou différents l'un de l'autre et étant tel que définis pour R₁ à R₄ dans la formule A-3, A-4, A-5 ou A-6 représentant le composé électroluminescent organique selon la revendication 1, Ar₉ et Ar₁₀ étant identiques ou différents l'un de l'autre et étant choisis chacun indépendamment parmi hydrogène, deutérium, alkyle en C₁-C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₆-C₃₀ substitué ou non substitué, alkylamine en C₁-C₃₀ substituée ou non substituée, arylamine en C₆-C₃₀ substituée ou non substituée, alkylsilyle en C₁-C₃₀ substitué ou non substitué, et arylsilyle en C₆-C₃₀ substitué ou non substitué, L₁₃ étant une liaison simple ou étant choisi parmi arylène en C₆-C₂₀ substitué ou non substitué et hétéroarylène en C₂-C₂₀ substitué ou non substitué, et k étant un entier de 1 à 3, pourvu que lorsque k est égal ou supérieur à 2, les lieurs L₁₃ sont identiques ou différents l'un de l'autre.

6. Dispositif électroluminescent organique selon la revendication 5, **caractérisé en ce que** Ar₉ dans la formule C est représenté par la formule C-1 : 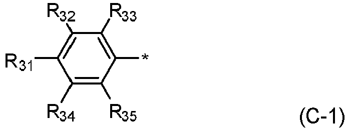 R₃₁ à R₃₅ étant identiques ou différents l'un de l'autre et étant tel que définis pour R₁ à R₄ dans la formule A-3, A-4, A-5 ou A-6 représentant le composé électroluminescent organique selon la revendication 1 et chacun des R₃₁ à R₃₅ étant optionnellement lié à un substituant adjacent pour former un cycle saturé ou non saturé.

7. Dispositif électroluminescent organique selon la revendication 5 ou 6, **caractérisé en ce que** L₁₃ dans la formule C est une liaison simple ou est arylène en C₆-C₂₀ substitué ou non substitué.

8. Dispositif électroluminescent organique selon la revendication 5, **caractérisé en ce que** le composé de formule C est choisi parmi les composés de formules C1 à C48 :

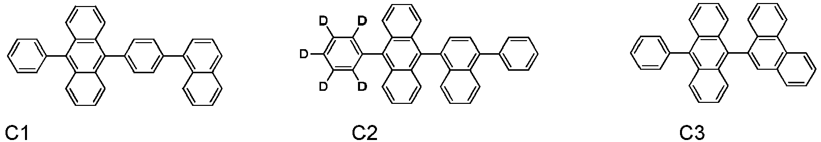

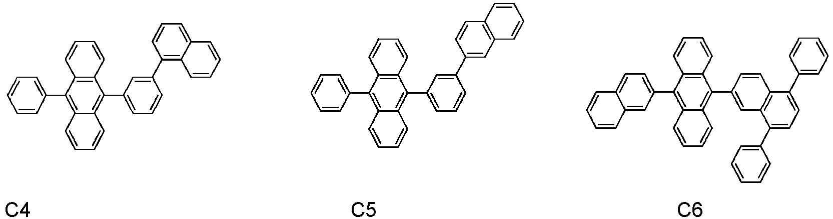

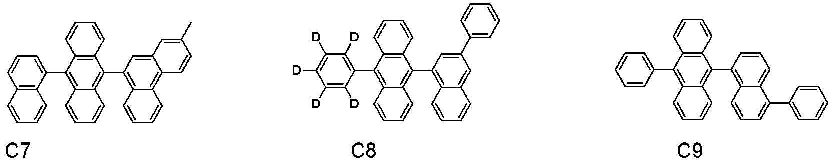

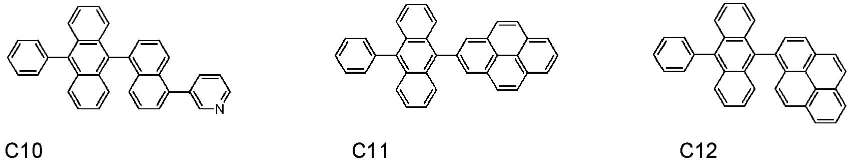

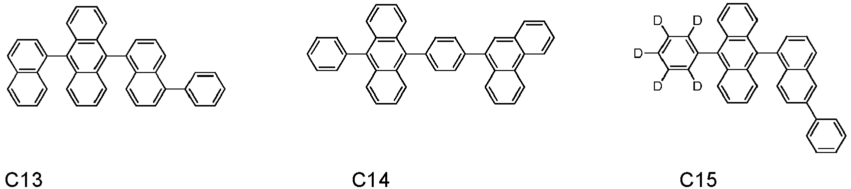

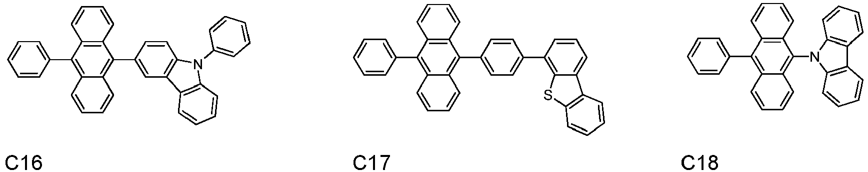

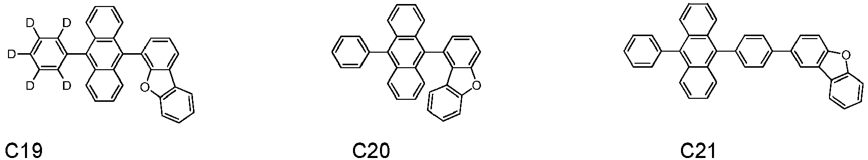

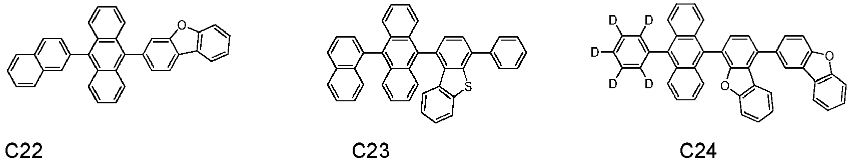

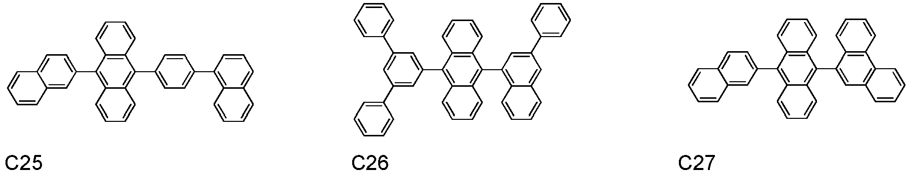

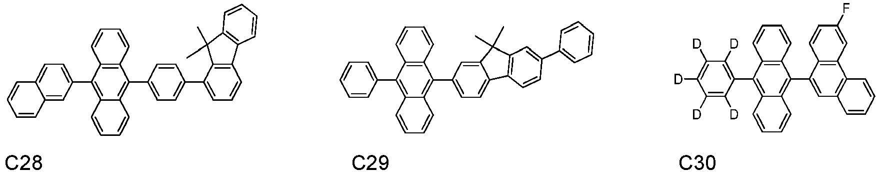

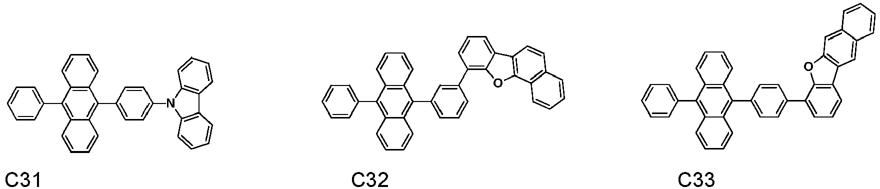

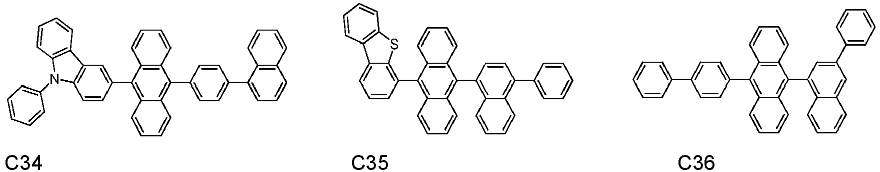

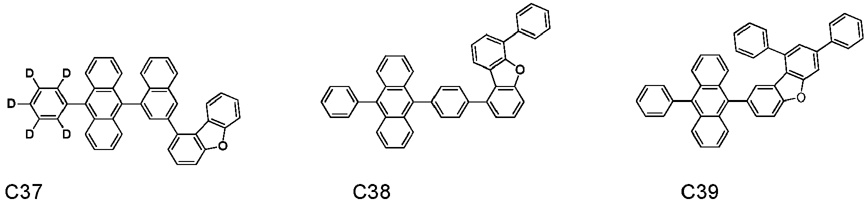

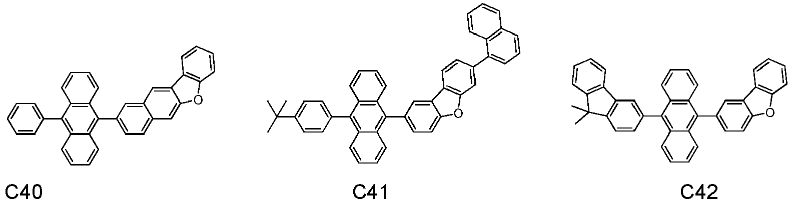

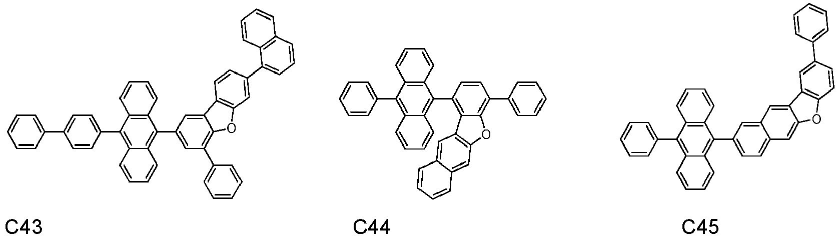

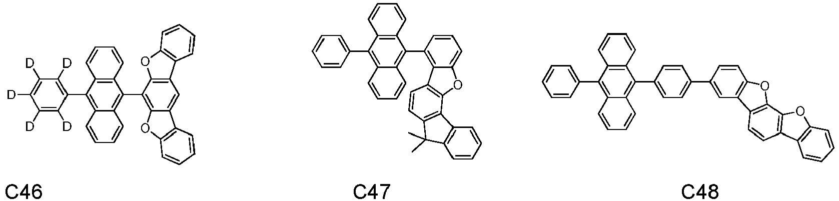

9. Dispositif électroluminescent organique selon l'une quelconque des revendications 4 à 8, **caractérisé en ce que** chacune de la couche de transport de trous et la couche de blocage d'électrons comprend un composé représenté par la formule D : 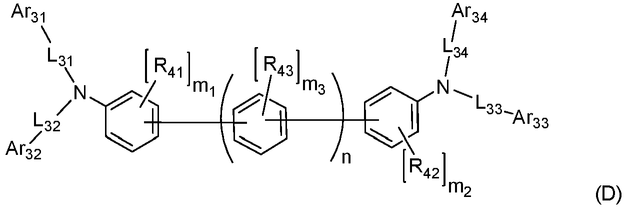 R₄₁ à R₄₃ étant identiques ou différents l'un de l'autre et étant choisis chacun indépendamment parmi hydrogène, deutérium, alkyle en C₁-C₂₀ substitué ou non substitué, aryle en C₆-C₅₀ substitué ou non substitué, arylalkyle en C₇-C₅₀ substitué ou non substitué, cycloalkyle en C₃-C₃₀ substitué ou non substitué, alkylsilyle en C₁-C₃₀ substitué ou non substitué, arylsilyle en C₆-C₃₀ substitué ou non substitué, et halogène, L₃₁ à L₃₄ étant identiques ou différents l'un de l'autre et étant chacun indépendamment des liaisons simples ou choisis parmi arylène en C₆-C₅₀ substitué ou non substitué et hétéroarylène en C₂-C₅₀ substitué ou non substitué, Ar₃₁ à Ar₃₄ étant identiques ou différents l'un de l'autre et étant choisis chacun indépendamment parmi aryle en C₆-C₅₀ substitué ou non substitué et hétéroaryle en C₂-C₅₀ substitué ou non substitué, n étant un entier de 0 à 4, pourvu que lorsque n est égal ou supérieur à 2, les cycles aromatiques comportant R₄₃ sont identiques ou différents l'un de l'autre, m₁ à m₃ étant des entiers de 0 à 4, pourvu que lorsque m₁ et m₃ sont égaux ou supérieurs à 2, les groupes R₄₁, R₄₂, et R₄₃ sont identiques ou différents l'un de l'autre, et les atomes d'hydrogène ou de deutérium sont liés aux atomes de carbone des cycles aromatiques auxquels R₄₁ à R₄₃ ne sont pas attachés.

10. Dispositif électroluminescent organique selon la revendication 9, **caractérisé en ce qu'**au moins un des Ar₃₁ à Ar₃₄ dans la formule D est représenté par la formule E : 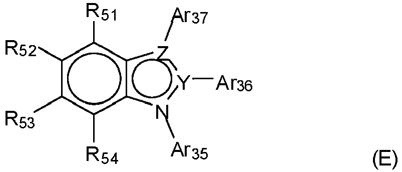 R₅₁ à R₅₄ étant identiques ou différents l'un de l'autre et étant choisis chacun indépendamment parmi hydrogène, deutérium, alkyle en C₁-C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, alkylamine en C₁-C₃₀ substituée ou non substituée, arylamine en C₅-C₃₀ substituée ou non substituée, alkylsilyle en C₁-C₃₀ substitué ou non substitué, arylsilyle en C₅-C₃₀ substitué ou non substitué, nitro, cyano, et halogène, qui sont optionnellement liés l'un à l'autre pour former un cycle, Y étant un atome de carbone ou d'azote, Z étant un atome de carbone, d'oxygène, de soufre ou d'azote, Ar₃₅ à Ar₃₇ étant identiques ou différents l'un de l'autre et étant choisis chacun indépendamment parmi aryle en C₆-C₅₀ substitué ou non substitué et hétéroaryle en C₃-C₅₀ substitué ou non substitué, pourvu que lorsque Z est un atome d'oxygène ou de soufre, Ar₃₇ est rien, pourvu que lorsque Y et Z sont des atomes d'azote, seulement un des Ar₃₅, Ar₃₆, et Ar₃₇ est présent, pourvu que lorsque Y est un atome d'azote et Z est un atome de carbone, Ar₃₆ est rien, sous réserve qu'un des R₅₁ à R₅₄ et des Ar₃₅ à Ar₃₇ est une liaison simple liée à un des lieurs L₃₁ à L₃₄ dans la formule D.

11. Dispositif électroluminescent organique selon la revendication 9, **caractérisé en ce que** le composé de formule D est choisi parmi les composés de formules D1 à D79 :

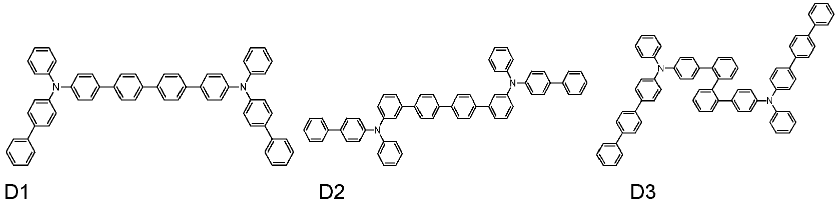

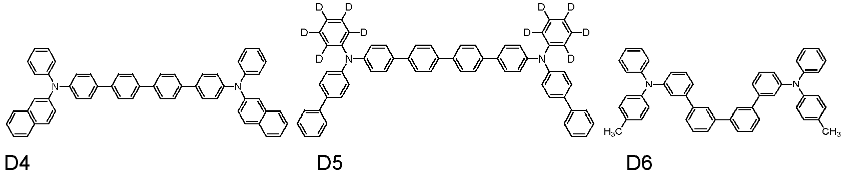

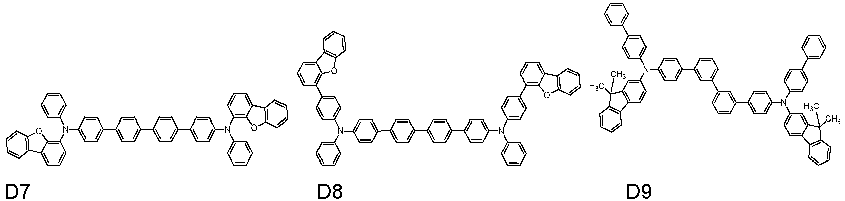

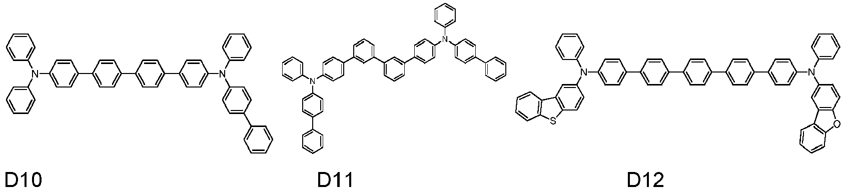

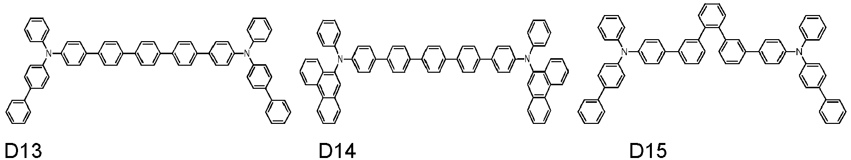

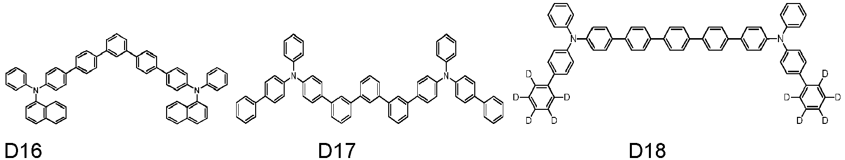

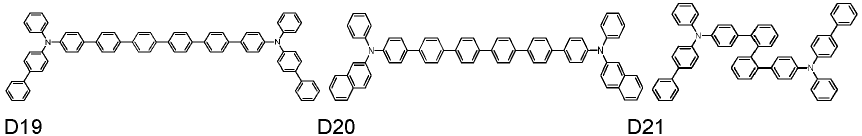

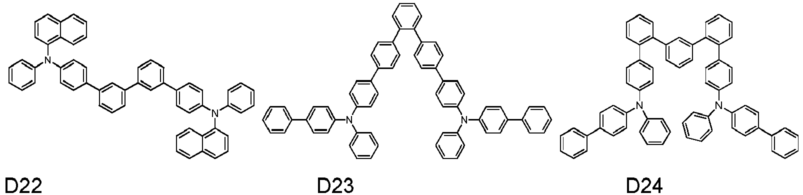

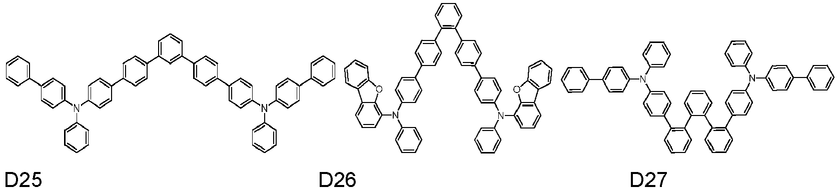

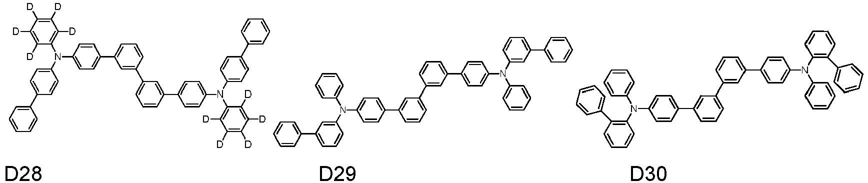

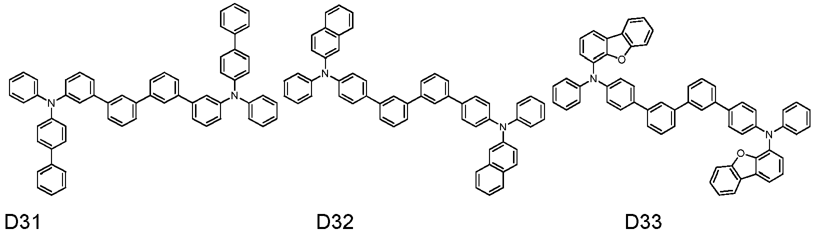

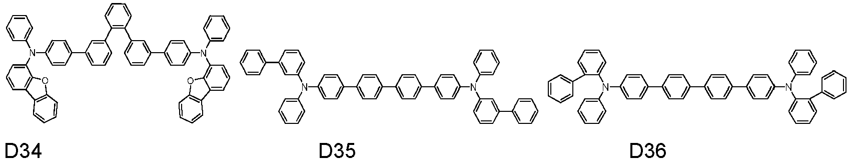

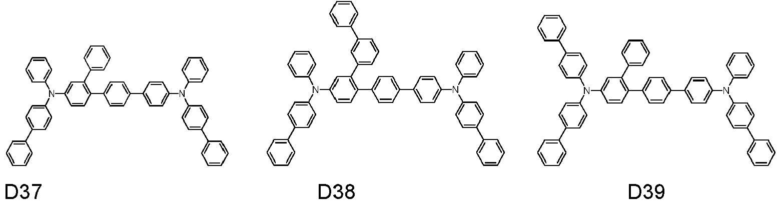

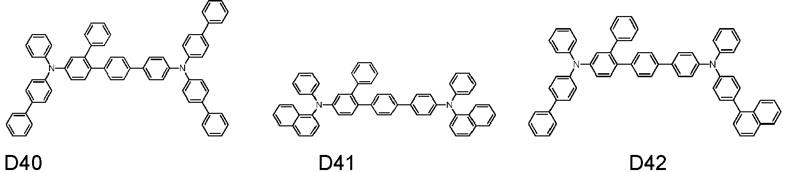

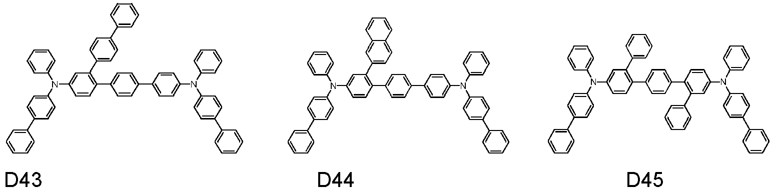

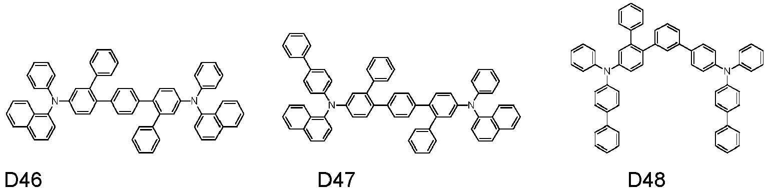

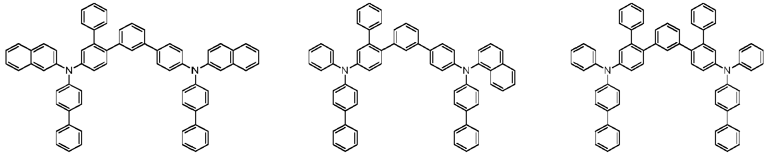

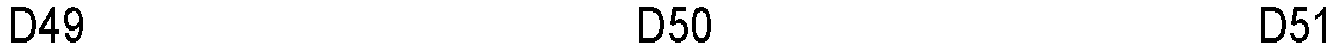

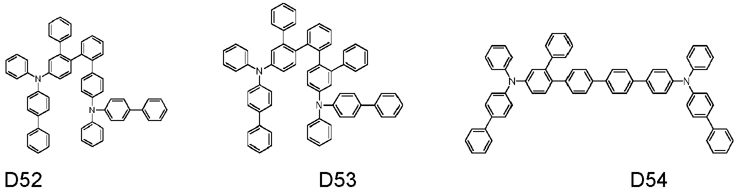

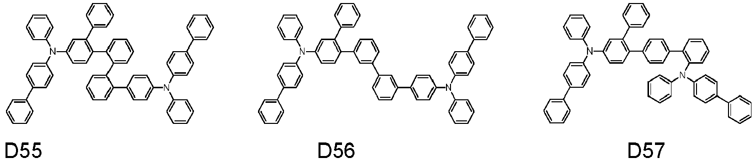

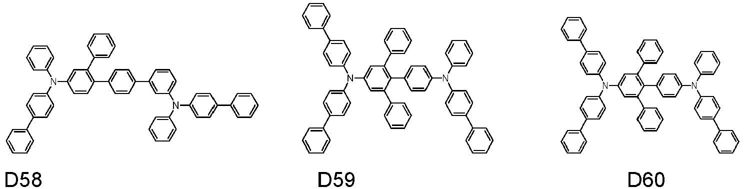

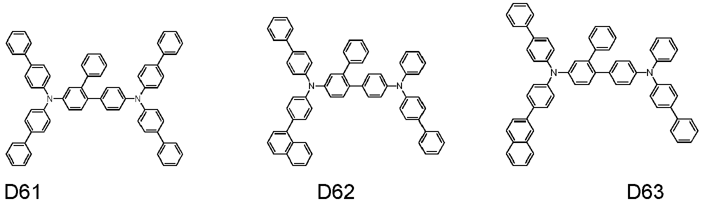

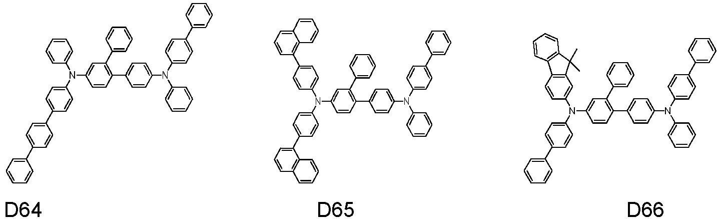

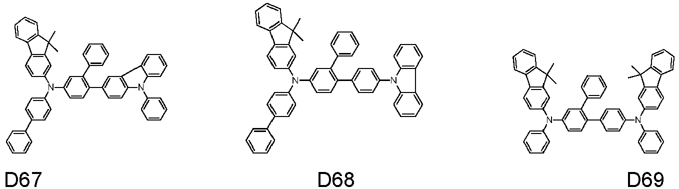

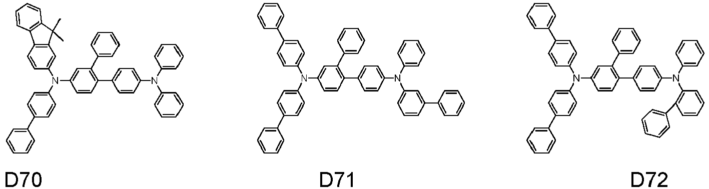

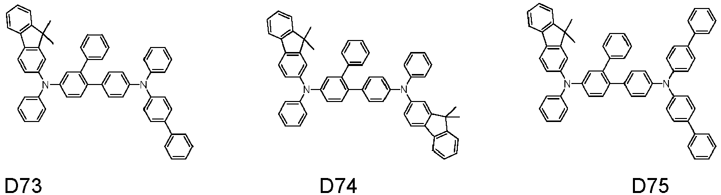

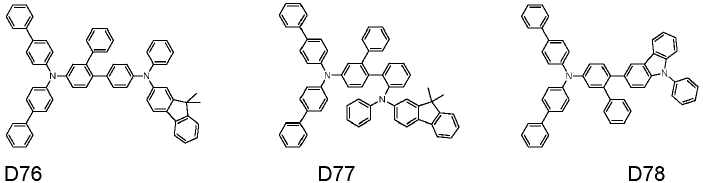

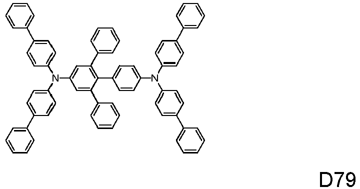

12. Dispositif électroluminescent organique selon la revendication 9, **caractérisé en ce que** le composé de formule D est choisi parmi les composés de formules D101 à D145 :

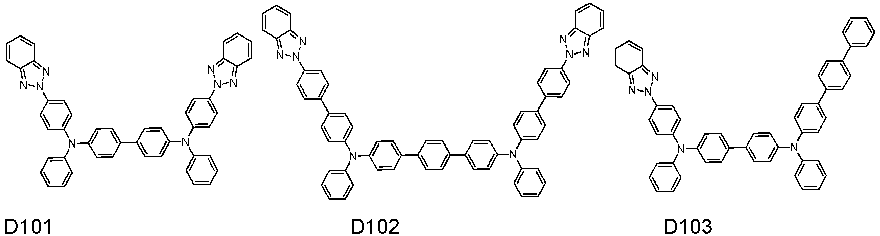

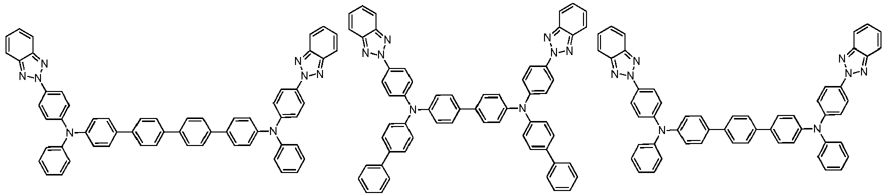

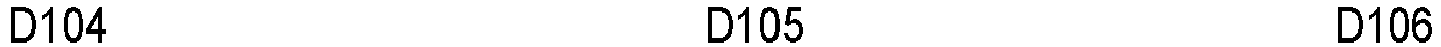

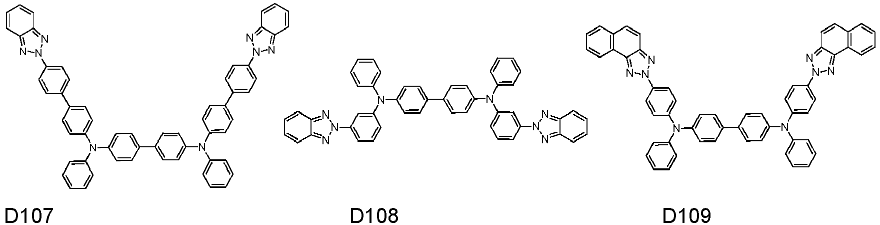

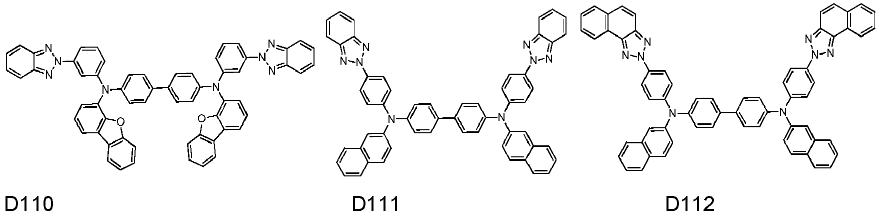

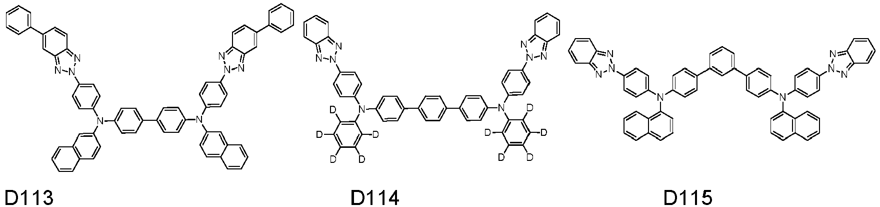

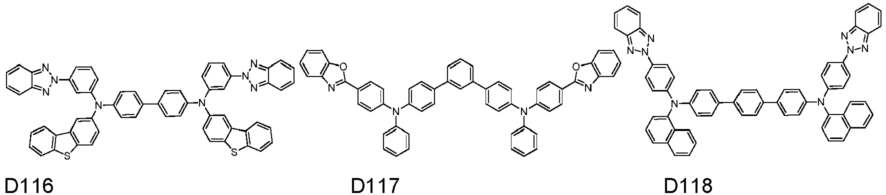

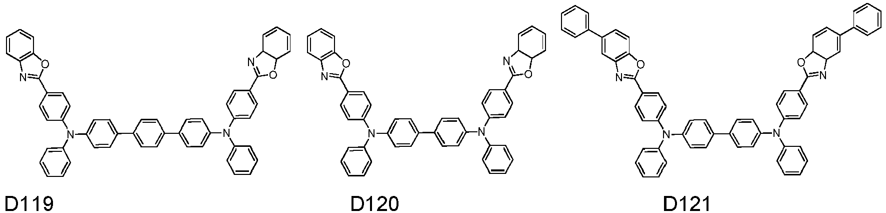

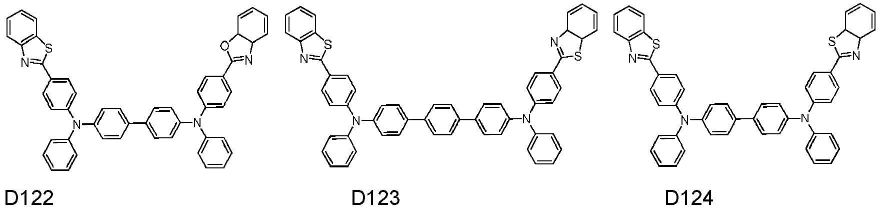

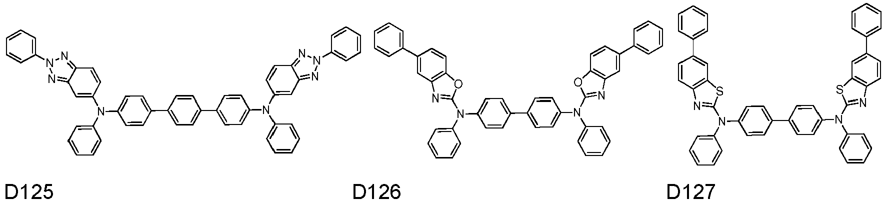

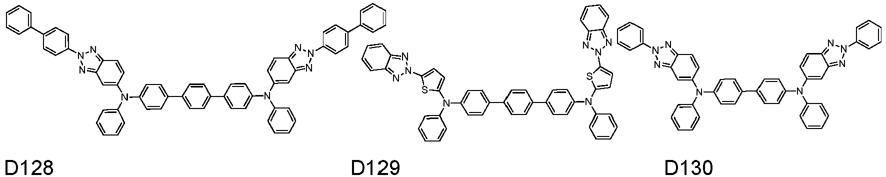

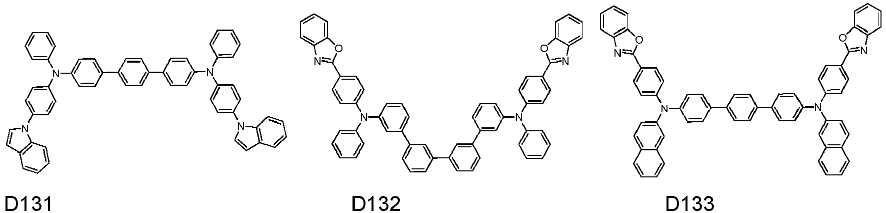

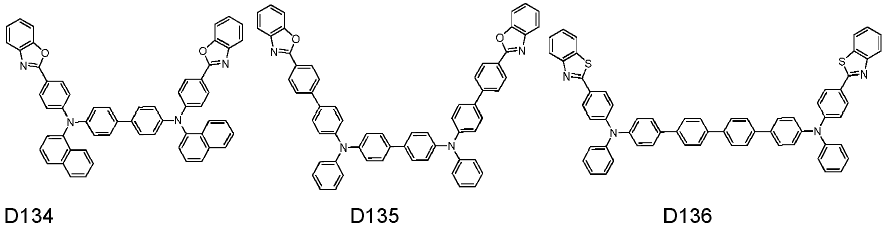

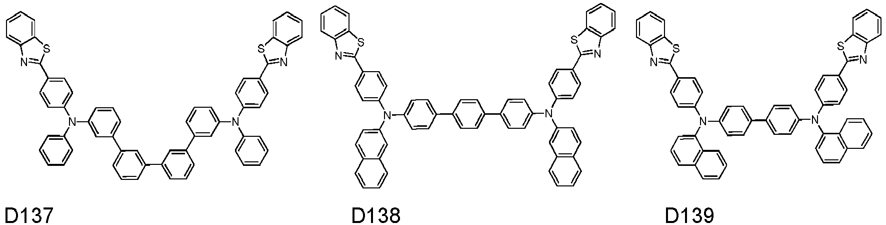

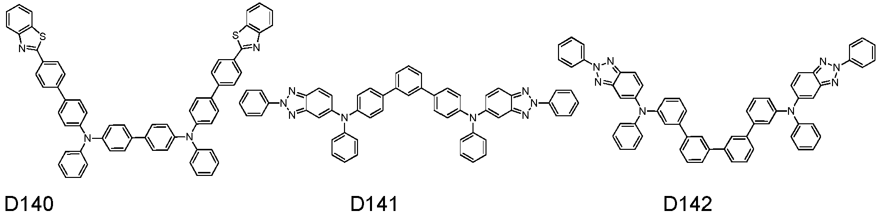

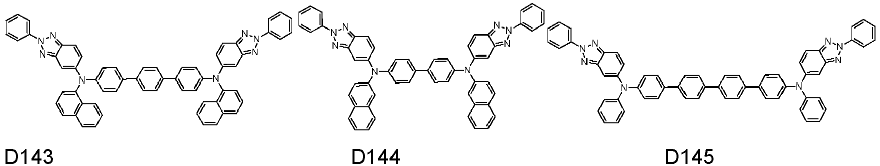

13. Dispositif électroluminescent organique selon l'une quelconque des revendications 4 à 12, **caractérisé en ce que** chacune de la couche de transport de trous et la couche de blocage d'électrons comprend un composé représenté par la formule F : 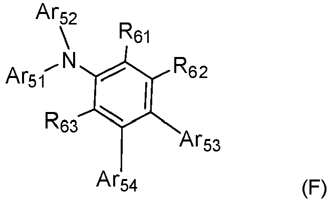 R₆₁ à R₆₃ étant identiques ou différents l'un de l'autre et étant choisis chacun indépendamment parmi hydrogène, deutérium, alkyle en C₁-C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₆-C₃₀ substitué ou non substitué, alkylamine en C₁-C₃₀ substituée ou non substituée, arylamine en C₆-C₃₀ substituée ou non substituée, alkylsilyle en C₁-C₃₀ substitué ou non substitué, arylsilyle en C₆-C₃₀ substitué ou non substitué, alkylgermanium en C₁-C₃₀ substitué ou non substitué, arylgermanium en C₁-C₃₀ substitué ou non substitué, cyano, nitro, et halogène, et Arsi à Ar₅₄ étant identiques ou différents l'un de l'autre et étant chacun indépendamment aryle en C₆-C₄₀ substitué ou non substitué ou hétéroaryle en C₂-C₃₀ substitué ou non substitué.

14. Dispositif électroluminescent organique selon la revendication 13, **caractérisé en ce que** le composé de formule F est choisi parmi les composés de formules F1 à F33 :

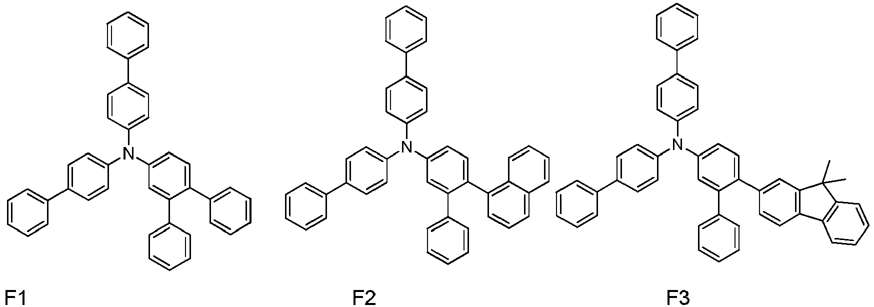

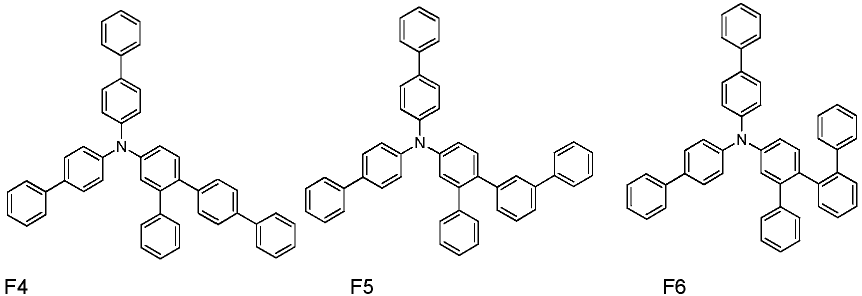

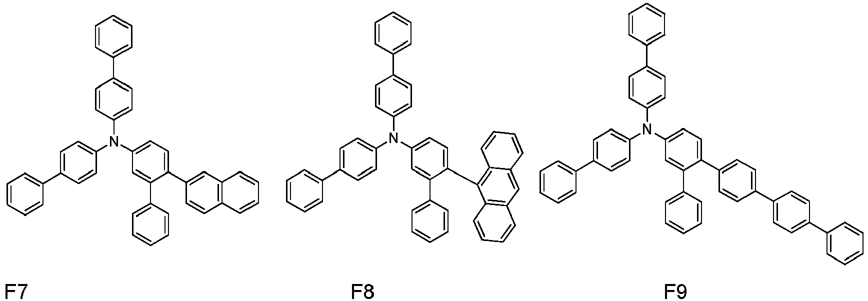

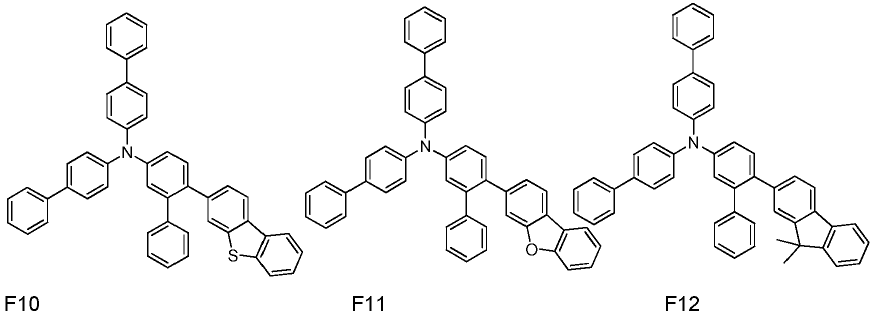

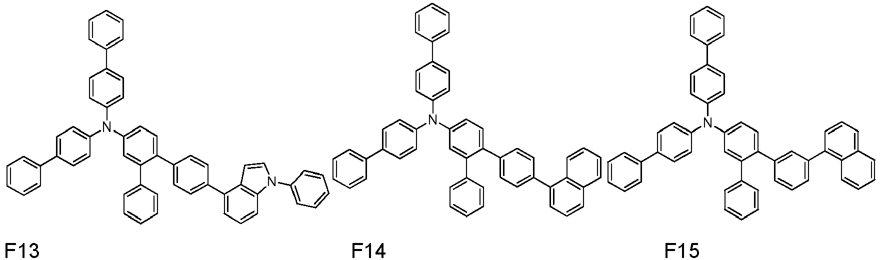

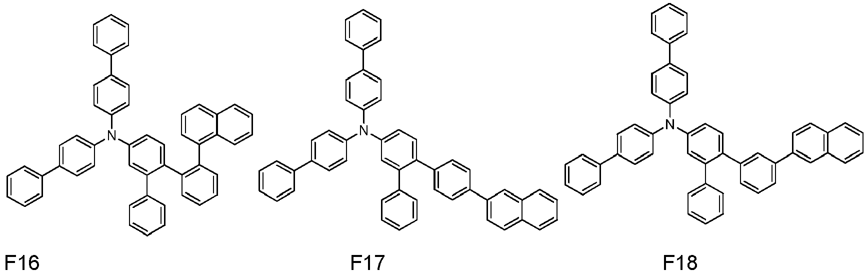

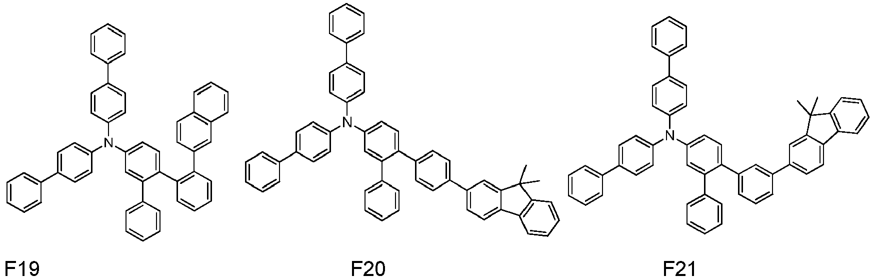

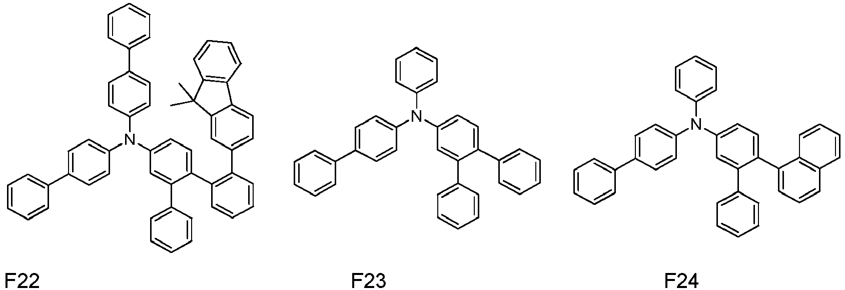

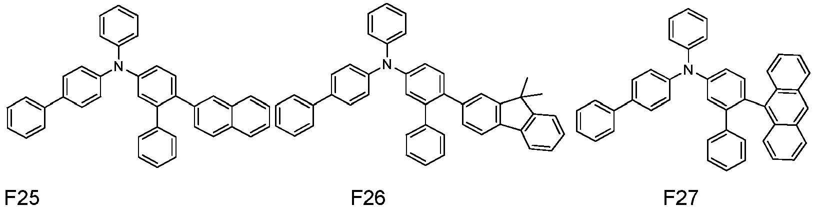

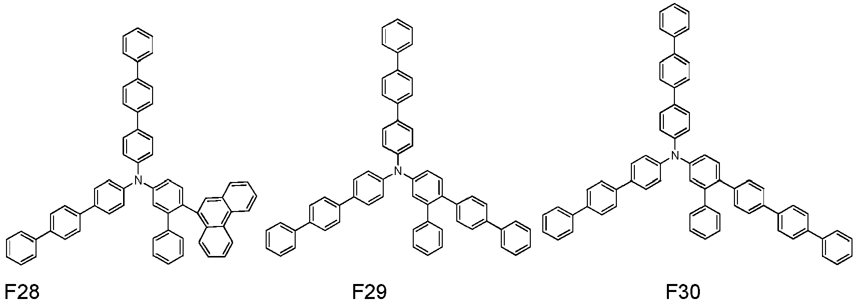

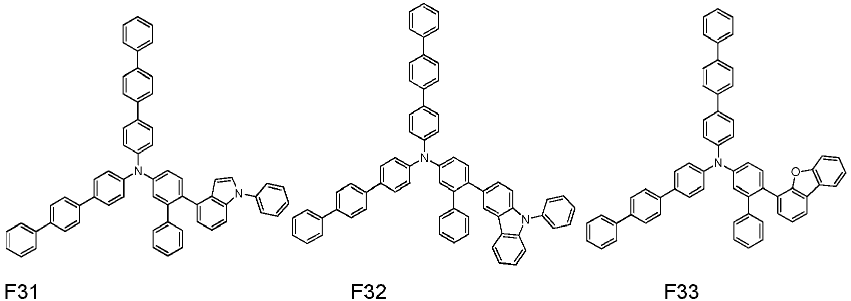

15. Dispositif électroluminescent organique selon l'une quelconque des revendications 4 à 14, **caractérisé en ce qu'**une ou plusieurs des couches sont formées par une méthode de dépôt ou de solution.

16. Dispositif électroluminescent organique selon l'une quelconque des revendications 3 à 15, dans lequel le dispositif électroluminescent organique est utilisé dans un système d'affichage ou d'éclairage choisi parmi des écrans plats, des écrans souples, des systèmes d'éclairage monochromatique plats, des systèmes d'éclairage blanc plats, des systèmes d'éclairage monochromatique souples, et des systèmes d'éclairage blanc souples.
